Europäisches Patentamt

European Patent Office

Office européen des brevets

(19)

(11) **EP 0 408 425 B1**

(12) **FASCICULE DE BREVET EUROPEEN**

(45) Date de publication et mention
de la délivrance du brevet:
**21.02.1996 Bulletin 1996/08**

(51) Int Cl.⁶: **G01R 31/28**

(21) Numéro de dépôt: **90401939.5**

(22) Date de dépôt: **04.07.1990**

(54) **Dispositif de test d'un réseau de composants notamment un circuit électronique**

Komponentennetzwerk-Testanordnung, insbesondere für eine elektronische Schaltung

Component net test appliance especially for an electronic circuit

(84) Etats contractants désignés:
**BE DE FR GB IT LU NL**

(30) Priorité: **13.07.1989 FR 8909523**
       **02.03.1990 FR 9002677**

(43) Date de publication de la demande:
**16.01.1991 Bulletin 1991/03**

(73) Titulaire: **DASSAULT ELECTRONIQUE**
**F-92214 Saint-Cloud (FR)**

(72) Inventeurs:
 • **Luciani, Pierre**
  **F-92380 Garges (FR)**
 • **Deves, Philippe**
  **F-78370 Plaisir (FR)**
 • **Taillibert, Patrick**
  **F-78160 Marly le Roi (FR)**

(74) Mandataire: **Plaçais, Jean-Yves**
**F-75009 Paris (FR)**

(56) Documents cités:
**EP-A- 0 231 948**

 • **PROCEEDINGS OF THE IEEE INTERNATIONAL CONFERENCE ON CIRCUITS AND COMPUTERS, ICCC'80, 1980, vol. 2, pages 924-927, N.B. Guy Rabbat (IEEE Catalog no. 80CH1511-5, Library of Congress Catalog Card no. 79-90696), IEEE, New York, US; C. TINAZTEPE et al.: "Use of nopal in generating programs for testing analog systems and circuit boards"**
 • **NACHRICHTENTECHNIK ELEKTRONIK, vol. 32, no. 11, 1982, pages 460-467, Ost-Berlin, DD; H. KRAMBEER et al.: "Fehlerlokalisierung in analogen Schaltungen auf der Grundlage von Knotenspannungsmessungen"**
 • **PROCEEDING OF THE MC INTERNATIONAL TEST CONFERENCE 1987, Washington, DC, 1-3 septembre 1987, pages 586-594, (IEEE Catalog no. 87CH2437-2), IEEE, New York, US; P. DEVES et al.: "Dedale: An expert system for troubleshooting analogue circuits"**

## Description

L'invention concerne le test d'un réseau de composants, notamment mais non exclusivement un circuit électronique.

Bien que l'invention trouve une application particulièrement avantageuse dans l'aide au diagnostic de l'origine d'une panne d'un circuit électronique, le terme "test" n'est pas ici associé limitativement à la notion de dépannage mais englobe notamment toute opération de contrôle sur un réseau dont le fonctionnement est supposé correct. En conséquence, le mot "test" s'applique à l'analyse de réseaux électroniques.

Diagnostiquer l'origine d'une panne, et donc localiser le ou les composants défectueux d'un circuit électronique présentant un fonctionnement incorrect, est une opération généralement difficile qui requiert habituellement un personnel qualifié.

Face à la diversité des circuits électroniques, dont il ne connaît pas toujours la finalité ni les fonctionnalités, le personnel chargé de la maintenance ne dispose souvent que des schémas électriques et parfois du manuel de maintenance, pour mener à bien sa tâche.

Ce personnel peut alors exécuter "à la main" des opérations de mesure et de calcul et gérer lui-même des hypothèses de bon ou de mauvais fonctionnement de certains composants aux fins d'établir un diagnostic. Cependant, toutes ces opérations sont généralement fastidieuses, délicates et nécessitent un temps conséquent avec un risque d'erreur qui peut s'avérer industriellement inacceptable.

Une alternative consiste à utiliser des logiciels du type de ceux existant dans les "systèmes experts". Cependant, une telle méthode sous-entend que la panne recherchée a été prévue ou déjà constatée et répertoriée au préalable, ce qui n'est pas forcément le cas de toutes les pannes. Par ailleurs, certains de ces logiciels nécessitent la description a priori du fonctionnement nominal correct du circuit, ce qui peut s'avérer contraignant dans certains cas. De plus, de tels logiciels ne sont pas toujours disponibles pour tous les types de circuits et leur implantation ainsi que leur utilisation sont généralement onéreuses.

D'une façon générale, quelle que soit la méthode utilisée, le personnel de maintenance est toujours confronté aux problèmes majeurs de l'interprétation, de l'analyse et de l'utilisation pertinente des mesures et observations qu'il peut effectuer.

On connaît des propositions qui procèdent par simulation du fonctionnement global du circuit à tester, à partir d'une description préalable complète de ce circuit: EP-A-0 231 948, Nachrichtentechnik Elektronik, vol. 32, N° 11, 1982,pp. 460, 465-467, et l'article de DEVES et al, "DEDALE: an expert system for troubleshooting analogue circuits", International Test Conference 1987, IEEE Catalog No 87CH2437-2, p. 586-594. De tels système ne répondent pas au problème posé qui consiste notamment à obtenir un appareil de test, à la fois simple à mettre en oeuvre, à un coût industriellement raisonnable, et assurant une aide efficace au personnel de maintenance dans sa tâche, afin de localiser aussi rapidement et sûrement que possible une panne présumée, même si l'on ne dispose pas en machine d'une description préalable complète du circuit à tester.

Le document Proceedings of the IEEE International Conference on Circuits and Computers, 1980, vol. 2, pp. 924-927 est du même genre. Il s'agit d'un générateur de programmes de test, qui utilise notamment des modèles de composants.

L'invention vient apporter une solution au problème posé.

Elle vise à proposer un dispositif automatisant les calculs et la gestion d'hypothèses afin d'aider le personnel de maintenance dans sa recherche de pannes.

Un but de l'invention est de proposer un dispositif dont l'utilisation ne requiert pas nécessairement la description totale du réseau à tester, ni la description du fonctionnement nominal de ce réseau.

Un autre but de l'invention est de proposer un dispositif dont l'utilisation ne nécessite aucune connaissance particulière des fonctionnalités du réseau à dépanner ou des symptômes de panne.

L'invention a encore pour but de permettre le diagnostic de défaillances analogiques d'un réseau de composants en fonctionnement statique ou dynamique.

Un autre but de l'invention est d'offrir une grande sûreté de diagnostic, sans nécessiter de procédures spécifiques prédéterminées de localisation de panne.

L'invention vise encore un dispositif utilisant dans une large mesure des éléments du commerce.

Le dispositif électronique d'analyse d'un réseau de composants comprend, de façon connue d'après le document IEEE International Conference on Circuits and Computers, 1980, vol. 2, pp. 924-927 :

- des moyens d'interface, comprenant des moyens pour identifier au moins un composant du réseau, une sonde pour capter une grandeur physique, relative à l'état de fonctionnement de ce composant, et des moyens coopérant avec la sonde pour délivrer des échantillons numériques de cette grandeur physique captée,

- une mémoire comprenant une zone formant mémoire de valeurs, propre à stocker les échantillons de grandeurs physiques captées, relatifs à différents composants du réseau, et une zone formant mémoire auxiliaire, propre à stocker une représentation du fonctionnement normal du réseau de composants à tester, sous forme de modèles fonctionnels, relatifs à au moins une espèce particulière de composants, et

- des moyens de traitement, reliés à cette mémoire et aux moyens d'interface, et aptes à effectuer un traitement comportant l'application desdits modèles fonctionnels aux échantillons de grandeurs physiques captées.

Il est caractérisé en ce que:

- les moyens d'interface comprennent des moyens pour définir des intervalles d'échantillonnage, dans un intervalle de temps choisi, et pour délivrer une série d'échantillons de ladite grandeur physique à l'intérieur de cet intervalle de temps choisi,

- la mémoire de valeurs est agencée pour stocker lesdites séries d'échantillons en tant que données de grandeurs physiques captées, en correspondance dudit intervalle de temps choisi, et en correspondance d'une spécification des noeuds et composants du réseau concernés,

- la mémoire auxiliaire comprend des expressions-composant portant sur des grandeurs physiques relatives à un composant, et des expressions-lois représentant des relations générales entre grandeurs physiques,

- les moyens de traitement comprennent:

    . des moyens aptes, en partant de données de grandeurs physiques captées, stockées dans la mémoire de valeurs en correspondance d'un intervalle de temps choisi,

        à calculer des estimations de grandeurs physiques relatives à un composant choisi parmi lesdits composants spécifiés du réseau concerné, en appliquant auxdites données une expression-composant stockée dans la mémoire auxiliaire, cette expression-composant correspondant audit composant choisi, et
        à stocker ces estimations de grandeurs physiques dans la mémoire de valeurs, de sorte que la mémoire de valeurs contient à la fois des données de grandeurs physiques captées et des grandeurs physiques estimées,

    . des moyens d'aide à la décision, propres à assister un utilisateur dans la sélection d'un composant d'un réseau et dans la capture de grandeurs physiques relatives à ce composant, en correspondance d'une spécification du réseau portant au moins sur ledit composant, ce qui permet de réduire le temps nécessaire à la localisation d'un composant défectueux dans ledit réseau concerné.

Ainsi, le dispositif peut opérer sans stockage préalable dans la mémoire auxiliaire d'informations relatives à la structure du réseau de composants.

Il est particulièrement avantageux qu'un tel dispositif d'analyse permette de tenir compte des précisions de capture des différentes grandeurs physiques au sein du réseau, ainsi que des incertitudes liées notamment aux caractéristiques fonctionnelles des composants.

Aussi, selon un mode de réalisation de l'invention, il est prévu que

- certains au moins des échantillons captés soient stockés en mémoire avec des fourchettes de précision,

- les modèles fonctionnels soient au moins en partie affectés de fourchettes d'incertitude,

- toute estimation soit stockée en mémoire avec sa fourchette d'incertitude estimée, résultant de certaines au moins desdites fourchettes d'incertitude et desdites fourchettes de précision,

- lorsque la mémoire contient, pour certains au moins des intervalles d'échantillonnage, une première et une deuxième fourchette d'origines différentes pour une même grandeur physique, établies à partir de la contribution d'un ensemble primaire de composants, ces deux fourchettes soient rapprochées pour en déduire une première information sur le fonctionnement des composants de cet ensemble primaire.

Comme détaillé plus loin, un principe de l'analyse selon l'invention repose sur le fait que, lorsque lesdites première et deuxième fourchettes sont disjointes sur au moins une fraction significative de l'intervalle de temps, cette première information est représentative d'un fonctionnement incorrect d'au moins un composant dudit ensemble primaire de composants ayant contribué à l'établissement de ces deux fourchettes.

Les deux fourchettes rapprochées peuvent être une fourchette de précision et une fourchette d'incertitude estimée, ou bien deux fourchettes d'incertitude estimées, ou bien une fourchette de précision et une fourchette de référence tirée d'un modèle de composant, ou bien encore une fourchette d'incertitude estimée et une fourchette de référence.

Un autre but de l'invention est de proposer un dispositif électronique d'analyse comportant des moyens de traitement aptes à proposer à l'utilisateur du dispositif une stratégie efficace de capture de grandeurs physiques et d'estimation d'autres grandeurs physiques pour aboutir, en un nombre minimum de captures, au diagnostic d'un ou de plusieurs composants défectueux.

Aussi, pour aboutir rapidement à la mise en évidence d'un composant défectueux, le dispositif comprend avantageusement un automate de décisions, relié à la structure du réseau, et comportant :

- un premier mécanisme portant sur la détermination du choix et de l'ordre des composants relativement auxquels seront capturées les différentes grandeurs physiques, et

- un deuxième mécanisme portant sur les estimations de grandeurs physiques.

Selon un autre mode de réalisation, dans lequel le réseau de composants est un circuit électronique, la sonde est propre à capter une différence de potentiel entre deux bornes choisies du circuit, les moyens d'identification identifiant au moins un composant branché entre lesdites bornes; la mémoire de valeurs est alors propre à stocker plusieurs différences de potentiel correspondant au même intervalle de temps, prises entre une première borne commune et différentes bornes voisines de celle-ci; le traitement comporte, pour chaque différence de potentiel, l'estimation d'une expression de courant tirée du modèle fonctionnel du composant concerné, sur ledit intervalle de temps; les moyens de traitement sont alors propres à tester, sur l'ensemble des expressions de courant, en chaque instant dudit intervalle de temps, une condition prenant en compte la nullité présumée du courant total en ladite première borne commune, ce test donnant une première indication sur le fonctionnement des composants branchés à ladite première borne commune.

D'autres avantages et caractéristiques de l'invention apparaîtront à l'examen de la description détaillée ci-après et des dessins annexés sur lesquels :

- la figure 1 est un synoptique schématique d'un dispositif selon l'invention;

- la figure 2 représente schématiquement un mode de réalisation particulier d'un dispositif selon l'invention;

- les figures 3 à 7 illustrent différents modèles fonctionnels,

- la figure 8 est un organigramme de fonctionnement schématique d'un dispositif selon l'invention,

- la figure 9 est un organigramme de fonctionnement schématique d'une partie de l'organigramme de la figure 8,

- la figure 10 illustre plus en détail l'organigramme de la figure 8,

- les figures 11 à 13 illustrent plus en détail des parties de l'organigramme de la figure 10,

- la figure 14 illustre un exemple d'un circuit électronique à tester,

- les figures 15 à 17 illustrent un organigramme de fonctionnement du dispositif dans le cas particulier du circuit de la figure 14,

- la figure 18 est un organigramme général de fonctionnement d'un autre mode de réalisation du dispositif selon l'invention,

- la figure 19 est une partie plus détaillée de l'organigramme de la figure 18,

- la figure 20 illustre un exemple d'un circuit électronique à dépanner selon l'organigramme de la figure 18,

- la figure 21 est une courbe relative à l'activation du circuit de la figure 20,

- les figures 22 à 25 illustrent des modèles fonctionnels de composants du circuit de la figure 20,

- les figures 26A à 26E illustrent une utilisation du dispositif dans le cas particulier du circuit de la figure 20, et

- les figures 27 à 43 représentent des courbes relatives au test du circuit de la figure 20.

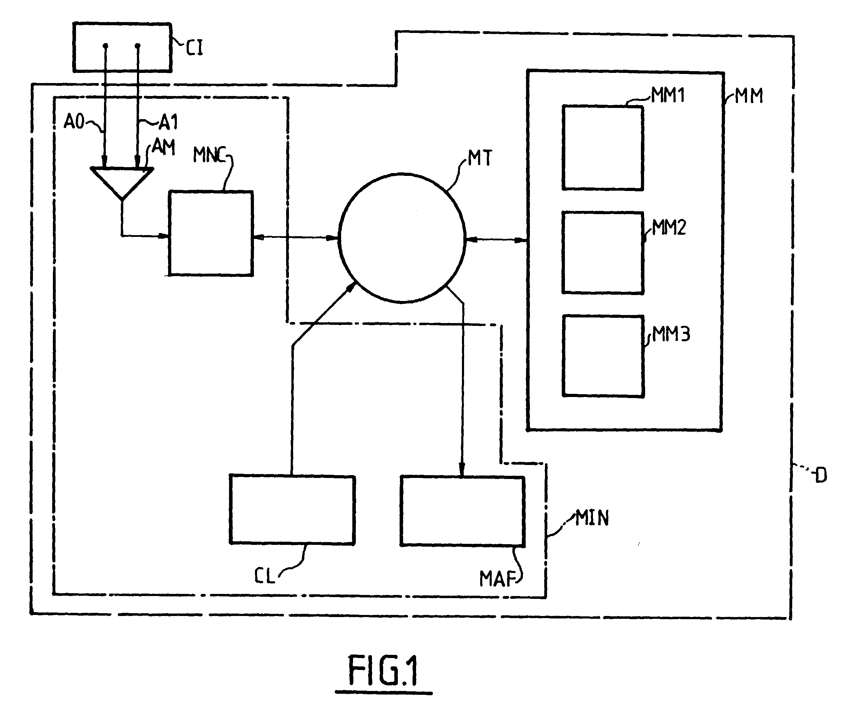

Tel qu'illustré sur la figure 1, le dispositif comprend des moyens de traitement MT reliés à une mémoire MM ainsi qu'à des moyens d'interface MIN avec le réseau à dépanner CI d'une part, et avec l'utilisateur d'autre part.

L'interface avec l'utilisateur est réalisée au moyen d'un clavier CL et de moyens d'affichage tels qu'un écran MAF. Le clavier permet notamment, si la structure du réseau n'est pas déjà mémorisée, d'identifier au moins un composant du réseau et de définir également des instants d'échantillonnage dans un intervalle temporel choisi.

Quant à l'écran, il permet notamment l'affichage du ou des composants défectueux révélés par le dispositif lors du test.

Pour assurer l'interface avec le réseau de composants, il est prévu des moyens de sonde (plus simplement sonde) aptes à capter une grandeur physique d'un type choisi relative à l'état de fonctionnement d'un composant ainsi que des moyens AM, MNC coopérant avec cette sonde pour délivrer une série d'échantillons de cette grandeur physique à l'intérieur de l'intervalle temporel choisi. Lorsque la grandeur physique captée est une différence de potentiel, cette sonde comporte généralement des sondes distinctes A0 et A1 reliées par l'intermédiaire de l'amplificateur analogique AM aux moyens de numérisation commandables des mesures effectuées MNC.

La mémoire du dispositif peut être découpée fonctionnellement en :

- une mémoire de modèles fonctionnels MM2, comprenant des expressions-composant portant sur des grandeurs physiques relatives à au moins une espèce particulière de composant, ainsi que des expressions-lois représentant des relations générales entre grandeurs physiques,

- une mémoire de valeurs MM1, propre à stocker plusieurs séries d'échantillons de grandeurs physiques, correspondant au même intervalle de temps mais relatives à différents composants du réseau,

- éventuellement, une mémoire propre à stocker la configuration du réseau de composants, et

- une mémoire MM3 logeant notamment l'algorithme de fonctionnement du dispositif ainsi que diverses autres données ou instructions relatives à son utilisation.

Matériellement, il peut être prévu une seule mémoire regroupant l'ensemble de ces mémoires fonctionnelles, ou bien des mémoires séparées affectées à certaines au moins de celles-ci.

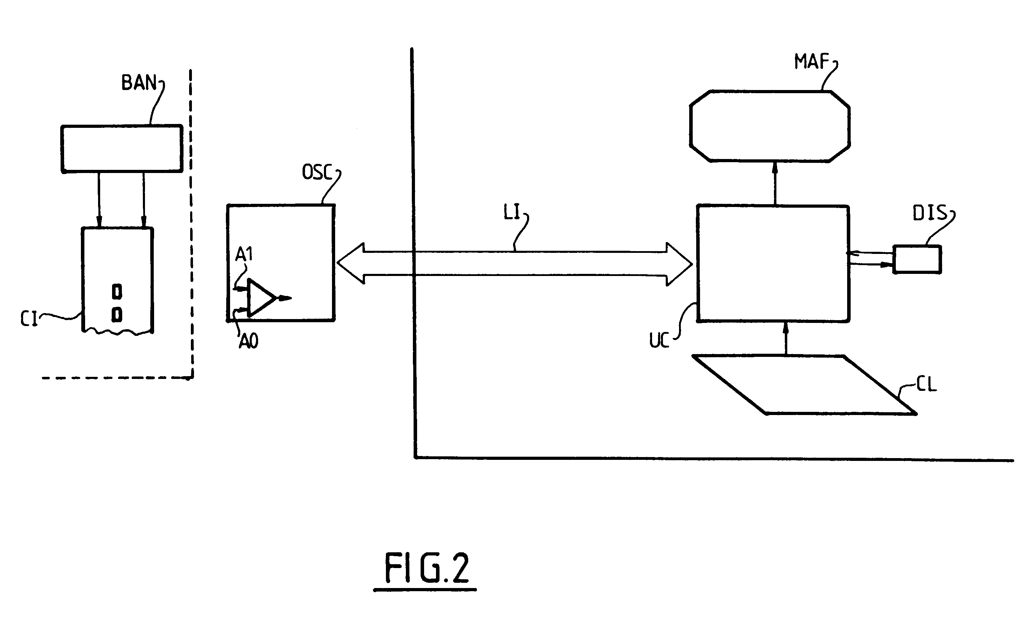

Pratiquement, comme illustré sur la figure 2, dans le cas d'une application électronique prévue pour environ cent composants électroniques, les moyens de traitement du dispositif peuvent être logés au sein d'un micro-ordinateur classique UC associé à un clavier et à un écran alphanumérique. Il est alors avantageux que ce micro-ordinateur dispose d'une mémoire de masse, telle qu'une disquette DIS, d'une capacité de 1,44 megaoctets, contenant notamment l'algorithme de fonctionnement du dispositif ainsi que les différents modèles, ainsi que d'une mémoire centrale de travail d'environ 4 megaoctets.

Un oscilloscope numérique OSC, séparé, peut incorporer la sonde utilisée dans ce cas pour capter une différence de potentiel entre deux bornes du réseau, et peut être utilisé pour définir l'intervalle temporel choisi, les instants d'échantillonnage, et délivrer la série d'échantillons de la grandeur physique captée à l'unité centrale du dispositif par l'intermédiaire par exemple d'un bus numérique LI.

Dans cette configuration, le circuit CI à dépanner est relié à un banc de test BAN apte à activer ses entrées primaires de façon à le faire fonctionner dans une situation particulière dans laquelle la panne se manifeste. Cependant, il peut être envisagé que l'activation de ce circuit soit fournie directement par le dispositif selon l'invention.

D'une façon générale, les moyens de traitement, reliés à ces mémoires et aux moyens d'interface, sont aptes à effectuer un traitement comportant :

- l'estimation, en partant de données de grandeurs physiques captées et stockées dans la mémoire de valeurs en correspondance de l'intervalle de temps choisi, d'autres grandeurs physiques relatives à un composant choisi parmi des composants du réseau analysé, en appliquant auxdites données un modèle fonctionnel (expression-composant et/ou expression-loi), stocké(es) dans la mémoire auxiliaire, et

- le stockage de ces grandeurs physiques estimées dans la mémoire de valeurs, en correspondance de l'intervalle de temps choisi, de sorte que la mémoire de valeurs contienne à la fois des données de grandeurs physiques captées et des données de grandeurs physiques estimées,

ainsi que des tests sur des valeurs contenues dans cette mémoire de valeurs.

Dans l'exemple pratique évoqué, la mémoire centrale de travail incorpore cette mémoire de valeurs.

Selon un mode de réalisation de l'invention, le dispositif permet de prendre en compte la précision de la sonde ainsi que les incertitudes sur les caractéristiques des divers composants.

Aussi, certains au moins des échantillons captés, en pratique tous, sont stockés en mémoire avec des fourchettes de précision. Cette précision peut être indiquée au dispositif par l'utilisateur ou bien être directement incorporée de façon automatique compte tenu des caractéristiques de la sonde. Concrètement, si l'intervalle temporel choisi s'étend entre 0 et 40 microsecondes, en étant échantillonné en 400 instants d'échantillonnage espacés de 0,1 microseconde, et si de l'instant 0 à l'instant 0,2 microseconde, la sonde capte une différence de potentiel V de 4 volts, les deux premiers échantillons captés relatifs à cette différence de potentiel seront affectés de la fourchette de précision (Vm; VM) = (3,99; 4,01).

De la même façon, les modèles fonctionnels sont, au moins en partie, affectés de fourchettes d'incertitude.

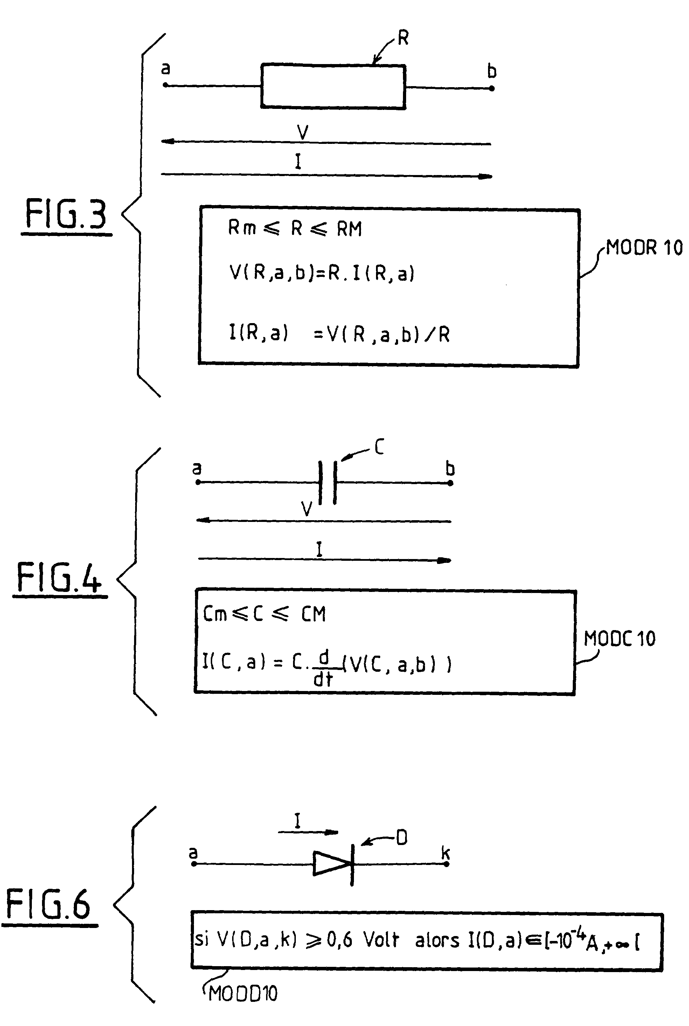

Les figures 3 à 6 illustrent ainsi des modèles relatifs à quatre espèces particulières de composants. Ces modèles comprennent des expressions-composant portant sur des grandeurs physiques relatives à l'espèce particulière correspondante de composant et relatives, de préférence, à un fonctionnement correct de ces composants.

Ainsi, pour une résistance (figure 3), le modèle MODR10 prend en compte une fourchette d'incertitude (Rm; RM) relative à la valeur R de cette résistance. Ce modèle définit également la relation existant entre la différence de potentiel V(R,a,b) prise entre les bornes a et b de cette résistance et le courant I(R,a) rentrant dans la borne a de cette résistance (loi d'ohm). Le modèle fonctionnel définit également la relation inverse permettant d'obtenir le courant à la borne a à partir de la différence de potentiel prise entre les bornes a et b.

Dans la mesure où la différence de potentiel est une grandeur physique captée, la mesure du courant I apparaît ici comme une grandeur physique estimée à partir du modèle de cette résistance. Bien entendu, on aurait pu supposer effectuer une capture directe du courant I en la borne a, ce qui aurait conduit à une différence de potentiel V estimée.

Etant donné que la différence de potentiel V est stockée en mémoire avec une fourchette de précision et que la valeur de la résistance R est affectée d'une fourchette d'incertitude (Rm; RM), il en résulte une fourchette d'incertitude estimée (Im; IM) pour le courant I.

D'une façon générale, pour toute grandeur estimée, la fourchette d'incertitude estimée correspondante est déterminée dans le cas le plus défavorable. En d'autres termes, on cherchera à obtenir la plus grande fourchette d'incertitude estimée à partir des fourchettes associées aux grandeurs physiques utilisées dans la formulation permettant de déterminer la grandeur estimée.

Concrètement, dans le cas présent, la valeur Im est obtenue par le rapport Vm/RM et la valeur IM est obtenue par le rapport VM/Rm.

Cependant, d'une façon générale, afin d'éviter un élargissement excessif des fourchettes d'incertitude estimées, pour une grandeur physique estimée obtenue à partir d'une formulation faisant intervenir une pluralité de grandeurs physiques différentes, ladite formulation est agencée pour ne mentionner qu'une seule fois chaque grandeur physique différente.

En ce qui concerne le modèle MODC10 d'un condensateur C (figure 4), la valeur de celui-ci est affectée d'une fourchette d'incertitude (Cm; CM) et le courant I en sa borne a est estimé à partir de la valeur C et de la dérivée temporelle de la différence de potentiel captée entre les bornes a et b.

Certains modèles de composants peuvent comporter des fourchettes de référence portant sur des grandeurs physiques particulières relatives à ces composants. C'est le cas par exemple des diodes et des transistors.

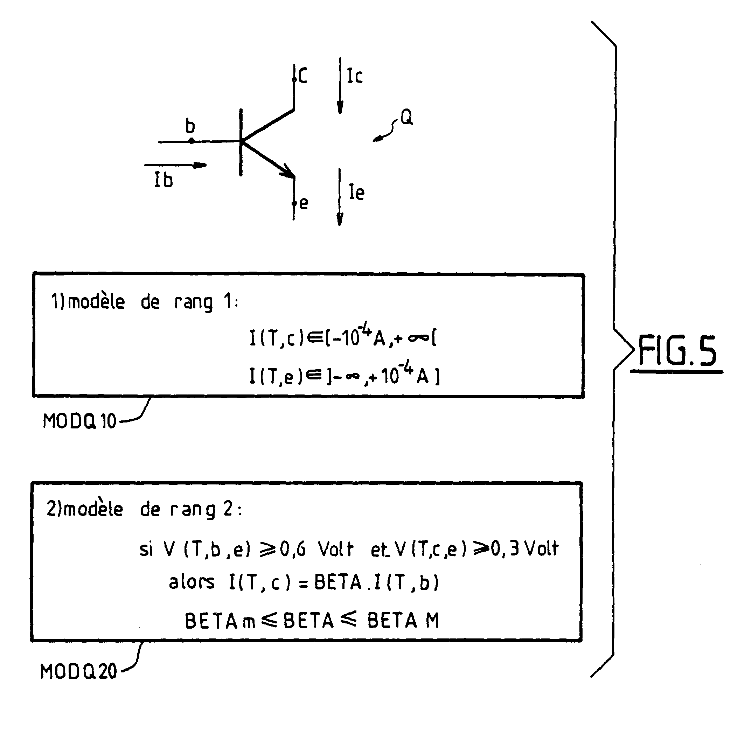

En ce qui concerne un transistor Q (figure 5), il est possible de prévoir des modèles de fonctionnement de complexités différentes. Ainsi, un premier modèle simple MODQ10, dit de rang 1, prévoit que le courant collecteur doit être positif tandis que le courant émetteur doit être négatif, avec les conventions des signes de cette figure, remarque étant faite qu'il s'agit ici d'un transistor NPN. La condition de positivité de ces courants se traduit par leurs appartenances respectives à des fourchettes de référence définies par l'intervalle $[-10^{-4}A, +\infty[$ où le symbole $+\infty$ désigne $+$ l'infini, tandis que la fourchette de référence relative à la négativité du courant est $]-\infty, +10^{-4}A]$

Les sous-intervalles $[-10^{-4}A, 0]$ et $[0, 10^{-4}A]$ des intervalles respectifs $[-10^{-4}A, +\infty[$ et $]-\infty, +10^{-4}A]$ ont pour rôle de tenir compte des capacités parasites du transistor sans nécessiter de modèles fonctionnels plus complexes.

Un autre modèle simple peut prévoir que la tension base-émetteur V(T,b,e) du transistor doit être inférieure à une limite choisie, par exemple 3 Volts. Un tel modèle est particulièrement avantageux car il permettra éventuellement, comme expliqué plus en détail ci-après, de rapprocher cette fourchette d'incertitude avec la fourchette de précision de la différence de potentiel captée V(T,b,e) pour en déduire directement une information relative au transistor.

Il est également possible de prévoir un modèle MODQ20 de complexité supérieure, dit de rang 2. Un tel modèle pourra par exemple traduire qu'un transistor "n'est un amplificateur de courant avec un gain beta connu que s'il est passant". Ceci se traduit alors par les conditions mathématiques définies sur la figure 5 avec une fourchette d'incertitude (BETAm, BETAM) sur la valeur BETA du gain en courant.

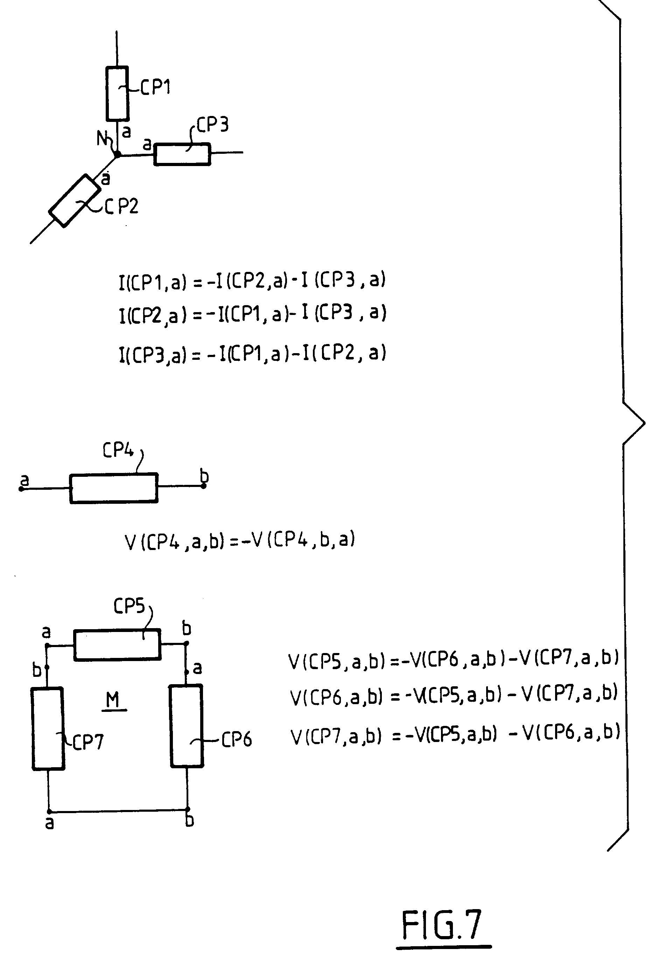

En ce qui concerne une diode D (figure 6), un modèle simple de fonctionnement MODD10 montre encore que, lorsque la différence de potentiel entre l'anode a et la cathode k de la diode est supérieure ou égale à 0,6 volt, alors le courant I en l'anode doit être compris à l'intérieur de la fourchette de référence $[-10^{-4}A; +\infty[$, traduisant encore que ce courant doit être positif.

Outre les expressions-composants, la mémoire de modèles comprend également des expressions-lois représentant des relations générales entre grandeurs physiques.

Ainsi, comme illustré sur la figure 7, dans le cas d'une application électronique, ces expressions permettent de déterminer, en utilisant une règle prenant en compte la nullité du courant total en un noeud N d'un circuit électronique, d'estimer la valeur I(CP1,a) du courant en la borne a d'un composant CP1 reliée à ce noeud, à partir des valeurs connues I(CP2,a) et I(CP3,a) des courants en d'autres bornes a d'autres composants CP2 et CP3, reliées à ce noeud.

De même, une autre expression-loi utilise une règle traduisant le fait que la différence de potentiel V(CP4,a,b) prise entre les bornes a et b d'un composant CP4 est égale à l'opposé V(CP4,b,a) de la différence de potentiel prise entre les bornes b et a de ce même composant.

Enfin, la règle édictant que la somme des différences de potentiels le long d'une maille M est nulle permet d'estimer la différence de potentiel V(CP5,a,b) aux bornes d'un composant CP5 de cette maille en connaissant les autres différences de potentiel V(CP6,a,b) et V(CP7,a,b) aux bornes des autres composants CP6 et CP7 de cette même maille.

A ce stade de la description, il convient de détailler une notion importante d'un invention qui consiste en la définition de l'intervalle temporel IT choisi pour la capture des différentes grandeurs physiques, ici des différences de potentiel.

Il est nécessaire que les captures des différentes grandeurs physiques soient effectuées pendant un même intervalle de temps à l'intérieur duquel la défaillance du circuit se manifeste.

La définition de cet intervalle temporel IT implique notamment la définition d'une date de début de capture ainsi que celle de la durée de cette capture.

Pour les circuits ayant un fonctionnement statique, les différences de potentiel, par exemple, sont stables dans le temps. Par conséquent, les différentes captures peuvent être effectuées à tout instant et la notion de durée de capture est prépondérante devant celle de la date de début de capture.

Il en est de même pour les circuits ayant un fonctionnement dynamique et examinés dans le domaine fréquentiel. En effet, les amplitudes et phases des différents signaux sont alors stables dans le temps pour une fréquence donnée. Les différentes captures de différences de potentiel peuvent donc être également faites à tout instant.

Par contre, en ce qui concerne les circuits ayant un fonctionnement dynamique et examinés dans le domaine temporel, il est nécessaire que les formes d'ondes des différences de potentiel aux bornes des composants soient reproductibles dans le temps. Ainsi, par exemple, si l'un des composants présente une période transitoire (en particulier lors d'une mise sous tension), il est nécessaire que les captures des différentes différences de potentiel des autres composants soient effectuées alors que ce composant présente sa période transitoire. Ainsi, dans ce cas particulier, le circuit à dépanner sera mis hors fonctionnement entre chaque capture. La date de début de l'intervalle temporel sera alors la date de la mise sous tension. L'homme de l'art remarque donc que, dans ce cas, la notion de date de début est prépondérante au même titre que la notion de durée.

Il convient de remarquer également que la capture sur un intervalle temporel choisi, et non uniquement en un instant précis, permet de détecter des défaillances analogiques de circuits électroniques aussi bien en fonctionnement statique qu'en fonctionnement dynamique, ce que ne pourrait pas réaliser "à la main" un utilisateur en raison du nombre d'opérations et de la diversité de la forme des signaux sur tout l'intervalle temporel choisi.

Il convient de définir également, particulièrement dans le cas d'un circuit électronique, la notion de borne observable. Une telle borne est presentée comme étant celle dont tous les composants qui y sont branchés sont accessibles à la capture des grandeurs physiques, par exemple des différences de potentiel. Dans le cas d'un circuit imprimé monocouche par exemple, toutes les bornes du circuit sont observables. Par contre, dans le cas de circuits multicouches, on conçoit aisément que des liaisons intercouches ne puissent pas être physiquement accessibles aux sondes. De telles bornes ne sont alors pas observables. Cette considération conduit alors à la remarque suivante. Au sens de la présente description, la notion de composant n'est pas limitée à celle habituellement attribuée à une résistance ou à un transistor par exemple mais peut désigner également un noeud ou une liaison du circuit inaccessible aux sondes.

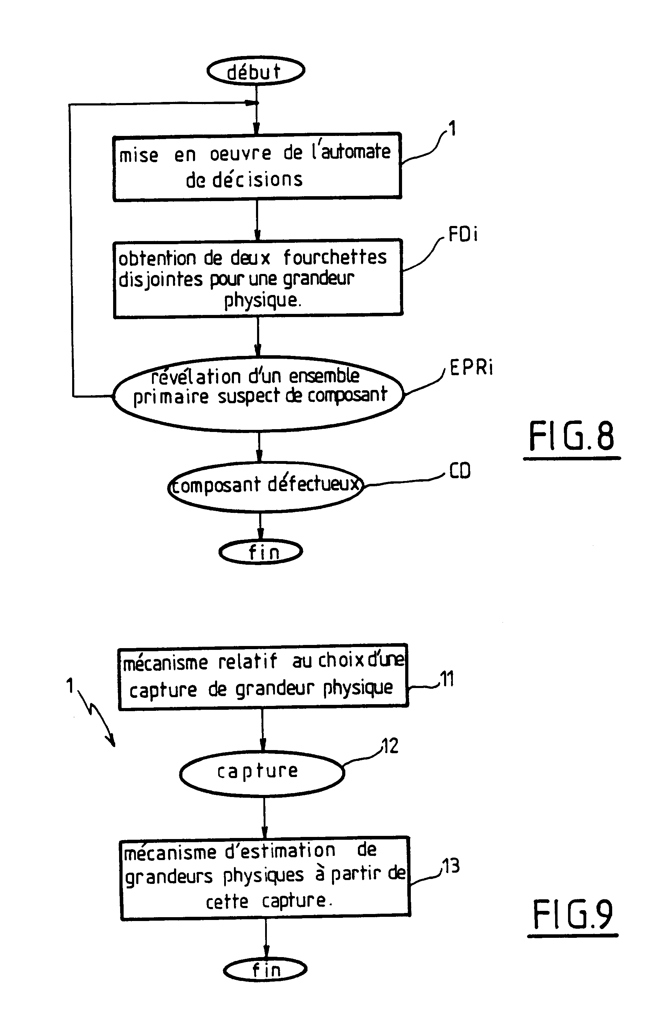

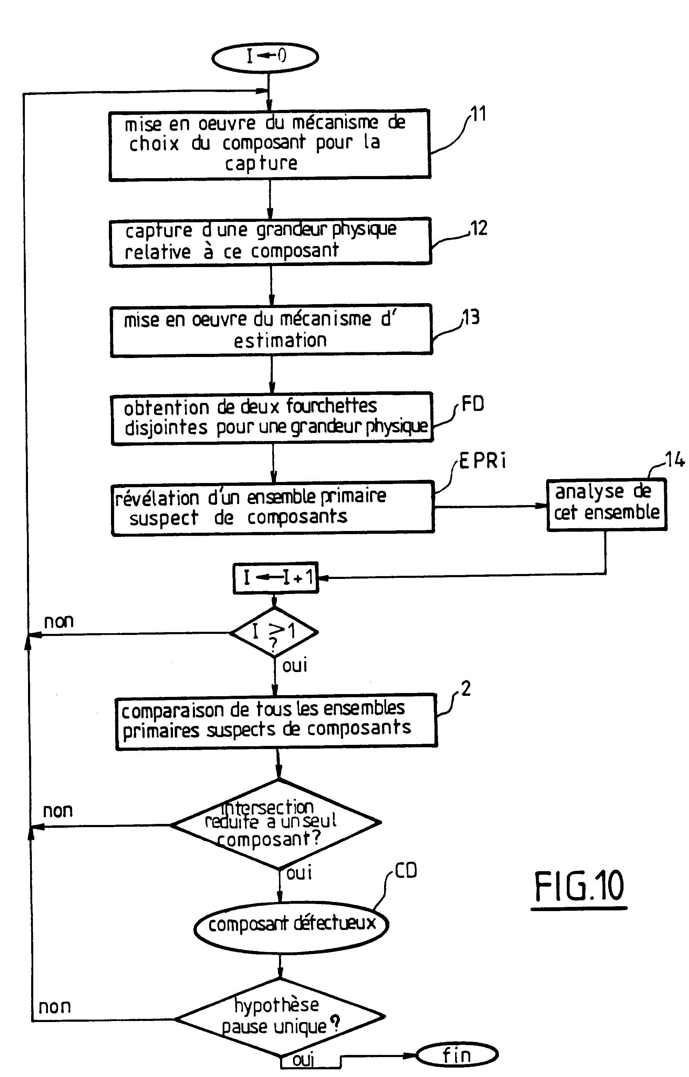

Bien que, comme on le verra ci-après, l'utilisateur puisse utiliser manuellement le dispositif selon l'invention, c'est-à dire décider lui-même au niveau de quel composant capturer les grandeurs physiques, l'invention prévoit une assistance de l'utilisateur quant à la stratégie de capture des différentes grandeurs physiques dans le but d'arriver le plus rapidement possible à la localisation du composant défectueux. Cette assistance se traduit par la mise en oeuvre d'un automate de décisions 1 comportant un premier mécanisme 11 portant sur la détermination du choix et de l'ordre des composants relativement auxquels seront effectuées les captures des différentes grandeurs physiques, ainsi qu'un deuxième mécanisme 12 portant sur les estimations de grandeurs physiques (figures 8 et 9). La mise en oeuvre de cet automate de décisions, relié à la structure du réseau, nécessite la connaissance de la configuration de ce dernier disponible dans la mémoire de configuration.

D'une façon générale, après la capture 12 d'une grandeur physique relativement à un composant indiqué, par exemple à l'écran, par le premier mécanisme de l'automate, le mécanisme d'estimation 13 permet d'estimer une grandeur physique qui peut être :

- soit une grandeur physique d'un type différent de celle déjà captée pour le composant correspondant,

- soit la grandeur physique déjà captée pour ce composant, par exemple à partir d'autres grandeurs physiques captées pour d'autres composants et/ou d'autres grandeurs physiques estimées.

Pour effectuer cette estimation, les moyens de traitement utilisent les données contenues dans la mémoire de valeurs. Ainsi, une grandeur estimée, d'un type différent de celui d'une grandeur captée, peut être déterminée à partir de l'échantillon capté et d'un modèle fonctionnel, ou bien à l'aide de fourchettes d'incertitude estimées déjà présentes dans la mémoire de valeurs et relatives à d'autres grandeurs estimées. L'estimation d'une grandeur physique, qui a par ailleurs déjà été captée, peut également résulter de la combinaison d'autres grandeurs physiques estimées, elles-mêmes résultant à l'origine d'une autre grandeur physique captée.

Plus particulièrement, lorsque le réseau de composants comrend une pluralité de mailles, comme ce peut être le cas par exemple pour un circuit électronique, le mécanisme d'estimation comporte :

* pour un composant d'une maille ayant donné lieu à une capture de grandeur physique d'un type choisi, par exemple une différence de potentiel, une estimation d'au moins une grandeur physique d'un type différent dudit type choisi, par exemple une valeur de courant, tirée d'un modèle fonctionnel dudit composant et des échantillons de ladite grandeur physique captée, et,

* pour un composant n'ayant pas donné lieu à une grandeur physique captée d'un type choisi, et appartenant à ladite maille ou directement connectée à un composant de ladite maille, une estimation d'au moins une grandeur physique, de même type que le type choisi, par exemple une différence de potentiel, ou d'un type différent, par exemple une valeur de courant, obtenue à partir de valeurs déjà stockées dans la mémoire de valeurs et associées à au moins un composant de ladite maille.

Concrètement, toujours dans le cas d'un circuit électronique, le traitement d'estimation comporte :

* pour certains au moins des composants du circuit, à partir de la capture d'une différence de potentiel entre une première et une deuxième borne de l'un de ces composants, les estimations des courants à chacune des deux bornes et, éventuellement en outre, l'estimation de la différence de potentiel entre les deuxième et première bornes de ce composant,

* pour un composant appartenant à une maille dont les différences de potentiel aux bornes des autres composants de cette maille sont connues, et n'ayant pas donné lieu à une capture de différence de potentiel à ses bornes, l'estimation de cette différence de potentiel à partir des autres différences de potentiels relatives aux autres composants,

* pour un composant dont une borne est connectée à un noeud du circuit auquel sont également connectées les bornes respectives d'autres composants pour lesquels les courants respectifs en ces bornes sont connus, l'estimation du courant en la borne dudit composant.

L'homme du métier remarque donc que, après mise en oeuvre de cet automate de décisions 1, les grandeurs physiques ayant fait l'objet d'une capture et/ou d'une estimation sont affectées de fourchettes de précision et/ou d'incertitudes estimées. Un principe général du dispositif selon l'invention consiste alors, lorsque la mémoire de valeurs contient, sur certains au moins des instants d'échantillonnage, une première et une deuxième fourchette d'origines différentes pour une même grandeur physique, en le rapprochement de ces deux fourchettes pour en déduire une première information sur le fonctionnement de l'ensemble des composants ayant contribué à l'établissement de ces deux fourchettes. L'ensemble de ces composants sera dans la suite désigné sous la dénomination "ensemble primaire" EPRi.

La première fourchette peut être par exemple une fourchette d'incertitude estimée obtenue par exemple :

- à partir d'une fourchette de précision relative à une grandeur physique captée associée à un premier composant,

- d'un modèle fonctionnel de ce premier composant, et

- d'une fourchette d'incertitude estimée associée à une grandeur physique estimée relative à un deuxième composant.

Ces premier et deuxième composants forment alors un premier groupe ayant contribué à l'établissement de cette première fourchette.

La deuxième fourchette peut être également une fourchette d'incertitude estimée, pour la même grandeur physique que celle relative à la première fourchette, mais obtenue de façon différente à partir d'un deuxième groupe de composants.

L'ensemble primaire de composants ayant contribué à l'établissement de ces deux fourchettes est alors la réunion des premier et deuxième groupes de composants.

D'autres cas peuvent se produire.

Ainsi, les deux fourchettes d'origines différentes peuvent être une fourchette de précision et une fourchette d'incertitude estimée, ou bien une fourchette d'incertitude estimée et une fourchette de référence contenue dans un modèle fonctionnel de composant, ou encore une fourchette de précision et une fourchette de référence.

Lorsque ces première et deuxième fourchettes sont disjointes sur au moins une fraction significative de l'intervalle temporel, alors, cet ensemble primaire de composants EPRi est suspect en ce sens qu'il contient au moins un composant ayant un fonctionnement incorrect. On peut parler alors de "conflit".

L'obtention immédiate d'un ensemble primaire suspect de composants réduit à un seul composant, donc au composant défectueux CD, est très improbable. Aussi, est-il nécessaire de réitérer le traitement de façon à obtenir au moins un autre ensemble primaire suspect différent ayant conduit à l'obtention de deux fourchettes disjointes, remarque étant faite que ces deux autres fourchettes disjointes peuvent être ou ne pas être relatives à la même grandeur physique que les deux fourchettes disjointes précédentes. Alors, le ou les composants suspectés d'un fonctionnement incorrect appartiennent à l'intersection de deux ensembles primaires.

Le traitement est en conséquence effectué au moins jusqu'à l'obtention de deux ensembles primaires dont l'intersection comporte un seul composant et sera arrêté à ce stade dans l'hypothèse d'une panne unique.

Cet algorithme de fonctionnement est résumé plus en détail sur la figure 10 et fait apparaître une étape supplémentaire 14 d'analyse de l'ensemble primaire suspect de composant, comportant, lorsque cet ensemble primaire de composants satisfait une condition prédéterminée, une capture sélective de grandeurs physiques relatives à certains composants de cet ensemble primaire. On reviendra plus en détail sur cette analyse ultérieurement.

Comme évoqué ci-avant, l'information déduite du rapprochement des deux fourchettes est représentative d'un fonctionnement incorrect d'au moins un composant de l'ensemble primaire lorsque ces deux fourchettes sont disjointes sur une fraction significative de l'intervalle temporel. Une fraction est significative lorsqu'elle comporte un nombre prédéterminé d'instants d'échantillonnages successifs, par exemple supérieur ou égal à deux. Une telle précaution vise à éviter le diagnostic de conflits illicites, notamment lorsque les fourchettes d'incertitude estimées résultent de calculs de dérivées temporelles. En effet, il importe de remarquer que les fonctions à dériver n'étant pas connues a priori - et cela d'autant moins que le réseau de composants considéré est en panne - la valeur de la dérivée risque d'être mal estimée et par conséquent d'engendrer un conflit illicite. Par contre, un véritable conflit n'apparaîtra en général que pendant plusieurs instants d'échantillonnages successifs. Bien entendu, si par exemple, lors d'un premier découpage de l'intervalle temporel, la fraction significative est réduite à un seul instant d'échantillonnage, l'utilisateur a toujours la possibilité, puisque les moyens de définition de l'intervalle temporel sont commandables, de modifier le découpage temporel de l'intervalle en des instants d'échantillonnage plus rapprochés de façon à mettre en évidence éventuellement le conflit sur plusieurs instants d'échantillonnages successifs révélant alors une véritable fraction significative.

Lorsque les première et deuxième fourchettes d'origines différentes pour une même grandeur physique présentent une fourchette d'intersection non vide, cette fourchette d'intersection est affectée en priorité à ladite grandeur physique. En d'autres termes, l'obtention de ces deux fourchettes non disjointes ne révèle pas un ensemble primaire suspect de composants et permet tout au plus d'affirmer que les hypothèses ayant conduit à l'établissement de ces deux fourchettes sont consistantes. Les moyens de traitement, en affectant en priorité la fourchette d'intersection à la grandeur physique, pourront éventuellement comparer **ultérieurement** cette fourchette d'intersection à une autre fourchette d'origine différente obtenue pour cette grandeur physique à partir d'un autre groupe de composants pour déceler éventuellement un autre conflit. Par ailleurs, le mécanisme d'estimation se poursuit, éventuellement, à partir de cette fourchette d'intersection.

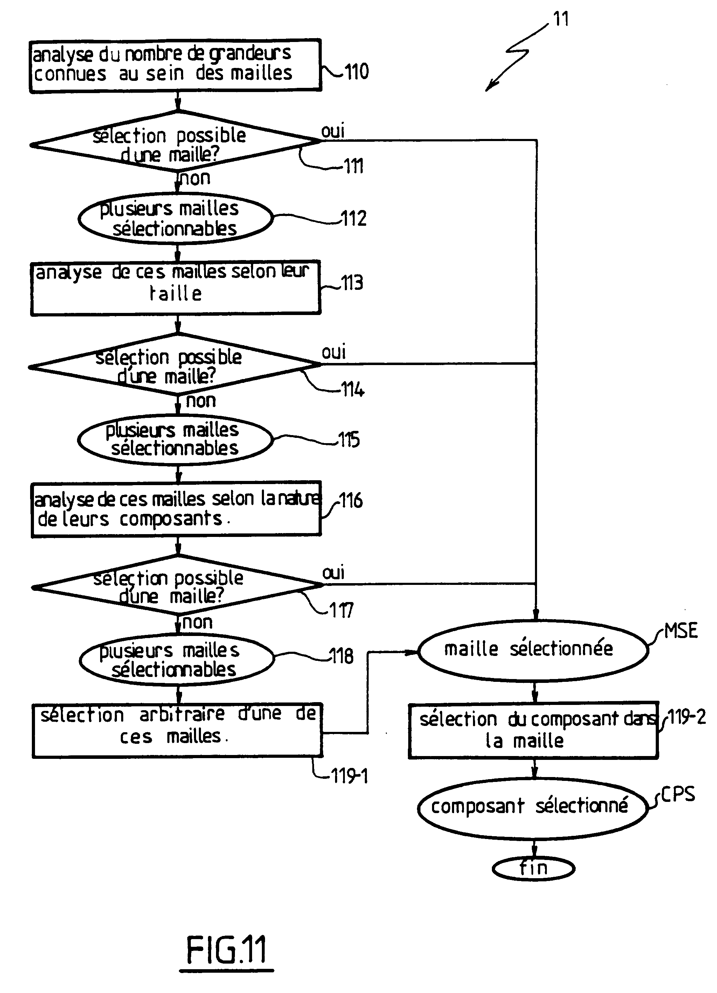

La figure 11 illustre plus en détail le mécanisme du choix et de l'ordre des composants relativement auxquels seront effectuées les captures de grandeurs physiques. On suppose ici que le réseau de composants comporte une pluralité de mailles.

Ce premier mécanisme comporte tout d'abord un premier critère de décision portant sur la sélection d'une maille au sein de laquelle sera effectuée au moins une capture de grandeur physique d'un type choisi. Ce premier critère inclut un premier sous-critère 110 portant sur l'analyse du nombre de grandeurs physiques, par exemple des différences de potentiels, déjà connues (c'est à dire captées ou estimées) au sein de chaque maille.

En cas de sélection possible 111 d'au moins deux mailles selon le premier sous-critère, il est prévu un deuxième sous-critère 113 portant sur le nombre des composants de chaque maille sélectionnable 112. Selon ce deuxième sous-critère, les moyens de traitement sélectionneront préférentiellement une maille en fonction de son nombre de composants pris dans l'ordre 3, 4, 2.

En cas de sélection possible d'au moins deux mailles selon le deuxième sous-critère (étape 114), il est prévu un troisième sous-critère 116 portant sur la nature des composants de ces mailles sélectionnables 115.

Ainsi, lorsqu'il s'agit d'un circuit électronique, la maille sélectionnée selon le troisième sous-critère est celle présentant le plus grand nombre de composants passifs (résistance, condensateur, inductance et autres multipôles passifs).

Si plusieurs mailles sont encore sélectionnables par le troisième sous-critère (117, 118), il est procédé à une sélection arbitraire d'une de ces mailles (étape 119-1), de façon à obtenir la maille sélection MSE.

Une fois cette maille sélectionnée MSE obtenue, le premier mécanisme comporte un deuxième critère de décision 119-2 portant sur la nature du composant de cette maille. Ainsi, dans le cas d'un circuit électronique, la capture d'une différence de potentiel sera préférentiellement effectuée aux bornes d'un composant passif et préférentiellement encore aux bornes d'un dipôle.

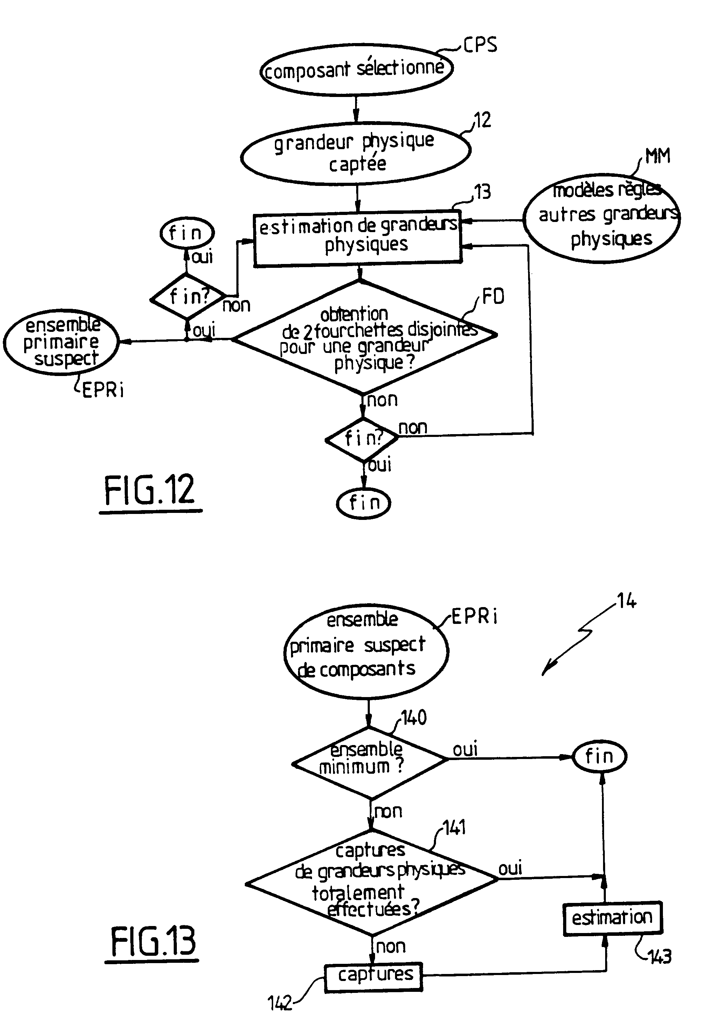

Ce premier mécanisme de décision permet alors l'affichage sur l'écran d'un composant sélectionné CPS relativement auquel l'utilisateur devra effectuer la capture 12 de la grandeur physique (figure 12).

A partir de là, les moyens de traitement procèdent, comme illustré sur la figure 12, à l'estimation 13 des diverses grandeurs physiques évoquées ci-avant, à partir des modèles, des règles et autres grandeurs physiques stockées dans la mémoire MM du dispositif, plus particulièrement dans la mémoire de valeurs et dans la mémoire de modèles.

Ce deuxième mécanisme d'estimation estime toutes les grandeurs physiques possibles à partir de la structure du réseau et des données contenues dans la mémoire de valeurs et les moyens de traitement peuvent en déduire, au cours de cette estimation, un ensemble primaire suspect EPRi par l'obtention de deux fourchettes disjointes FD. Il convient de remarquer que l'obtention d'un ensemble primaire suspect n'interrompt pas forcément le traitement d'estimation si d'autres grandeurs physiques peuvent être encore estimées.

Ainsi, de même qu'il était possible de procéder à de nouvelles estimations à partir d'une fourchette d'intersection de deux fourchettes non disjointes, il est possible de poursuivre le traitement d'estimation à partir de l'une au moins de deux fourchettes disjointes aux fins de l'obtention éventuelle d'un autre conflit.

En présence d'un tel ensemble primaire suspect, il est procédé, comme évoqué ci-avant, à une analyse de ce dernier (figure 13). Les moyens de traitement déterminent tout d'abord si cet ensemble primaire de composants satisfait à la condition prédéterminée d'un ensemble dit "minimum" (étape 140). Concrètement, dans le cas d'un circuit électronique par exemple, un ensemble minimum de composants se caractérise par des composants tous connectés à une même borne commune. Si cette condition est satisfaite, il n'est procédé à aucun traitement supplémentaire sur cet ensemble.

Dans le cas contraire, il est procédé à une capture d'une différence de potentiel aux bornes des composants de l'ensemble primaire suspect EPRi pour lesquels cette capture n'a pas déjà été effectuée (étapes 141-142). A partir de ces captures éventuelles, il est procédé à de nouvelles estimations (étape 143) pour aboutir éventuellement à un autre ensemble primaire suspect de composants.

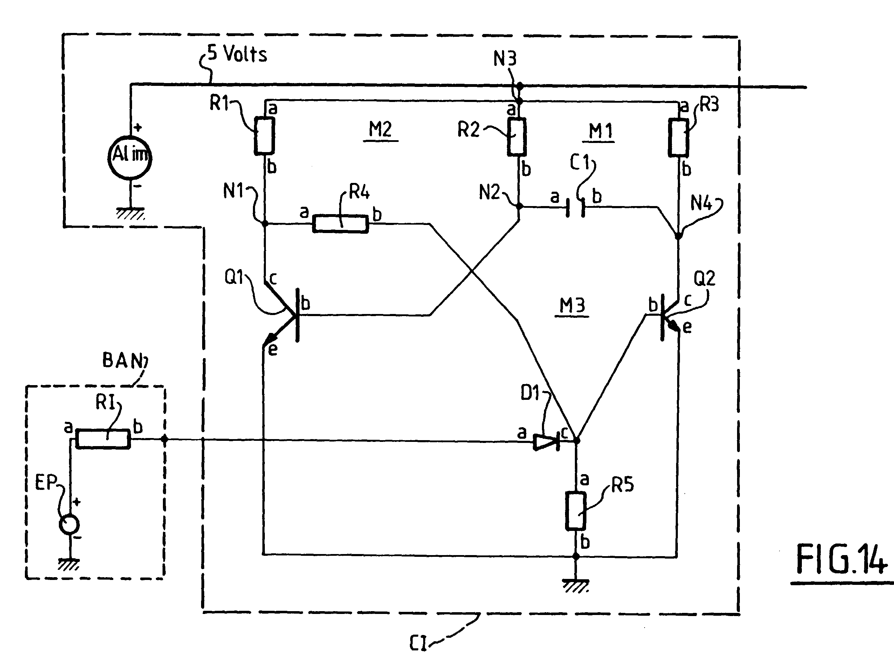

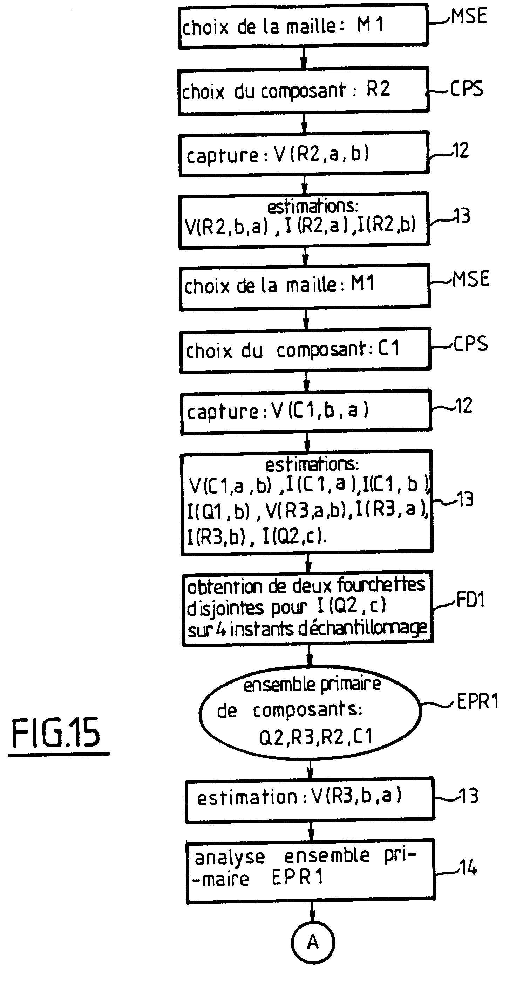

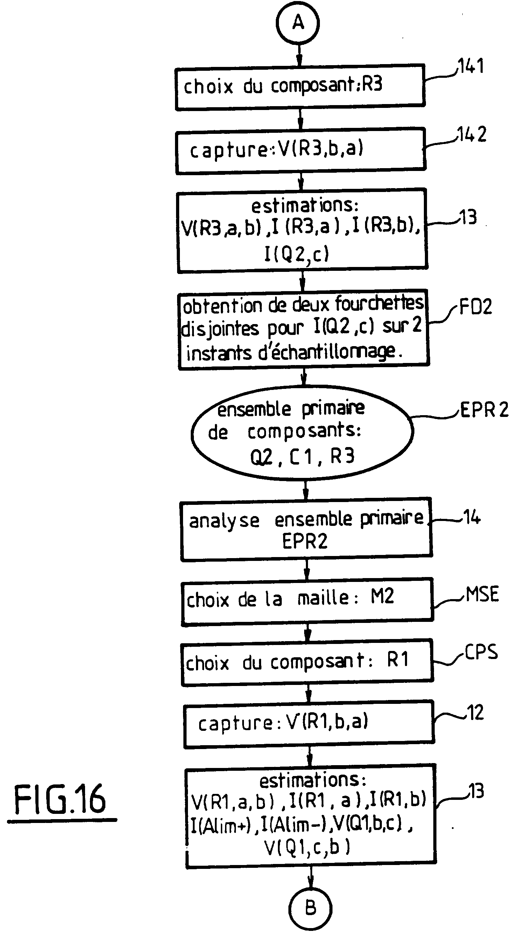

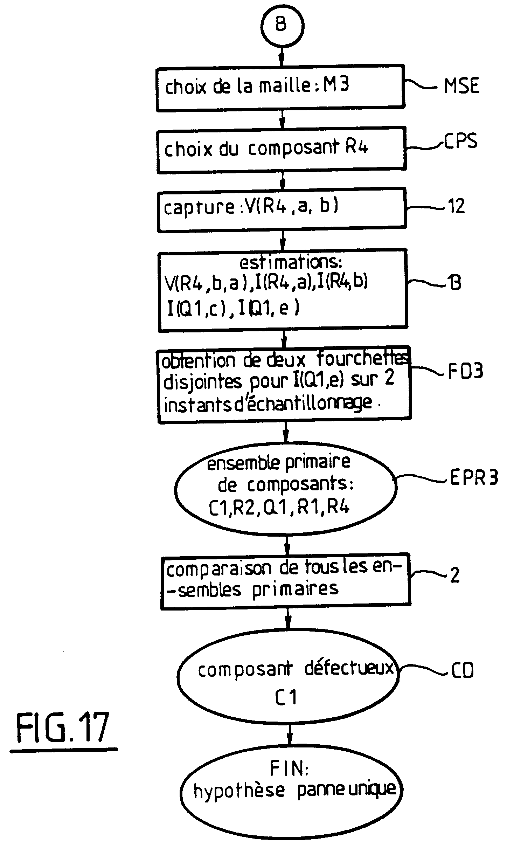

Un exemple précis d'utilisation du dispositif selon l'invention va maintenant être illustré sur le cas particulier d'un circuit électronique, en se référant plus particulièrement aux figures 14 à 17.

Le circuit électronique à dépanner CI, illustré sur la figure 14, comprend une pluralité de composants dont les caractéristiques sont définies dans l'annexe 1. En ce qui concerne les résistances et le condensateur, les valeurs numériques de ces composants sont fournies. En ce qui concerne les diodes et les transistors, sont fournis un nom de société ainsi qu'une référence sous laquelle le composant est commercialisé par ladite société.

L'intervalle temporel choisi pour les différences de potentiel captées dans le circuit CI est compris entre 0 et 40 microsecondes, échantillonné toutes les 0,1 microseconde. Le composant défectueux est le condensateur C1.

Le banc de test BAN permettant d'activer ce circuit comprend un générateur d'impulsions EP associé à une résistance RI de 50 ohms et délivre, sur l'intervalle temporel, une forme d'onde en forme de créneau.

A des fins de simplification, on décrira ici principalement le déroulement de l'algorithme de fonctionnement en ne citant que quelques valeurs numériques pour les diverses fourchettes de précision, d'incertitude et d'incertitude estimée.

Les grandeurs physiques captées seront ici des différences de potentiels, remarque étant faite qu'il aurait été bien sûr possible de prévoir des sondes propres à capter des courants. Les grandeurs estimées seront donc des courants, mais également des différences de potentiel.

Au début du test, aucune différence de potentiel n'est connue puisqu'aucune différence de potentiel n'a été captée. En conséquence, le choix de la maille sélectionnée MSE s'effectue en fonction des deuxième et troisième sous-critères pour aboutir à la sélection de la maille M1 comportant trois composants passifs R2, C1 et R3.

Le composant sélectionné CPS est la résistance R2 entre les bornes a et b de laquelle est captée la différence de potentiel V(R2,a,b) (étape 12).

A partir de cette différence de potentiel captée, du modèle de la résistance et des règles générales contenues dans la mémoire de modèles, sont estimés les courants I(R2,a) et I(R2,b) aux deux bornes de la résistance ainsi que la différence de potentiel V(R2,b,a) entre les bornes b et a de cette même résistance.

Etant donné qu'à ce stade du traitement, il n'est plus possible d'estimer une grandeur physique avec les données présentes dans la mémoire de valeurs, il convient de choisir une autre maille pour la capture d'une différence de potentiel. La maille M1 est à nouveau choisie puisque c'est celle qui présente le plus grand nombre de différences de potentiels déjà connues.

Le composant sélectionné CPS est alors le condensateur C1 entre les bornes b et a duquel est captée une différence de potentiel. Il est rappelé ici que la capture de cette différence de potentiel s'effectue dans les mêmes conditions de fonctionnement du circuit que celles effectuées pour la capture précédente, c'est-à-dire entre l'instant de mise en route du circuit (0 microseconde) et 40 microsecondes.

A partir de cette différence de potentiel, sont successivement estimés :

- la différence de potentiel V(C1,a,b) entre les bornes a et b,

- le courant I(C1,a) en la borne a,

- le courant I(C1,b) en la borne b, puis, en supposant un courant total nul au noeud N2,

- le courant de base I(Q1,b) du transistor Q1 à partir du courant estimé en la borne b de la résistance R2 et du courant estimé en la borne a du condensateur C1, puis

- la différence de potentiel V(R3,a,b) entre les bornes a et b de la résistance R3, à partir des deux différences de potentiels précédemment captées, dont la fourchette d'incertitude estimée à l'instant 10,2 µs vaut environ (4,848; 4,969),

- le courant I(R3,a) en la borne a de la résistance R3,

- le courant I(R3,b) en la borne b de la résistance R3, puis, avec l'hypothèse du courant nul au noeud N4 du circuit,

- le courant I(Q2,c) de collecteur du transistor Q2.

A ce stade de l'estimation, il apparaît deux fourchettes disjointes pour le courant de collecteur du transistor Q2 (référence FD1) sur les quatre instants d'échantillonnage successifs suivants : 16,4 µs; 16,5 µs; 16,6 µs; 16,7 µs.

La première de ces fourchettes disjointes est une fourchette d'incertitude estimée et le groupe de composants ayant contriubé à son établissement comporte le transistor Q2, la résistance R3, la résistance R2 et le condensateur C1. A titre d'exemple, la fourchette d'incertitude estimée à l'instant 16,4 µs vaut (-0,03A; -0,006A) environ.

La deuxième de ces fourchettes est une fourchette de référence contenue dans le modèle du transistor Q2 et précisant que ce courant collecteur doit êre positif, c'est-à-dire la fourchette $[-10^{-4}A, +\infty[$. Bien entendu, seul le transistor Q2 est à l'origine de cette fourchette de référence et constitue alors, en quelque sorte, le deuxième groupe de composants ayant contribué à l'établissement de cette fourchette de référence.

En conséquence, un premier ensemble primaire suspect de composants EPR1, résultant de la réunion des deux groupes de composants ci-avant, comporte le transistor Q2, la résistance R3, la résistance R2 et le condensateur C1.

Bien que les moyens de traitement doivent maintenant analyser (étape 14) cet ensemble primaire de composants EPR1, le mécanisme d'estimation permet encore l'estimation 13 de la différence de potentiel V(R3,b,a) entre les bornes b et a de la résistance R3.

L'analyse de cet ensemble primaire de composants EPR1 révèle qu'il ne s'agit pas là d'un conflit minimum puisque les quatre composants de cet ensemble ne sont pas tous connectés à une même borne. En conséquence, il convient d'examiner aux bornes de quel composant de cet ensemble une capture de différence de potentiel n'a pas déjà été effectuée. Il s'agit là des composants R3 et Q2. La résistance R3 étant un composant passif, la capture de la différence de potentiel s'effectuera préférentiellement à ses bornes, ce qui est réalisé dans l'étape 142 entre les bornes b et a.

A partir de là sont successivement estimées :

- la différence de potentiel V(R3,a,b) entre les bornes a et b de la résistance R3,

- le courant I(R3,a) en la borne a de la résistance en utilisant le modèle de celle-ci, puis

- le courant I(R3,b) en la borne b et enfin

- le courant collecteur I(Q2,c) du transistor Q2 en utilisant à nouveau le courant en la borne b du condensateur C1, le courant en la borne b de la résistance R3 et le fait que le courant est nul au noeud N4.

L'homme du métier remarque ici qu'en ce qui concerne la différence de potentiel V(R3,a,b) aux bornes de la résistance R3, on obtient une deuxième fourchette d'incertitude estimée qui vaut environ (4,870; 4,962) à l'instant 10,2 μs. En effet, cette grandeur avait déjà été estimée auparavant à partir de la capture de la différence de potentiel aux bornes du condensateur C1. Cependant, ces deux fourchettes n'étant pas disjointes, les moyens de traitement ne concluent pas à l'existence d'un ensemble primaire suspect de composants. La fourchette d'intersection (4,870; 4,962) à l'instant 10,2 μs entre ces deux fourchettes est alors stockée dans la mémoire de valeurs pour être affectée en priorité à cette grandeur physique lors d'une comparaison ultérieure éventuelle et être utilisée par le mécanisme d'estimation pour d'autres estimations.

Par contre, on obtient (référence FD2) une autre fourchette d'incertitude estimée en ce qui concerne le courant de collecteur du transistor Q2 qui, rapprochée à nouveau avec la fourchette de référence du modèle, révèle une intersection vide sur deux instants d'échantillonnage.

Les moyens de traitement concluent donc à l'existence d'un deuxième ensemble primaire de composants EPR2 comportant le transistor Q2, le condensateur C1 et la résistance R3.

L'intersection des deux ensembles primaires EPR1 et EPR2 est réduite à l'ensemble primaire EPR2. Le traitement doit donc être poursuivi puisque, à ce stade, on ne peut pas discerner parmi ces trois composants Q2, C1, R3 lequel présente un fonctionnement incorrect.

L'étape 14 d'analyse de l'ensemble primaire EPR2 est effectuée et révèle que cet ensemble primaire traduit un conflit minimum puisque les trois composants sont tous connectés au noeud N4. Aucune capture supplémentaire de différence de potentiel n'est alors effectuée sur cet ensemble primaire.

La maille suivante sélectionnée selon le premier mécanisme est la maille M2 constituée des composants R1, Q1 et R2, puisque, mise à part la maille M1, il s'agit de la maille présentant le plus fort nombre de différences de potentiels déjà connues.

Le composant sélectionné CPS est la résistance R1 entre les bornes b et a de laquelle est effectuée une capture 12 de différence de potentiel.

A partir de cette grandeur physique captée, sont successivement estimés :

- la tension V(R1,b,a) aux bornes de cette résistance prise entre les bornes b et a,

- le courant I(R1,a) en la borne a et le courant I(R1,b) en la borne b en utilisant le modèle de résistance,

- le courant d'alimentation I(ALIM+) en la borne positive de cette alimentation ALIM en utilisant la règle du courant nul au noeud N3 du circuit et les courants estimés I(R1,a), I(R2,a), I(R3,a) en les bornes a des résistances R1, R2 et R3,

- le courant I(ALIM-) en la borne moins de l'alimentation,

- la tension base collecteur V(Q1,b,c) du transistor Q1 connaissant les différences de potentiels captées aux bornes des résistances R1 et R2 ainsi que la règle de nullité de la somme des différences de potentiels le long de la maille M2.

Aucune autre estimation n'étant possible, il convient de sélectionner un autre composant aux bornes duquel sera captée une différence de potentiel.

La maille sélectionnée est alors la maille M3 constituée du transistor Q1, de la résistance R4, du transistor Q2 et du condensateur C1.

Le composant sélectionné est la résistance R4 entre les bornes a et b de laquelle est captée la différence de potentiel (étape 12).

A partir de là sont successivement estimés :

- la différence de potentiel V(R4,b,a) entre les bornes b et a de cette résistance,

- les courants en les deux bornes de cette résistance,

- le courant de collecteur (I(Q1,c) du transistor Q1 en utilisant les courants aux bornes a et b des résistances R4 et R1 ainsi que la règle du courant nul au noeud N1,

- le courant émetteur I(Q1,e) du transistor Q1 à partir du courant de collecteur de ce transistor, du courant de base de ce transistor et de la règle spécifiant un courant nul au niveau de la jonction des trois bornes de ce transistor, remarque étant faite que le courant de base de ce transistor Q1 est estimé à partir du courant en la borne b de la résistance R2, du courant en la borne a du condensateur C1 et de la règle spécifiant un courant nul au noeud N2.

On obtient alors, pour ce courant émetteur du transistor Q1, une première fourchette d'incertitude estimée qui, rapprochée avec la fourchette de référence du modèle spécifiant que ce courant doit être négatif, révèle une intersection vide et donc un troisième ensemble primaire suspect de composants EPR3 comportant le transistor Q1, la résistance R1, la résistance R4, la résistance R2 et le condensateur C1.

A titre indicatif, le conflit apparaît aux instants 10 μs et 10,1 μs et la première fourchette d'incertitude estimée vaut environ, à ce dernier instant (0,02A; 0,05A).

La comparaison des trois ensembles primaires obtenus (étape 2) révèle une intersection réduite à un seul composant, à savoir le composant défectueux (qui est ici le condensateur C1), ce qui met fin au programme de diagnostic dans l'hypothèse d'une panne unique.

L'homme du métier remarque ainsi que seules deux captures de différences de potentiels ont été nécessaires pour l'obtention du premier ensemble primaire suspect de composants et que cinq captures de différences de potentiels ont été nécessaires au total pour l'établissement du diagnostic révélant le condensateur C1 en tant que composant défectueux.

Bien qu'il soit particulièrement avantageux d'utiliser la mise en oeuvre de l'automate de décisions, le dispositif de test ici décrit permet également à l'utilisateur de choisir lui-même les composants relativement auxquels il effectuera des captures de grandeurs physiques, par exemple dans des cas simples ou lorsque celui-ci a déjà une idée préconçue sur la panne qu'il recherche. Dans ce cas, la suite du traitement reste analogue à celle décrite précédemment, notamment en ce qui concerne le mécanisme d'estimation et le rapprochement des fourchettes.

L'utilisateur peut également modifier l'automate de décision par l'adjonction de critères particuliers, par exemple spécifiques au réseau de composants en cours de test, ou pour remplacer la sélection arbitraire d'une maille.

Il convient encore de noter que l'une des grandeurs physiques sur laquelle est susceptible de s'effectuer le rapprochement des deux fourchettes peut être le courant traversant une jonction semi-conductrice telle qu'une diode, ou bien encore la différence de potentiel aux bornes d'un composant passif, tel qu'une résistance.

Par ailleurs, le dispositif n'est pas incompatible avec l'utilisation d'expressions-composant relatives à des fonctionnements incorrects de composants (modèles de fautes) qui peuvent être employées, par exemple, pour confirmer ou affiner un diagnostic obtenu à partir de modèles relatifs à un fonctionnement correct des composants.

On va maintenant décrire un autre mode de réalisation du dispositif selon l'invention mettant en oeuvre un algorithme de fonctionnement basé sur un test portant sur l'ensemble des expressions de courant estimées par le dispositif, d'une condition prenant en compte la nullité présumée du courant total en une borne commune du circuit électronique.

Bien que l'utilisation de fourchettes de précision, d'incertitude estimées et de référence ne soit pas incompatible avec le test de cette condition, on ne décrira ici qu'un traitement simplifié n'utilisant pas de telles fourchettes. Aussi, comme on le verra ci-après, les expressions-composants des modèles seront simplifiés.

Dans ce mode de réalisation, pour une application de 100 composants environ, une mémoire de masse d'une capacité de 1,44 mega-octets et une mémoire centrale de travail d'environ 1 mega-octet sont suffisantes.

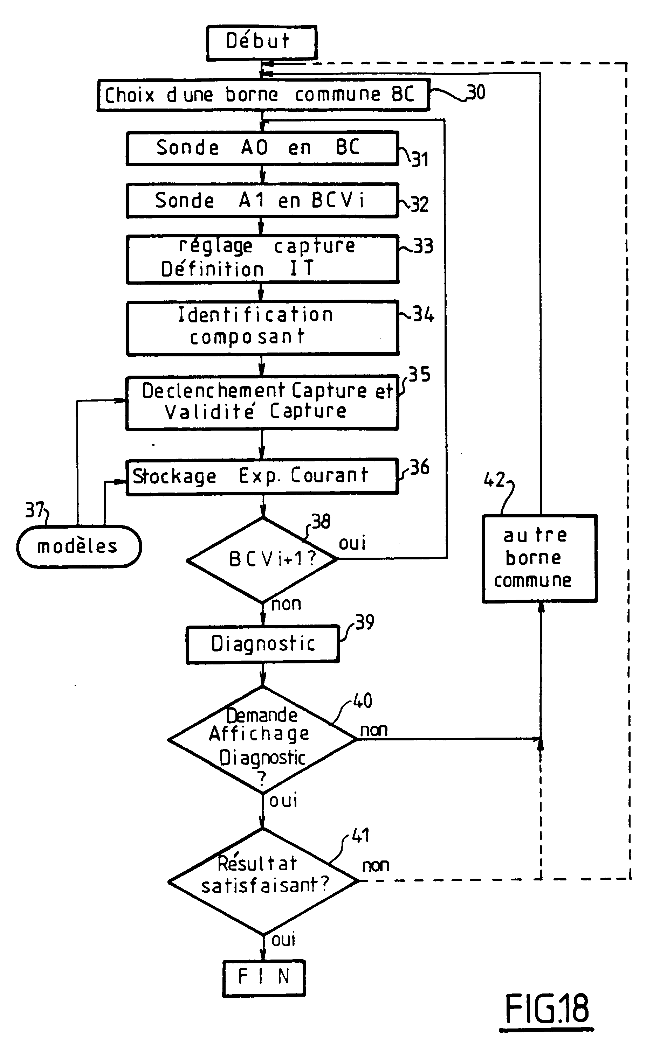

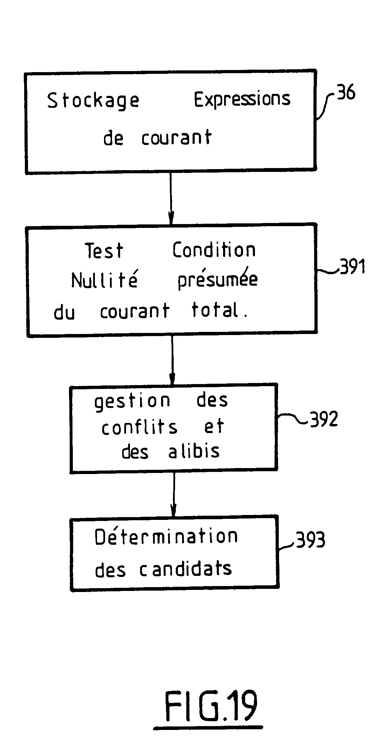

On va maintenant décrire d'une façon générale le fonctionnement de ce dispositif, en se référant plus particulièrement aux figures 18 et 19.

Un des principes fondamentaux utilisé au sein de ce mode de réalisation consiste à déterminer des expressions de courant à partir des différences de potentiel captées entre les bornes de chaque composant d'un ensemble de composants reliés à une même borne commune ou noeud d'observation, et à partir de modèles fonctionnels décrivant leurs comportements respectifs, remarque étant faite que ces modèles peuvent être représentatifs d'un mauvais fonctionnement ou d'un bon fonctionnement, comme on le verra ci-après.

Dans une étape 30, l'utilisateur choisit une borne commune BC d'un ensemble de composants. Le choix de cette borne est laissé à l'appréciation de l'utilisateur. Si celui-ci est familiarisé avec le circuit à dépanner ou s'il en connaît les fonctionnalités, il peut choisir judicieusement une première borne commune à laquelle sont reliés des composants qu'il juge suspects. Cependant, s'il n'a aucune idée préconçue sur l'origine de la panne, ou s'il ne connaît pas les fonctionnalités du circuit, il choisit une première borne commune au hasard et procédera alors de proche en proche pour établir son diagnostic, en étant éventuellement guidé par le dispositif.

La première sonde A0 est placée au niveau de la borne commune BC (étape 31) tandis que la deuxième sonde A1 est placée en une borne voisine BCVi de cette borne commune (étape 32).

Dans l'étape 33, l'utilisateur règle ses paramètres de capture en définissant par exemple la base de temps, l'amplitude de la mesure. Il définit en d'autres termes l'intervalle temporel IT pour la capture de la différence de potentiel entre la borne BC et la borne BCVi. Ces divers paramètres peuvent être réglés directement sur l'organe de capture tel que l'oscilloscope numérique ou bien peuvent être entrés dans le système à l'aide du clavier si les moyens de sonde et de numérisation commandables sont par exemple intégrés au dispositif.

Dans l'étape suivante 34, l'utilisateur identifie le composant branché entre la borne BC et la borne BCVi à l'aide du clavier. Il peut utiliser à cette fin des touches dédiées du clavier et marquées (par exemple R pour une résistance et Q pour un transistor). Il se sert également de touches numériques pour désigner le repère du composant sur le schéma électrique.

L'utilisateur déclenche alors la capture proprement dite de la différence de potentiel, dans l'étape 35, ce qui marque le début d'une série d'opérations effectuées par les moyens de traitement.

D'une façon analogue au mode de fonctionnement déjà décrit, les données analogiques correspondant aux différences de potentiel sont numérisées dans les moyens de numérisation commandables MNC et transmises aux moyens de traitement. Ceux-ci sont alors aptes à mémoriser ces informations dans la mémoire MM1 et à les caractériser pour leur traitement ultérieur, en tenant compte de la représentation schématique du circuit. On peut à cet effet par exemple définir une fenêtre temporelle, un temps de montée, une fréquence et un repère permettant d'attribuer ces caractéristiques au composant correspondant du circuit tel qu'il est repéré dans le schéma électrique.

Il est également avantageux que les moyens de traitement soient aptes à s'assurer de la validité d'une telle capture. A cet effet, ils utilisent notamment le modèle fonctionnel 37 du composant identifié. Ainsi, si le modèle du composant fait apparaître qu'il est nécessaire de prendre en compte la dérivée temporelle de la différence de potentiel pour l'établissement d'une expression de courant, et que dans le même temps, la période d'échantillonnage choisie pour la capture ne permet pas d'obtenir cette dérivée avec une précision suffisante, les moyens de traitement considéreront la capture effectuée comme non valide car ne permettant pas d'en déduire une expression de courant précise. Dans ce cas alors, des directives peuvent être affichées sur l'écran MAF du dispositif à l'attention de l'utilisateur afin que celui-ci modifie le pas d'échantillonnage puisque les moyens de numérisation MNC sont commandables.

On suppose maintenant que la capture a été jugée valide par les moyens de traitement.

Ceux-ci déterminent alors, dans l'étape 36, une expression de courant pour la différence de potentiel captée, tirée du modèle fonctionnel du composant concerné, sur ledit intervalle temporel IT. D'une façon générale, ce modèle peut être représentatif d'un fonctionnement correct du composant ou bien d'un fonctionnement incorrect de celui-ci. L'utilisation de l'un ou l'autre des modèles est laissée à l'appréciation de l'utilisateur, dans la mesure des modèles disponibles en mémoire.

En ce qui concerne les composants de type dipôle (par exemple résistance, condensateur), les modèles de bon fonctionnement sont une retranscription des lois de la physique régissant l'évolution des paramètres courant-tension.

Pour les autres types de composants, les modèles correspondent plutôt à des ensembles de contraintes à satisfaire.

Des exemples détaillés de modèles fonctionnels seront décrits ci-après. On peut cependant d'ores et déjà indiquer qu'il est possible là encore d'affecter à un composant électronique donné une pluralité de modèles fonctionnels de complexités différentes. Le dispositif pourra alors utiliser par exemple d'abord un modèle fonctionnel simple et, si le diagnostic aboutit à une conclusion manifestement inattendue, ou aboutit à aucune conclusion, on pourra alors utiliser des modèles de complexité supérieure.

Une fois l'expression de courant estimée par les moyens de traitement, celle-ci est stockée en mémoire en vue du diagnostic.

Dans l'étape suivante 38, l'utilisateur place la sonde A1 successivement sur les autres bornes voisines reliées à la borne commune BC et le dispositif réexécute successivement les étapes 34 et 36.

Il convient de remarquer ici que les moyens de traitement sont avantageusement aptes à mémoriser la borne commune au sein du circuit à contrôler, ainsi que l'identification des composants branchés à celle-ci. Ainsi, ceci permet, au fil de la procédure, de construire, de façon incrémentale, une représentation du circuit. De plus, ceci permet à l'utilisateur d'éviter de rentrer les mêmes informations d'une session à l'autre concernant des composants ou des bornes déjà observés.

Lorsque toutes les bornes voisines ont été traitées, le dispositif passe alors dans l'étape 39 de diagnostic dont le principe général consiste en un test, par les moyens de traitement, sur l'ensemble des expressions de courant, en chaque instant dudit intervalle temporel IT, d'une condition prenant en compte la nullité présumée du courant total en ladite borne commune, ce qui permet d'obtenir une première indication sur le fonctionnement des composants branchés à cette borne commune.

D'une façon générale, ce test de ladite condition comprend la comparaison d'une valeur algébrique à une valeur de référence. Plus précisément, lorsque certaines au moins des expressions de courant sont des valeurs algébriques de courant proprement dites, le test de l'ensemble des expressions de courant comprend la somme algébrique de ces valeurs de courant qui est alors comparée à une valeur de référence. On pourra par exemple tester si cette somme algébrique est positive ou négative.

Dans le cas où toutes les expressions de courant sont des valeurs algébriques proprement dites, on teste si la somme algébrique de toutes les valeurs de courant est égale ou différente de 0, à un seuil de précision près.

Plusieurs cas peuvent se produire.

Si chaque expression de courant relative à chaque composant branché à la borne commune est tirée d'un modèle fonctionnel représentatif d'un fonctionnement correct du composant, et si la condition prenant en compte la nullité présumée du courant total en ladite borne commune est satisfaite (par exemple la somme algébrique de toutes les valeurs de courant est nulle), alors ladite première indication peut être représentative d'un fonctionnement individuel respectif incorrect d'une pluralité de composants branchés à la borne commune, l'ensemble de tous les composants branchés à cette borne commune ayant globalement un fonctionnement correct.

Si au contraire le test de la condition prenant en compte la nullité présumée du courant total est négatif (la somme algébrique de toutes les valeurs de courant est par exemple différente de 0), alors ladite première indication peut être représentative du fonctionnement incorrect d'au moins un composant branché à ladite borne commune, l'ensemble de ces composants ayant globalement également un fonctionnement incorrect.

On a vu que l'on pouvait cependant utiliser des modèles fonctionnels représentatifs de fonctionnements incorrects de composants. Dans ce cas, lorsqu'une seule expression de courant est tirée d'un modèle fonctionnel représentatif d'un fonctionnement incorrect d'un composant, branché à ladite borne commune, tandis que les autres expressions de courant relatives aux autres composants sont tirées respectivement des modèles fonctionnels représentatifs du fonctionnement correct, et lorsque la condition de la nullité présumée du courant total en ladite borne commune est satisfaite, alors ladite première indication signifie qu'effectivement le composant pour lequel un modèle de fonctionnement incorrect a été utilisé est défaillant.

Par contre, si le test de ladite condition est négatif (condition de nullité non satisfaite), le composant pour lequel un modèle de fonctionnement incorrect a été utilisé, est "innocenté" de ce mauvais fonctionnement (sous réserve que les autres composants reliés à cette borne commune soient supposés bons) et la recherche doit être poursuivie en appelant un par un successivement d'autres modèles de mauvais fonctionnement pour d'autres composants.

Il est intéressant ici de repréciser et d'introduire les notions de "conflit", "alibi" et "candidat". Pour la définition de ces notions, on se place maintenant dans l'hypothèse de l'utilisation de modèles de bon fonctionnement pour tous les composants branchés à la borne commune.

Si le test de la condition prenant en compte la nullité présumée du courant total en ladite borne commune n'est pas satisfaite à la borne commune choisie, il y a alors conflit sur cette borne commune entre les captures d'une part et les hypothèses de bon fonctionnement d'autre part. En d'autres termes, au moins un des modèles utilisés n'est pas vérifié.

Dans le cas où le test de cette condition est négatif, on a vu ci-avant que ceci impliquait que tous les composants étaient bons ou qu'au moins deux d'entre eux présentaient des mauvais fonctionnements se compensant. En d'autres termes, pour une borne commune choisie, un composant peut être "innocenté" si le groupe de tous les autres est supposé (ou vérifié) bon. De même, un composant ne peut être considéré comme défaillant que si, au moins un du groupe des autres composants reliés à la borne commune est lui-même considéré comme défaillant. On conçoit alors aisément que ledit groupe de composants forme un "alibi" pour le composant considéré.

En d'autres termes, un "conflit" est là encore un ensemble de composants dont l'un au moins présente un fonctionnement incorrect.

Un candidat est un ensemble qui est l'intersection de tous les conflits. Les alibis permettent éventuellement de restreindre les candidats possibles puisqu'un composant possédant un alibi ne peut appartenir à un ensemble candidat que si l'un au moins des éléments de son alibi y est inclus.

Ainsi, une fois que le test de la condition de nullité présumée du courant total a été effectué (étape 391), les moyens de traitement gèrent les conflits et les alibis (étape 392) et déterminent les candidats (étape 393).

Dans le cas d'un circuit où toutes les bornes sont observables (conformément à la définition donnée plus haut), un maximum de conflits pourront être détectés et le nombre de candidats possibles sera minimum.

Dans le cas contraire, le nombre de candidats possibles peut augmenter, réduisant ainsi les possibilités de diagnostic à une partie seulement du circuit à dépanner.

Lorsque le diagnostic a été effectué, l'utilisateur peut en demander ou non l'affichage (étape 40). Il pourra par exemple ne pas le faire s'il estime que, ayant placé la sonde A0 en une borne commune de masse, l'affichage du diagnostic ne lui sera d'aucune utilité. Par contre, les informations mémorisées lors de cette première série de captures seront utiles au dispositif dans la suite de la recherche. L'utilisateur choisit alors une autre borne commune (étape 42) et la succession des opérations se poursuit comme indiqué précédemment.

Si l'affichage du diagnostic est demandé, et que le résultat est jugé satisfaisant par l'utilisateur (étape 41), ce qui peut correspondre par exemple à l'affichage effectif d'un seul composant candidat, la recherche est terminée.

Dans le cas où le diagnostic affiché révèle un ensemble de candidats, l'utilisateur peut alors choisir une autre borne commune (étape 42) et répéter la succession des opérations jusqu'à réduire le nombre des candidats. Cette autre borne commune est alors avantageusement choisie parmi les bornes voisines de la première borne commune. Ce deuxième ensemble de captures fournira alors une deuxième indication sur l'ensemble des composants branchés à la deuxième borne commune. La combinaison des première et deuxième indications permettra alors l'affinage du diagnostic en fournissant par exemple une indication sur le fonctionnement d'un composant branché entre les première et deuxième bornes communes.

Le résultat peut être également jugé insatisfaisant si, manifestement, le circuit est en panne, et que l'affichage du diagnostic ne révèle aucun candidat. Ceci peut alors signifier par exemple que les modèles utilisés ne sont pas assez précis. L'utilisateur peut alors commander une nouvelle recherche en forçant l'utilisation de modèles de complexité supérieure disponibles.

Si le résultat n'est toujours pas satisfaisant, l'utilisateur peut être amené à douter de la conception du circuit ou encore à considérer des aspects autres que purement électriques (du type thermique, ou bien des couplages parasites par exemple) non modélisés et du ressort d'un expert.

Le dispositif selon l'invention offre à cet égard une alternative supplémentaire à l'utilisateur. En effet, les moyens de dialogue du dispositif permettent à l'utilisateur d'enrichir la bibliothèque de modèles en créant lui-même des modèles de bon ou de mauvais fonctionnement pour un composant.

L'homme de l'art remarque donc que ce dispositif offre également une grande souplesse d'utilisation. Il n'exige pas de description préalable du circuit à dépanner et l'utilisateur peut ne pas en connaître les détails de son fonctionnement, voire même ignorer les symptômes de sa défaillance. De plus, les conflits détectés sont indiscutables, c'est-à-dire qu'il est certain que l'un au moins des composants du conflit est mauvais.

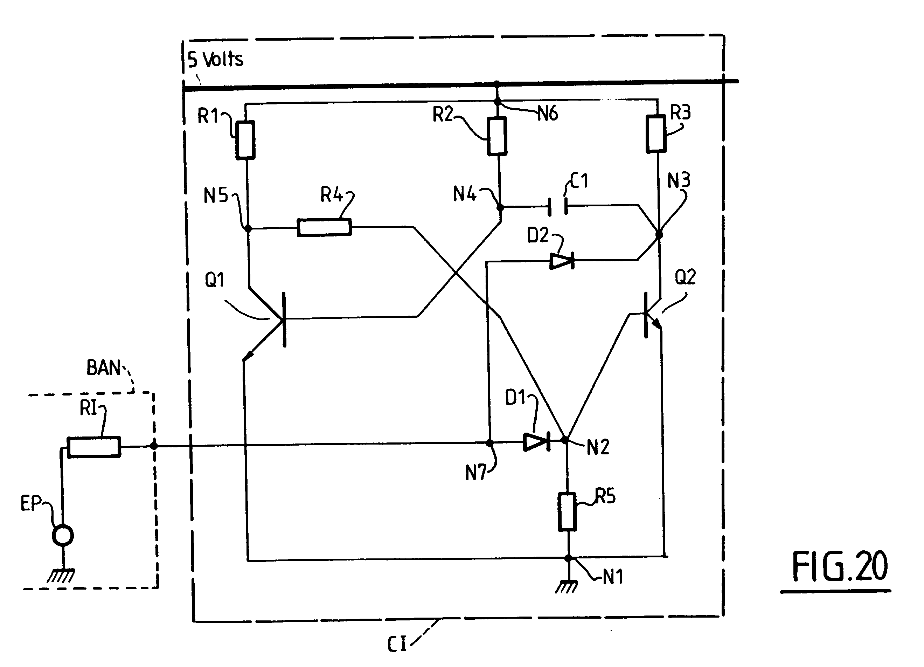

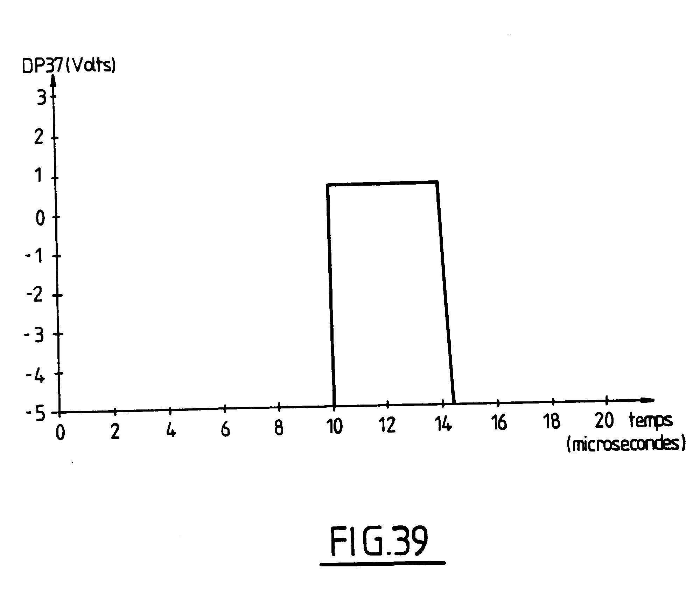

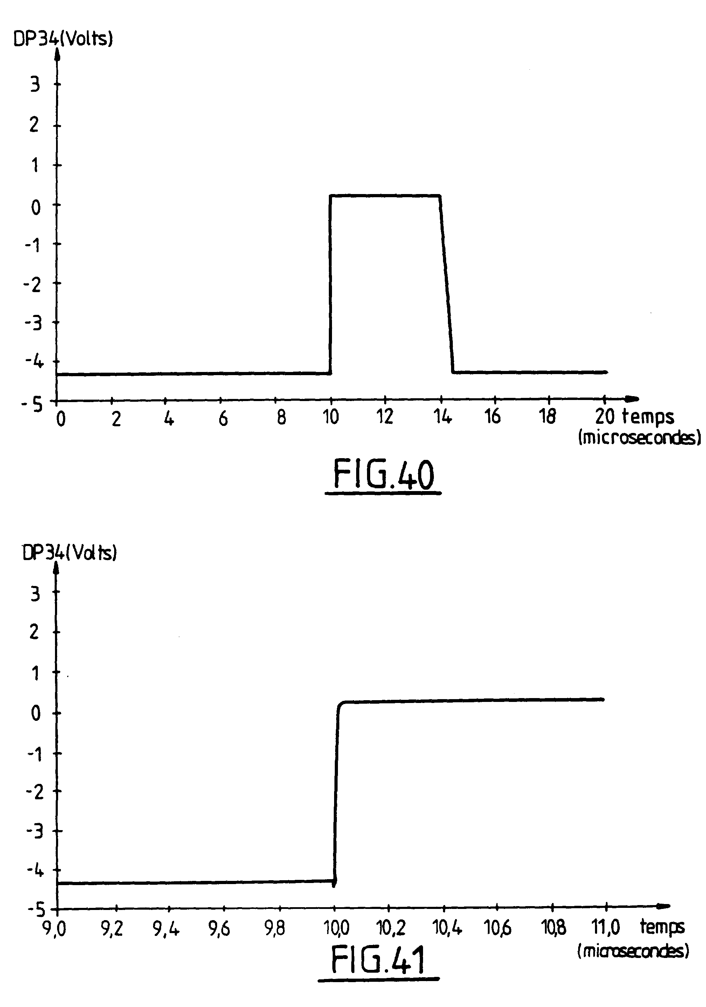

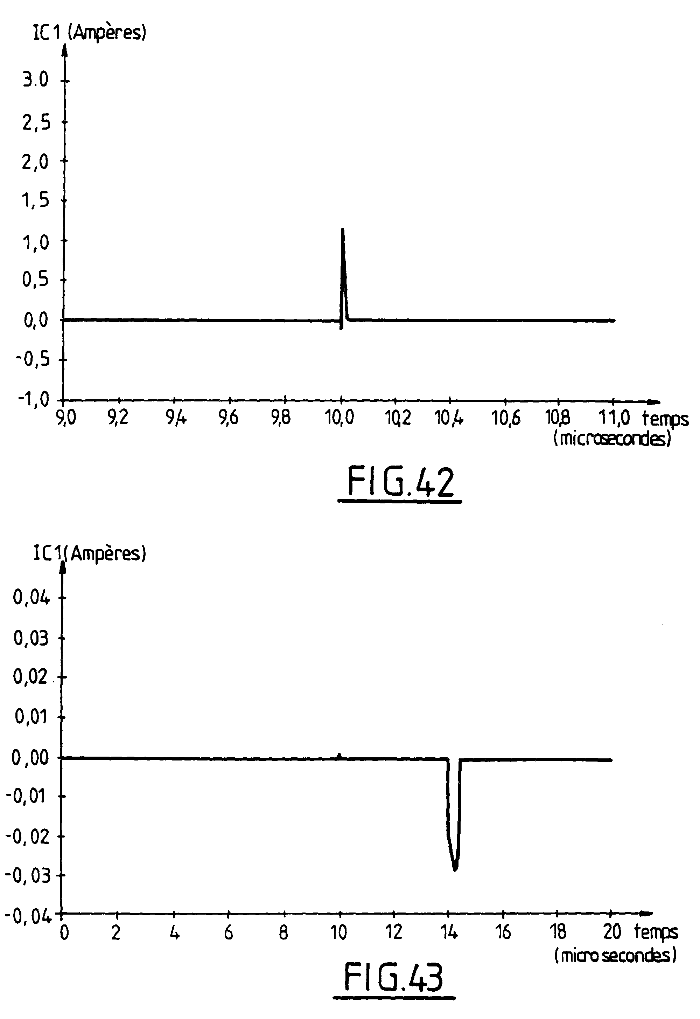

Un exemple précis d'utilisation du dispositif va maintenant être illustré sur un cas particulier, en se référant plus particulièrement aux figures 20 à 43.

Le circuit CI de la figure 20 est analogue à celui de la figure 14. Une diode D2, qui avait été retirée du circuit de la figure 14, à des fins de simplification, a été insérée entre l'anode de la diode D1 et le collecteur du transistor Q2. Cette diode D2 est identique à la diode D1. Par contre, l'alimentation ALIM n'est pas représentée.

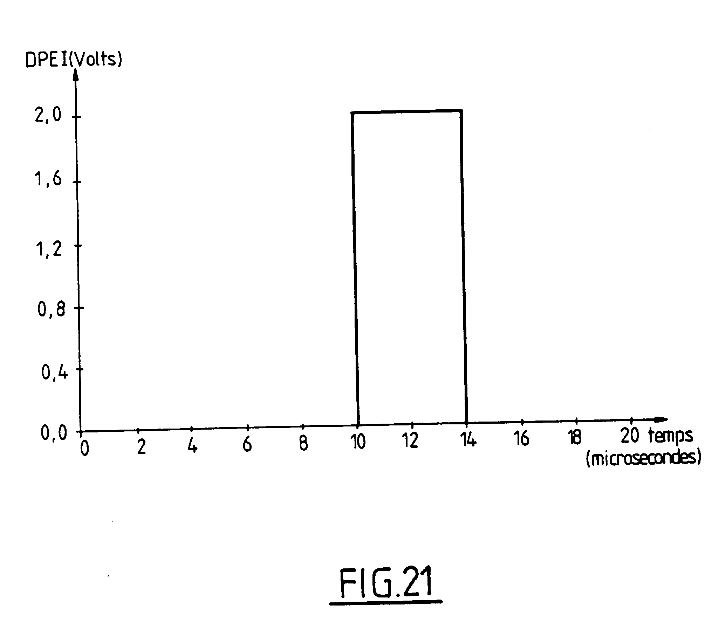

Le circuit comporte sept bornes N1 à N7 qui sont toutes observables. L'intervalle temporel choisi est compris entre 0 et 20 microsecondes. La forme d'onde DPEI en forme de créneau générée par le banc BAN est illustrée sur la figure 21. Le composant défaillant est là encore le condensateur C1 qui est coupé.

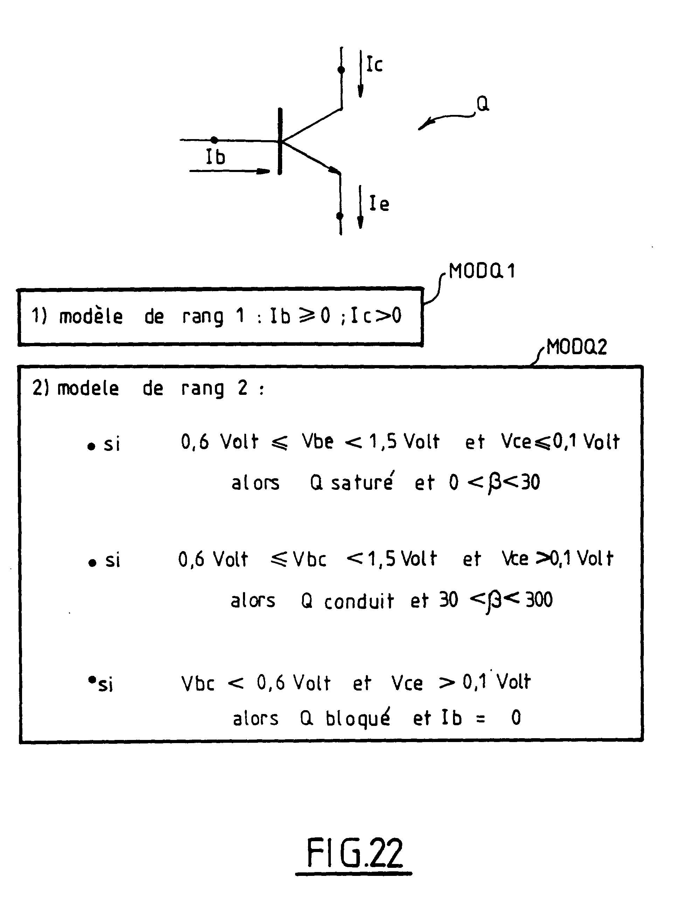

Les deux transistors Q1 et Q2 du circuit CI sont des transistors NPN présentant (figure 22), vu de la base, un courant Ib rentrant, vu du collecteur, un courant Ic rentrant, et vu de l'émetteur, un courant Ie sortant. Lorsque la tension Vbe = Vb - Ve, entre la base et l'émetteur, est supérieure ou égale à 0,6 volt, le courant de collecteur Ic est positif et égal à $\beta$ (béta) fois le courant de base Ib, où $\beta$ désigne le gain en courant. Lorsque la tension Vbe est inférieure à 0,6 volt, alors le transistor est bloqué et le courant de base Ib est nul. On peut donc définir un premier modèle simple que l'on dénommera "modèle de rang 1" MODQ1, et défini par les relations Ib > 0; Ic > 0.

Un modèle de complexité supérieure MODQ2, dénommé "modèle de rang 2", pourra être éventuellement utilisé si le modèle de rang 1 ne donne pas satisfaction. Ce modèle de rang 2 définit les différentes valeurs de $\beta$ dans différents états du transistor. Il convient de remarquer ici que, au sens de la présente description, le terme "expression de courant" peut également englober un gain en courant.

Le modèle de rang 1 MODD1, des diodes D1 et D2 du circuit est également un modèle présentant des contraintes à satisfaire. En effet, si la différence de potentiel VAnK entre l'anode An et la cathode K de la diode est supérieure ou égale à 0,6 volt, alors le courant Id traversant cette diode est strictement positif. Dans le cas contraire, ce courant est nul.

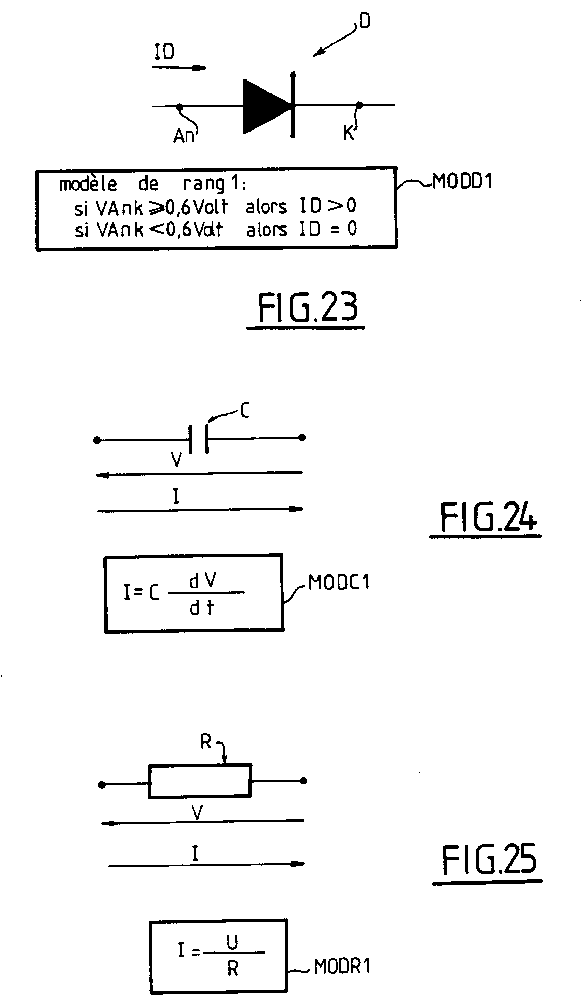

Les modèles de rang 1 MODC1 et MODR1 pour respectivement le condensateur et les résistances du circuit (figures 24 et 25) retranscrivent simplement les lois de la physique régissant l'évolution des paramètres courant-tension.

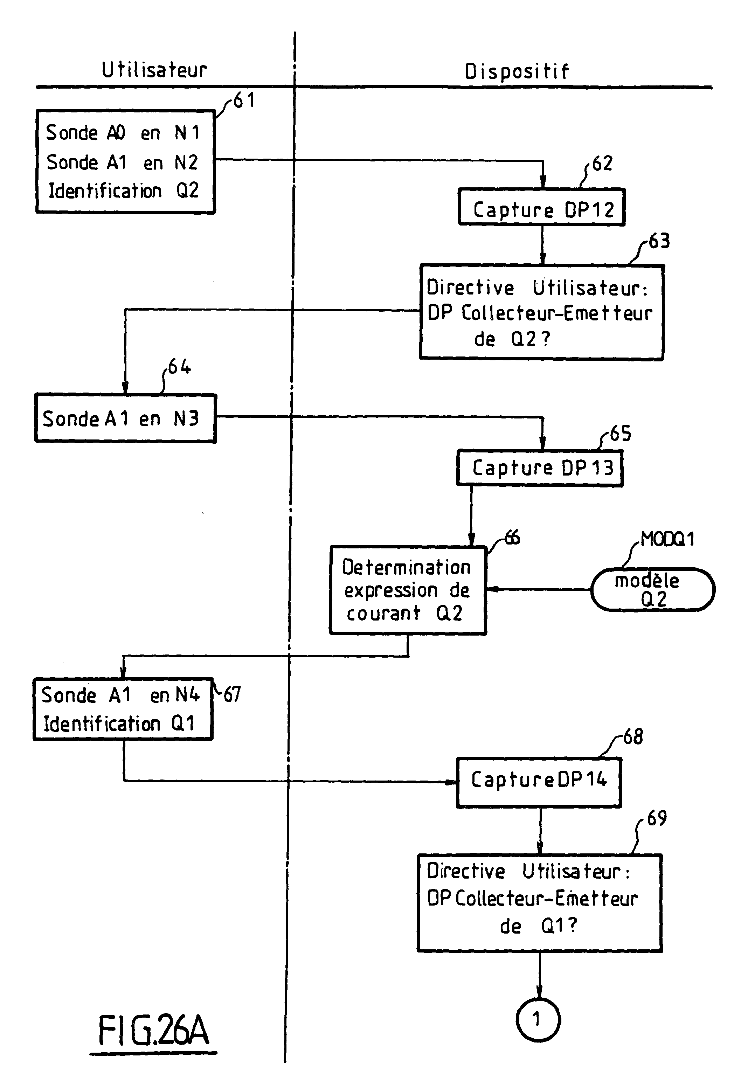

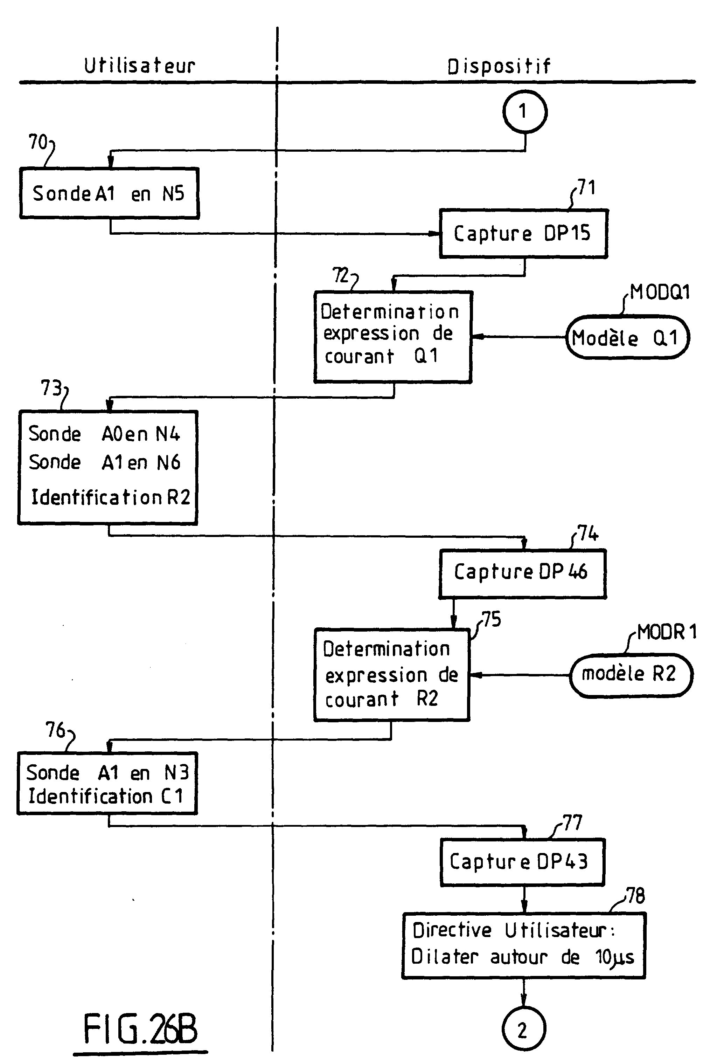

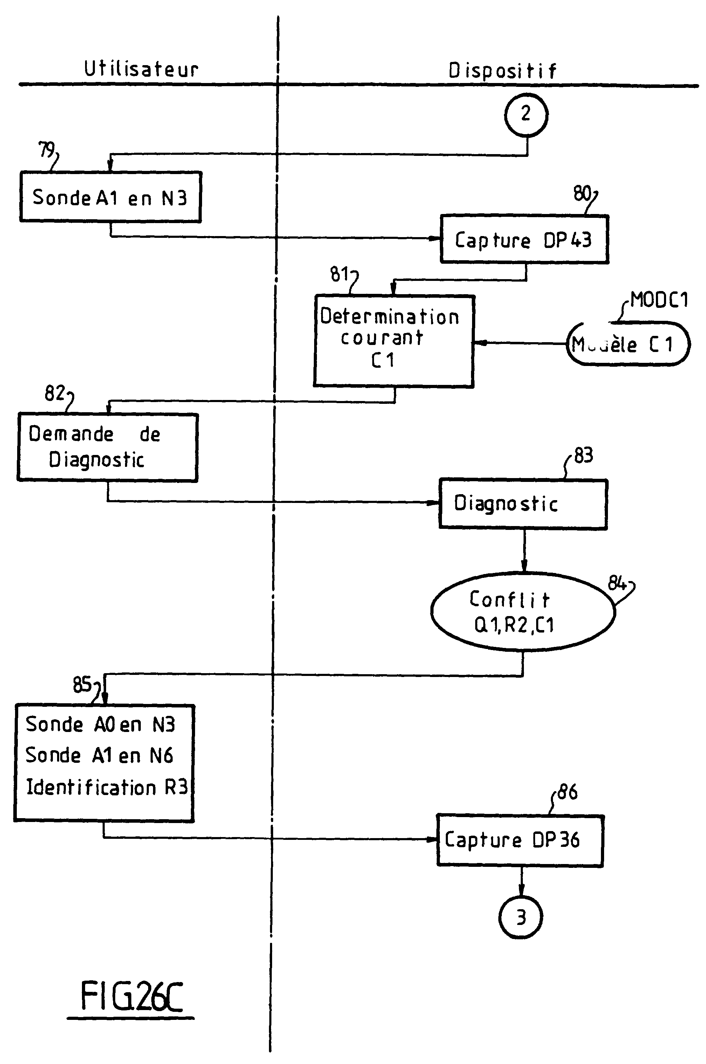

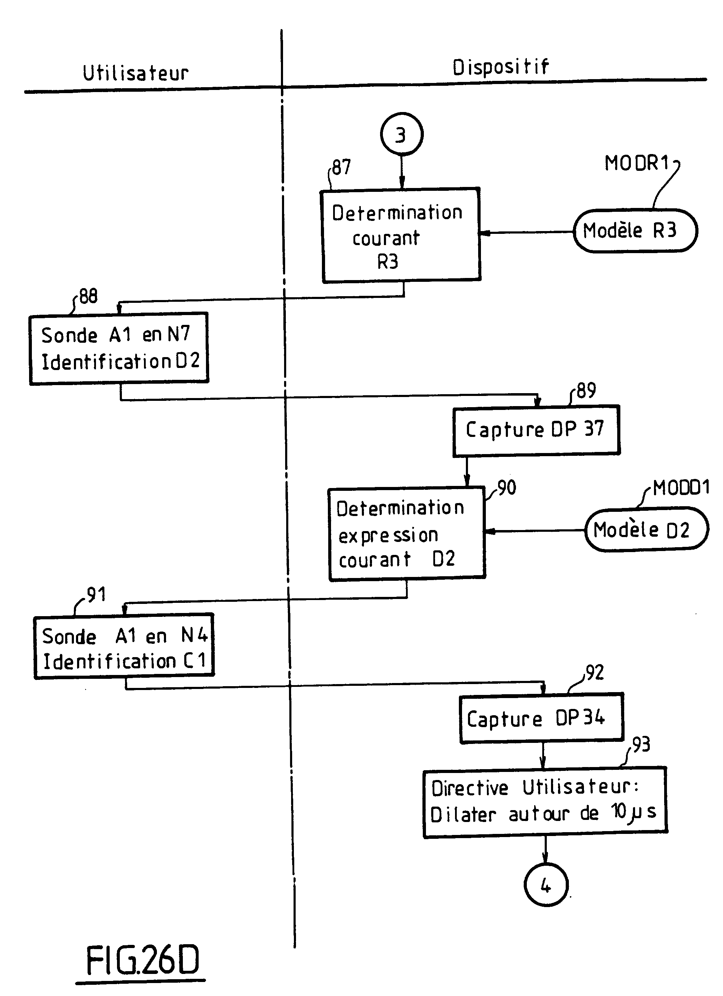

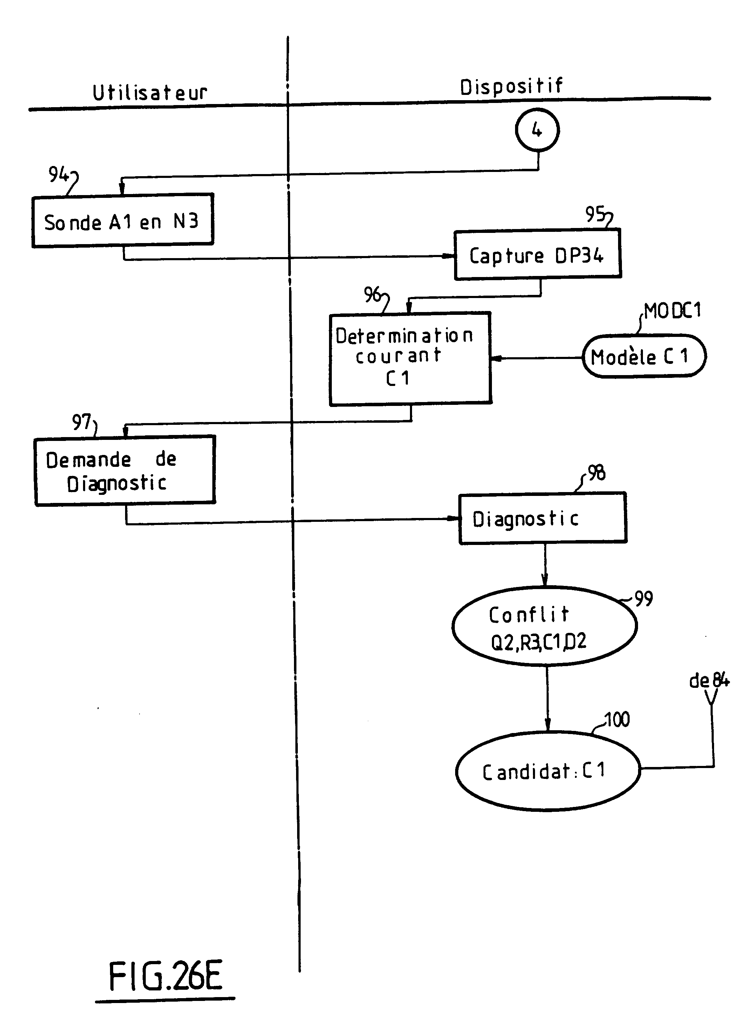

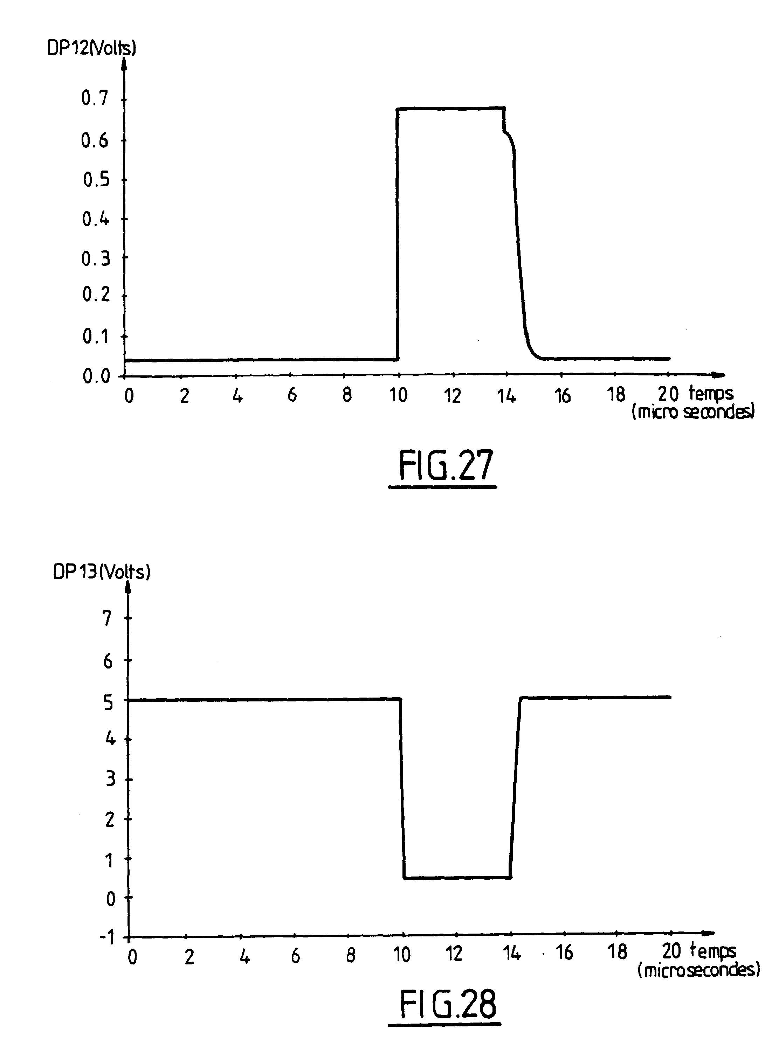

On se réfère maintenant plus particulièrement aux figures 26A à 26E pour décrire les différentes étapes de la recherche de pannes effectuée par l'utilisateur. Les différentes différences de potentiel DPij, entre la borne i et la borne j, sont illustrées sur les figures 27 à 43, de même que les différentes déterminations d'expressions de courant effectuées par les moyens de traitement.

Dans l'étape 61, l'utilisateur choisit comme première borne commune la borne N1 et place la sonde A0 en cette borne. La sonde A1 est placée en la borne N2 et identifie le transistor Q2 à l'aide du clavier. La capture de la différence de potentiel DP12 est alors effectuée (étape 62, figure 27). Puisque le composant est un transistor, les moyens de traitement du dispositif devront nécessairement avoir connaissance à un instant ultérieur du traitement de la différence de potentiel entre le collecteur et l'émetteur de ce transistor. Une directive est alors affichée sur l'écran du dispositif (étape 63) afin que l'utilisateur place la sonde A1 en N3 (étape 64).

Dans l'étape 65, la capture de la différence de potentiel entre le collecteur et l'émetteur de Q2, DP13, est effectuée (figure 28) et les moyens de traitement peuvent alors déterminer l'expression de courant relative à Q2 (étape 66) en tenant compte à toutes fins utiles du modèle MODQ2. On rappelle ici que cette expression de courant correspond en fait à une contrainte.

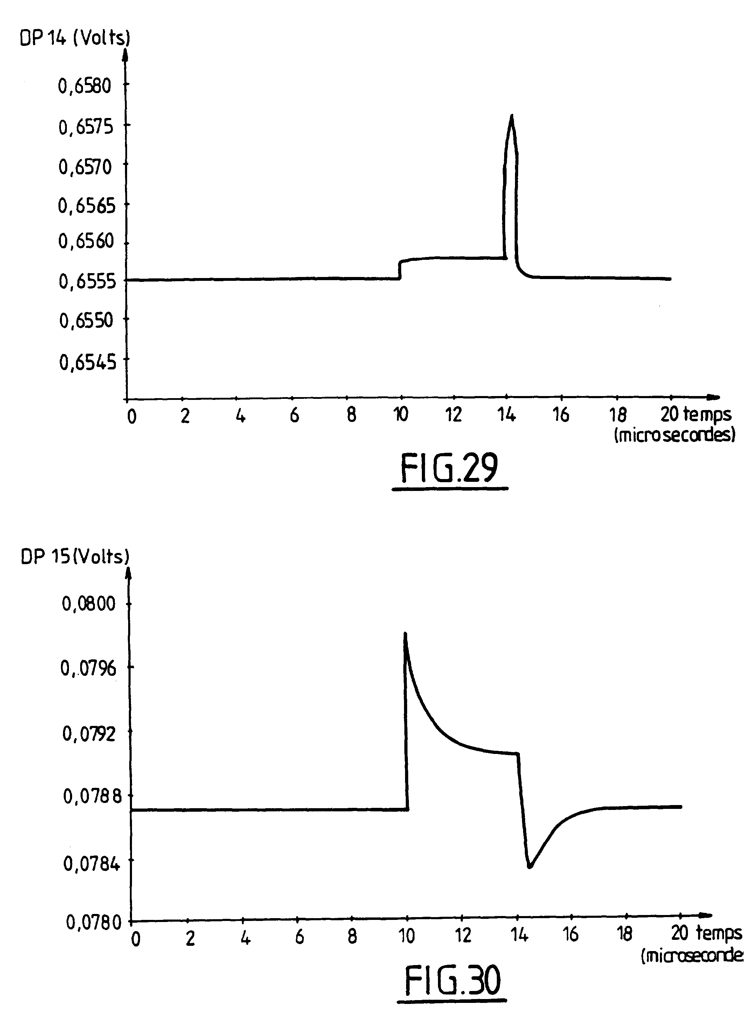

L'utilisateur poursuit sa démarche en plaçant la sonde A1 en une autre borne voisine de la borne commune N1, par exemple en N4 (étape 67) et identifie alors le transistor Q1. La capture de la différence de potentiel DP14 est effectuée dans l'étape 68 et est illustrée sur la figure 29. On retrouve alors, dans l'étape 69, une directive utilisateur analogue à la directive précédente puisqu'il s'agit également d'un transistor. En réponse à cette directive, l'utilisateur place la sonde A1 en la borne N5 (étape 70) et effectue la capture de la différence de potentiel DP15 (étape 71, figure 30), afin que les moyens de traitement puissent déterminer l'expression de courant relative à Q2 (étape 72) en tenant compte toujours du modèle MODQ2.

L'ensemble des observations relatives à la borne commune N1 est maintenant effectué. Cependant, l'utilisateur ne demande pas l'affichage du diagnostic, étant donné qu'il s'agit d'une borne de masse. Cependant, les informations obtenues à l'aide de ces différentes captures sont mémorisées dans le dispositif.

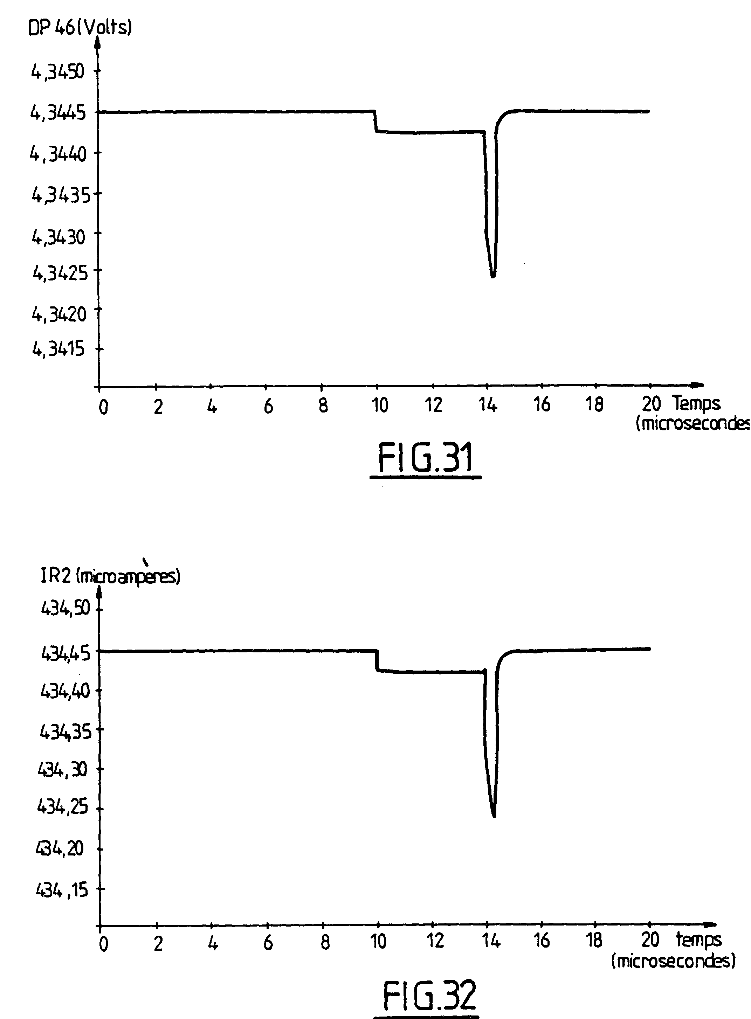

L'utilisateur choisit alors, dans l'étape 73, une deuxième borne commune N4 parmi l'ensemble des bornes voisines de la première borne commune N1. Il place la deuxième sonde A1 en la borne N6 et identifie la résistance R2. La capture de la différence de potentiel DP46 est effectuée dans l'étape 74 (figure 31) et le courant traversant la résistance R2 est déterminé dans l'étape 75, à l'aide du modèle MODR1, et est illustré sur la figure 32.

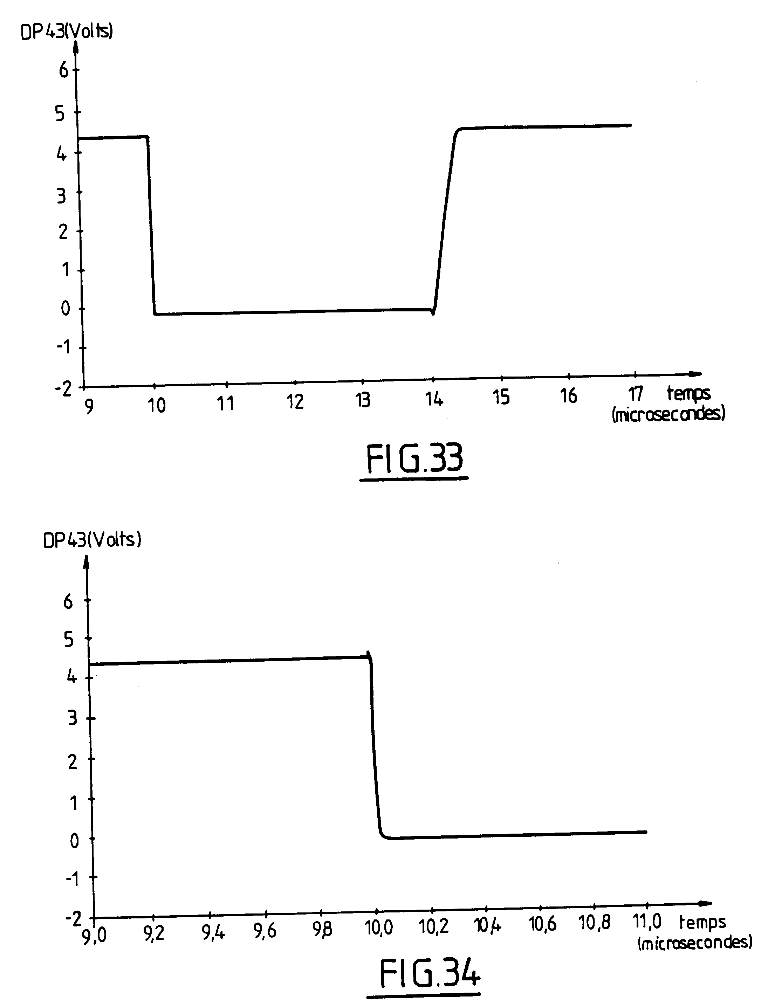

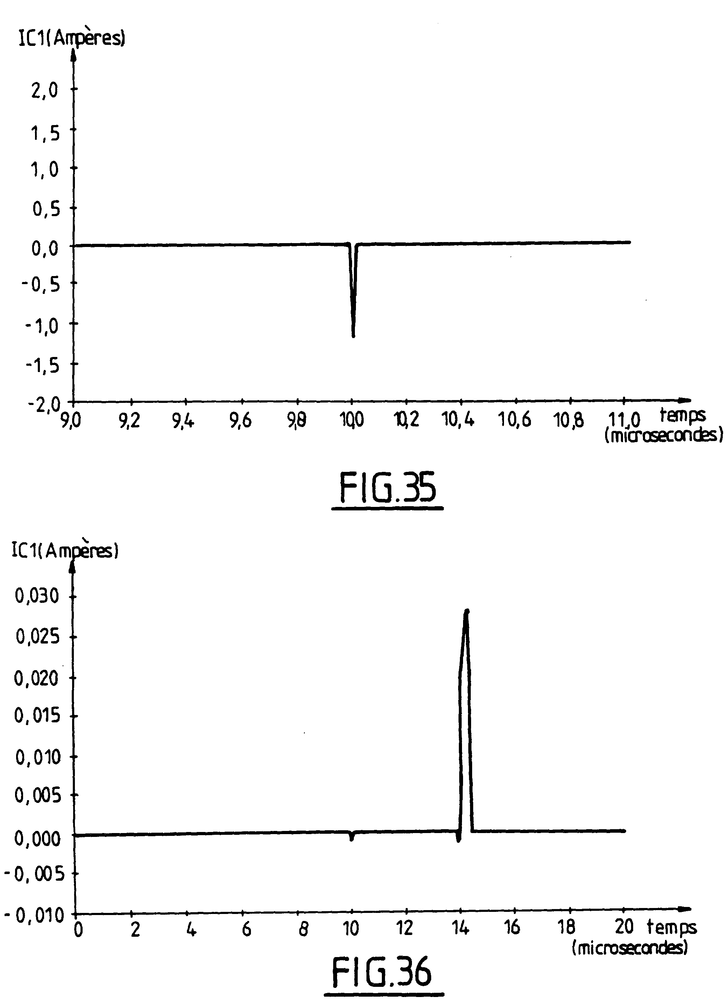

La sonde A1 est ensuite placée en la borne N3 (étape 76) et le condensateur C1 est identifié. La capture de la différence de potentiel DP43 est effectuée dans l'étape 77 et est illustrée sur la figure 33. Cependant, le modèle du condensateur fait apparaître le calcul d'une dérivée. Or, la courbe DP43 de la figure 18 révèle une forte pente aux alentours de 10 $\mu$s. Les moyens de traitement estiment alors que le pas d'échantillonnage choisi dans cette capture est insuffisant pour obtenir la précision requise dans le traitement. Aussi, une directive est donnée à l'utilisateur dans l'étape 72 de dilater la capture autour de 10 $\mu$s. L'utilisateur laisse donc la sonde A1 en la borne N3 (étape 79) et effectue à nouveau la capture de la différence de potentiel DP43 avec un pas d'échantillonnage réduit (étape 80, figure 34). Les moyens de traitement peuvent alors déterminer le courant traversant le condensateur C1 (étape 81, figures 35 et 36) à l'aide du modèle MODC1.

L'ensemble des mesures relatives à la deuxième borne commune N4 étant effectué, l'utilisateur demande l'affichage du diagnostic dans l'étape 82. Celui-ci est effectué par les moyens de traitement (étape 83) et est illustré plus en détail sur l'annexe 2.

Sur cette annexe on rappelle ((I) et (II)) les expressions de courant des transistors Q2 et Q1 qui seraient obtenues en utilisant le modèle de rang 2 et qui ont été mémorisées à toutes fins utiles dans le dispositif. Le diagnostic en la borne commune N4 (III) se traduit par la somme algébrique nulle (III.1) des courants aboutissant ou sortant en cette borne.

En fait, le modèle de bon fonctionnement utilisé pour le transistor est ici le modèle de rang 1, ce qui se traduit par l'expression (III.2). On notera ici que, dans cette expression, le courant de base du transistor Q1 est négatif ou nul car le sens de ce courant est alors vu de la borne N4 et non du transistor Q1. L'expression (III.1) se réduit alors à l'inégalité (III.3).

Les moyens de traitement déterminent alors une succession de valeurs pour le courant de base IbQ1 (III.4). Il en ressort (III.5) que le courant de base du transistor Q1 est strictement positif entre 10 $\mu$s et 10,02 $\mu$s. Il y a donc conflit entre les composants Q1, R2 et C1, ce qu'affiche le dispositif dans l'étape 84.

Dans le cas de l'utilisation d'un modèle de rang 2 pour le transistor Q1, il serait nécessaire de déterminer le courant de collecteur IcQ1 de ce transistor par la formule :

$$IcQ1 = IR1 + 1R4$$

puis le courant de base IbQ1 en utilisant le gain en courant à l'aide de la formule :

$$IbQ1 = IcQl/\beta$$

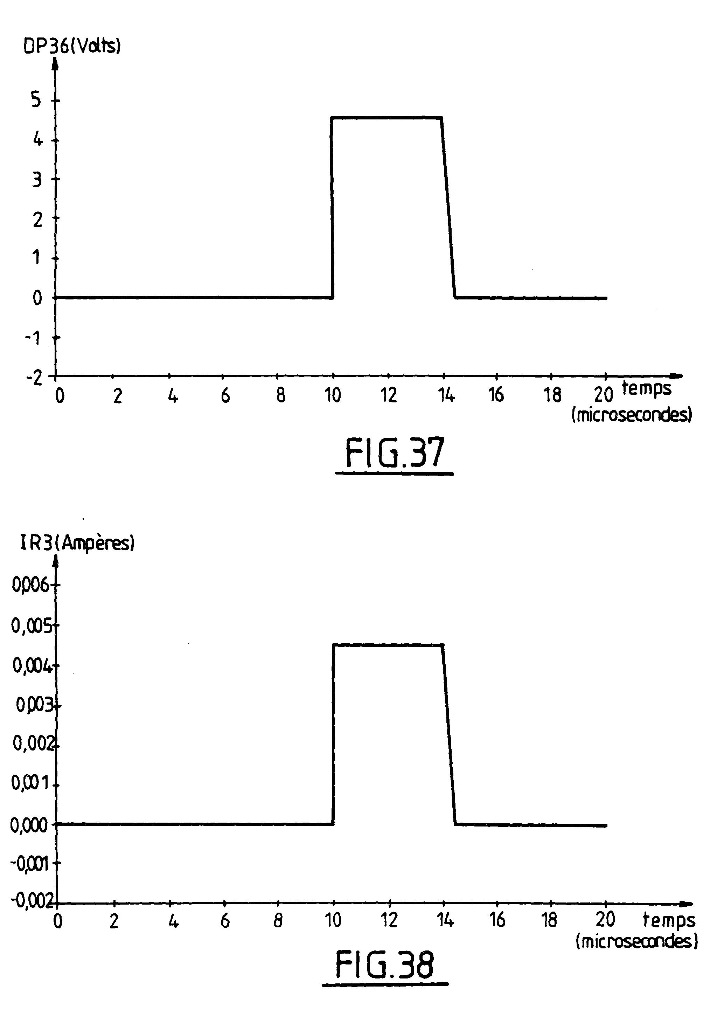

L'utilisateur poursuit sa recherche de panne en choisissant comme troisième borne commune la borne N3 qui est l'une des bornes voisines de la deuxième borne commune N4. Il explore dans les étapes 85 à 96 l'ensemble des bornes voisines de cette troisième borne commune. Les différentes différences de potentiel DP3j et les expressions de courant correspondantes sont illustrées sur les figures 37 à 43. L'expression de courant relative à la diode D2 est représentée sur l'annexe 2 par les relations (IV).

L'utilisateur demande ensuite l'affichage du diagnostic relatif à cette borne commune N3 dans l'étape 97. Dans ce diagnostic (étape 98 et relations (V), annexe 2), le test de la condition sur la nullité présumée du courant total en la borne N3 se traduit par la somme algébrique nulle des courants aboutissant et sortant en cette borne. Cependant, ceci se réduit à l'expression (V.3) puisque le courant de collecteur du transistor Q2 doit être négatif vu de la borne N3. De l'ensemble des relations (V.4) sur l'intervalle temporel 0; 20 $\mu$s, il ressort (V.5) que le courant de collecteur du transistor Q2 est strictement positif entre 14 $\mu$s et 14,3 $\mu$s. Il y a donc conflit entre les composants Q2, R3, C1 et D2, ce qui est affiché sur l'écran dans l'étape 99. Les moyens de traitement en déduisent donc, en intersectant les deux conflits 84 et 99, que le candidat défaillant est le condensateur C1, ce qui est affiché dans l'étape 100.

Le dispositif a permis ici de localiser d'une façon souple et rapide la panne et ce, sans que l'utilisateur ait connaissance des fonctionnalités du circuit.

Les avantages du dispositif selon l'invention sont les suivants, outre ceux déjà évoqués :

- le diagnostic du circuit n'est pas limité aux pannes continûment observables et permet la mise en évidence de pannes apparaissant par exemple lors de régimes transitoires, par l'utilisation d'un diagnostic sur un intervalle temporel de durée modulable,

- le comportement nominal du réseau de composants n'a pas à être décrit ni même sa fonctionnalité ni même le symptôme de panne,

- il n'est pas nécessaire de prévoir une description préalable des pannes probables du réseau,

- le recours à une modélisation numérique améliore la finesse des pannes détectables et élimine l'hypothèse qu'une panne doit entraîner une variation significative du comportement du réseau,

- les pannes provenant d'un changement de structure tel qu'un court-circuit et les fautes de fabrication telles qu'une erreur de composant, sont traitées comme les autres pannes,

- le dispositif permet bien évidemment le traitement des pannes multiples,

- les modèles de composants ainsi que les expressions lois générales peuvent porter sur des grandeurs non-mesurables qui pourront être estimées.

Généralement, dans un circuit électronique, seules les mesures de différences de potentiel sont accessibles. Cette contrainte a, jusqu'à ce jour, accentué les difficultés d'analyse des phénomènes observés et de synthèse des hypothèses de raisonnement, qui permettent, soit de localiser la panne, soit de poursuivre la recherche à cette fin. Or, il a été observé de façon surprenante que la seule mesure de différence de potentiel a contribué, avec des aménagements convenables, à apporter une solution au problème posé.

Enfin, bien qu'avantageusement utilisé dans le domaine de l'électronique, le dispositif selon l'invention ici décrit peut être utilisé dans d'autres domaines.

L'invention n'est pas limitée aux modes de réalisation ci-dessus décrits mais en embrasse toutes les variantes définies dans le cadre des revendications ci-après.

Ainsi ont été estimées ici des valeurs de courants. On pourrait également estimer des expressions de courant telles qu'un gain en courant par exemple, ou bien d'autres grandeurs physiques à partir d'autres modèles et expressions-lois appropriés.

Bien entendu, certains des moyens décrits ci-dessus peuvent être omis dans les variantes où ils ne servent pas.

Annexe 1

| | |
|---|---|
| Résistance R1 : | 1 kiloohm |
| Résistance R2 : | 10 kiloohms |
| Résistance R3 : | 1 kiloohm |
| Résistance R4 : | 10 kiloohms |
| Résistance R5 : | 10 kiloohms |
| Condensateur C1 : | 2 nanofarads |
| Diode D1 : | Référence 1N4148 Société Texas Instruments |
| Transistor Q1 : | Référence 2N2222A Société Texas Instruments |
| Transistor Q2 : | Référence 2N2222A Société Texas Instruments |

Annexe 2

$\mu$s : microseconde        $\mu$A : microampère        A : ampère

(I) Expression de courant de 02

| | |
|---|---|
| Ib = 0 | de 0 à 10 $\mu$s |
| 10 < $\beta$ < 300 | de 10 $\mu$s à 14 $\mu$s |
| Ib = 0 | de 14 $\mu$s à 20 $\mu$s |

(II) Expression de courant de Q1

| 0 < β < 10 | de 0 à 20 µs |
|---|---|

(III) Diagnostic en N4

| | | |
|---|---|---|
| (III.1) : | IbQ1 + IR2 +IC1 =0 | |
| (III.2) : | IbQ1 ≤ 0 | |
| (III.3) : | -IR2 - IC1 ≤ 0 | |
| (III.4) : | | |
| | IbQ1 = -(434.45 µA + 0) | de 0 à 10 µs |
| | IbQ1 = -(434.43 µA - 1,2A) | de 10 µs à 10,02 µs |
| | IbQ1 = -(434,43 µA + 0) | de 10,02 µs à (14 - ε) µs |
| | IbQ1 = -(434,30 µA) + 15 000 µA) | à (14 + ε) µs |
| | IbQ1 = -(434,24 µA + 27 000 µA) | à 14,03 µs |
| | IbQ1 = -(434,43 µA + 0) | de 16 µs à 20 µs |
| (III.5) : | IbQ1 > 0 | entre 10 µs et 10,02 µs |

Annexe 3

µs : microseconde          mA : milliampère

(IV) Expression de courant de D2

| | |
|---|---|
| ID2 : 0 | de 0 à 10 µs |
| ID2 > 0 | de 10 à 14 µs |
| ID2 : 0 | de 14 à 20 µs |

(V) Diagnostic en N3

```
(V.1)  :  IcQ2 + IR3 + IC1 + ID2 = 0

(V.2)  :  IcQ2 < 0

(V.3)  :  - IR3 - IC1 - ID1 ≤ 0

(V.4)  :  IcQ2 = -(0+0+0)                    de 0 µs à (10-ϵ)µs

          IcQ2 = -(4,5 mA + 0 + ID2)   ⎫
          et ID2 > 0                   ⎬  à 10 µs
          IcQ2 = -(4,5 mA + 1,2 + ID2) ⎫
          et ID2 > 0                   ⎬  à 10,02 µs
          IcQ2 = -(4,5 mA + 0 + ID2)   ⎫
          et ID2 > 0                   ⎬  de 10,03 µs à 14 µs


          IcQ2 = -(0 - 27 mA + 0) à 14,3 µs



          IcQ2 = -(0+0+0)              de 14,5 µs à 20 µs


(V.5)  :  IcQ2 > 0                     entre 14 µs et 14,3 µs
```

**Revendications**

1. Dispositif électronique d'analyse d'un réseau de composants, du type comportant:

   - des moyens d'interface (MIN), comprenant des moyens (CL) pour identifier au moins un composant du réseau, une sonde (A0, A1) pour capter une grandeur physique, relative à l'état de fonctionnement de ce composant, et des moyens coopérant avec la sonde pour délivrer des échantillons numériques de cette grandeur physique captée,

   - une mémoire (MM) comprenant une zone formant mémoire de valeurs (MM1), propre à stocker les échantillons de grandeurs physiques captées, relatifs à différents composants du réseau, et une zone formant mémoire auxiliaire (MM2), propre à stocker une représentation du fonctionnement normal du réseau de composants à tester, sous forme de modèles fonctionnels (MOD), relatifs à au moins une espèce particulière de composants, et

   - des moyens de traitement (MT), reliés à cette mémoire et aux moyens d'interface (MIN), et aptes à effectuer un traitement comportant l'application desdits modèles fonctionnels (MOD) aux échantillons de grandeurs physiques captées,
   caractérisé en ce que:

   - les moyens d'interface (MIN) comprennent des moyens (IT) pour définir des intervalles d'échantillonnage, dans un intervalle de temps choisi, et pour délivrer une série d'échantillons de ladite grandeur physique à l'intérieur de cet intervalle de temps choisi,

   - la mémoire de valeurs (MM1) est agencée pour stocker lesdites séries d'échantillons en tant que données de grandeurs physiques captées, en correspondance dudit intervalle de temps choisi, et en correspondance d'une spécification des noeuds et composants du réseau concernés, et

- la mémoire auxiliaire (MM2) comprend des expressions-composant portant sur des grandeurs physiques relatives à un composant, et des expressions-lois représentant des relations générales entre grandeurs physiques,

- les moyens de traitement (MT) comprennent:

  . des moyens aptes, en partant de données de grandeurs physiques captées, stockées dans la mémoire de valeurs en correspondance d'un intervalle de temps choisi,

    à calculer des estimations de grandeurs physiques relatives à un composant choisi parmi lesdits composants spécifiés du réseau concerné, en appliquant auxdites données une expression-composant stockée dans la mémoire auxiliaire, cette expression-composant correspondant audit composant choisi , et
    à stocker ces estimations de grandeurs physiques dans la mémoire de valeurs, de sorte que la mémoire de valeurs (MM1) contient à la fois des données de grandeurs physiques captées et des grandeurs physiques estimées,

  . des moyens d'aide à la décision, propres à assister un utilisateur dans la sélection d'un composant d'un réseau et dans la capture de grandeurs physiques relatives à ce composant, en correspondance d'une spécification du réseau portant au moins sur ledit composant, ce qui permet de réduire le temps nécessaire à la localisation d'un composant défectueux dans ledit réseau concerné.

2. Dispositif selon la revendication 1, caractérisé en ce que certains au moins des échantillons captés sont stockés en mémoire avec des fourchettes de précision,

   en ce que les modèles fonctionnels (MODR10, MODC10, MODQ10) sont au moins en partie affectés de fourchettes d'incertitude,

   en ce que toute estimation est stockée en mémoire avec sa fourchette d'incertitude estimée, résultant de certaines au moins desdites fourchettes d'incertitude et desdites fourchettes de précision,

   en ce que, en réponse à la situation que la mémoire contient, pour certains au moins des intervalles d'échantillonnage, une première et une deuxième fourchette d'origines différentes pour une même grandeur physique, établies à partir de la contribution d'un ensemble primaire de composants (EPRi), les moyens de traitement (MT) opèrent un rapprochement de ces deux fourchettes pour en déduire une première information sur le fonctionnement des composants de cet ensemble primaire.

3. Dispositif selon la revendication 2, caractérisé en ce que chacune des première et deuxième fourchettes appartient au groupe de fourchettes comprenant les fourchettes de précision, et les fourchettes d'incertitude estimées.

4. Dispositif selon la revendication 3, caractérisé en ce que certains au moins des modèles de composants (MODQ10) comportent au moins une fourchette de référence portant sur des grandeurs physiques particulières relatives à ces composants,

   et en ce que ledit groupe de fourchettes comporte en outre la(les) fourchette(s) de référence.

5. Dispositif selon l'une des revendications précédentes, caractérisé en ce que les moyens de définition des intervalles d'échantillonnage sont commandables par les moyens de traitement (MT).

6. Dispositif selon l'une des revendications précédentes, caractérisé en ce que les expressions-composants contenues dans la mémoire auxiliaire (MM2) portent sur un fonctionnement correct des composants.

7. Dispositif selon l'une des revendications 2 à 6, caractérisé en ce que, en réponse à la situation que lesdites première et deuxième fourchettes (FDi) sont disjointes sur au moins une fraction significative de l'intervalle de temps, les moyens de traitement (MT) établissent ladite première information comme représentative d'un fonctionnement incorrect d'au moins un composant dudit ensemble primaire de composants.

8. Dispositif selon la revendication 7, caractérisé en ce que, en réponse à la situation qu'un ensemble primaire de composants a conduit à l'obtention de deux fourchettes disjointes et satisfaisant une condition prédéterminée, les moyens de traitement (MT) commandent une capture sélective (14) de grandeurs physiques relatives à certains composants de cet ensemble primaire.

9. Dispositif selon l'une des revendications 7 et 8, caractérisé en ce que, en réponse à la situation que deux ensembles primaires différents ont conduit à l'obtention de deux fourchettes disjointes, les moyens de traitement (MT) sont aptes à suspecter de fonctionnement incorrect (CD) le composant appartenant à l'intersection des deux ensembles primaires.

10. Dispositif selon la revendication 9, caractérisé en ce que les moyens de traitement (MT) réitèrent le traitement au moins jusqu'à l'obtention de deux ensembles primaires dont l'intersection comporte un seul composant (CD).

11. Dispositif selon l'une des revendications 7 à 10, caractérisé en ce que ladite fraction significative de l'intervalle de temps comporte un nombre prédéterminé d'intervalles d'échantillonnage successifs.

12. Dispositif selon la revendication 11, caractérisé en ce que ledit nombre prédéterminé est supérieur ou égal à deux.

13. Dispositif selon l'une des revendications 2 à 6, caractérisé en ce que, en réponse à la situation que lesdites première et deuxième fourchettes présentent une fourchette d'intersection non vide, les moyens de traitement (MT) affectent en priorité cette fourchette d'intersection non vide à ladite grandeur physique.

14. Dispositif selon l'une des revendications précédentes, caractérisé en ce que les moyens de traitement (MT) sont aptes à estimer à partir d'au moins une donnée de la mémoire de valeurs (MM1), pour certains au moins des composants, au moins une grandeur physique appartenant au groupe comportant :

   * les grandeurs physiques d'un type différent de celles déjà captées respectivement pour ces composants,

   * les grandeurs physiques déjà captées respectivement pour ces composants.

15. Dispositif selon l'une des revendications précédentes, caractérisé en ce que, pour estimer une grandeur physique à partir d'une formulation faisant intervenir plusieurs grandeurs physiques différentes, les moyens de traitement (MT) établissent une formulation où chacune desdites grandeurs physiques différentes n'apparaît qu'une seule fois.

16. Dispositif selon l'une des revendications précédentes, caractérisé en ce qu'il comprend en outre une mémoire propre à mémoriser la configuration du réseau.

17. Dispositif selon la revendication 16, caractérisé en ce que les moyens de traitement (MT) comprennent un automate de décisions (1), relié à la structure du réseau, et comportant un premier mécanisme (11) portant sur la détermination du choix et de l'ordre des composants relativement auxquels seront effectuées les captures des différentes grandeurs physiques, ainsi qu'un deuxième mécanisme (13) portant sur les estimations de grandeurs physiques.

18. Dispositif selon la revendication 17, caractérisé en ce que, pour une maille considérée du réseau de composants, et un composant considéré appartenant à cette maille ou directement connecté à un composant de ladite maille, le deuxième mécanisme (13) des moyens de traitement (MT) effectue:

   * si le composant considéré a donné lieu à une capture de grandeurs physiques d'un type choisi, la mise en oeuvre d'une estimation d'au moins une grandeur physique d'un type différent dudit type choisi, tirée d'un modèle fonctionnel dudit composant et des échantillons de ladite grandeur physique captée,

   * si le composant considéré n'a pas donné lieu à une capture de grandeur physique d'un type choisi, la mise en oeuvre d'une estimation d'au moins une grandeur physique, de même type que le type choisi ou d'un type différent, obtenue à partir de valeurs déjà stockées dans la mémoire de valeurs et associées à au moins un autre composant de ladite maille.

19. Dispositif selon la revendication 12 prise en combinaison avec l'une des revendications 17 et 18, caractérisé en ce que le deuxième mécanisme (13) est susceptible d'utiliser ladite fourchette d'intersection pour d'autres estimations de grandeurs physiques.

20. Dispositif selon l'une des revendications 17 à 19, caractérisé en ce que le premier mécanisme (11) comporte un premier critère de décision portant sur la sélection d'une maille du réseau de composants (MSE) au sein de laquelle sera effectuée au moins une capture de grandeurs physiques.

21. Dispositif selon la revendication 20, caractérisé en ce que le premier mécanisme (11) comporte un premier sous-critère (110) du premier critère , lequel premier sous-critère porte sur le nombre de grandeurs physiques déjà connu au sein de chaque maille.

22. Dispositif selon la revendication 21, caractérisé en ce que, en réponse à une situation d'ambiguïté de sélection de mailles (112) selon le premier sous-critère (110), le premier mécanisme comporte un deuxième sous-critère (113) du premier critère, lequel deuxième sous-critère porte sur le nombre de composants de ces mailles (112).

23. Dispositif selon la revendication 22, caractérisé en ce que le deuxième sous-critère (113) comprend une priorité de sélection des mailles en fonction de leur nombre de composants pris dans l'ordre : 3, 4, 2.

24. Dispositif selon l'une des revendications 22 et 23, caractérisé en ce que, en réponse à une situation d'ambiguïté de sélection de mailles (115) selon le deuxième sous-critère, le premier mécanisme comporte un troisième sous-critère (116) du premier critère, lequel troisième sous-critère porte sur la nature des composants de ces mailles (115).

25. Dispositif selon l'une des revendications 20 à 24, caractérisé en ce que le premier mécanisme (11) comporte un deuxième critère de décision (119-2) portant sur la nature, telle que mémorisée, des composants de cette maille (MSE) sélectionnée par le premier critère.

26. Dispositif selon l'une des revendications précédentes, caractérisé en ce que les expressions-composant sont des lois de fonctionnement de composants électroniques (CI).

27. Dispositif selon la revendication 26, caractérisé en ce que les grandeurs physiques captées appartiennent au groupe comportant des expressions de courant et des différences de potentiel.

28. Dispositif selon la revendication 27, caractérisé en ce que les grandeurs physiques estimées appartiennent au groupe comportant des expressions de courant et des différences de potentiel.

29. Dispositif selon la revendication 24, prise en combinaison avec l'une des revendications 26 et 27, caractérisé en ce que la maille sélectionnée selon le troisième sous-critère (116) est celle mémorisée comme présentant le plus grand nombre de composants passifs.

30. Dispositif selon la revendication 25, prise en combinaison avec l'une des revendications 26 et 27, caractérisé en ce qu'en réponse au deuxième critère (119-2), le premier mécanisme (11) élabore une capture (142) d'une différence de potentiel préférentiellement aux bornes d'un composant passif.

31. Dispositif selon la revendication 30, caractérisé en ce que le premier mécanisme (11), en présence d'une ambiguïté sur les composants passifs, élabore une capture (142) d'une différence de potentiel préférentiellement aux bornes d'un dipôle passif.

32. Dispositif selon la revendication 7, prise en combinaison avec l'une des revendications 26 et 27, caractérisé en ce que les moyens de traitement (MT) élaborent la capture (142) d'une différence de potentiel en visant les bornes des composants de l'ensemble primaire pour lesquelles cette capture n'a pas déjà été effectuée, sauf si cet ensemble primaire (140) ne comporte que des composants connectés à une même borne commune.

33. Dispositif selon l'une des revendications 26 à 32, caractérisé en ce que les moyens de traitement (MT) opèrent une assistance selon un automate capable :

   * de répondre, pour certains au moins des composants du réseau, à la capture d'une différence de potentiel entre une première et une deuxième borne de l'un de ces composants, en estimant la différence de potentiel entre les deuxième et première bornes, ainsi que les courants en chacune de ces deux bornes,

   * de répondre au fait qu'un composant possède une borne connectée à un noeud du réseau auquel sont également connectées les bornes respectives d'autres composants pour lesquelles les courants respectifs en ces bornes sont connus, en estimant le courant en la borne dudit composant,

\*   de répondre au fait qu'un composant appartient à une maille dans laquelle les différences de potentiel aux bornes des autres composants de cette maille sont connues, en estimant la différence de potentiel aux bornes de ce composant.

34. Dispositif selon l'une des revendications 26 à 33, caractérisé en ce que les expressions-lois prennent en compte au moins une règle prise parmi :

\*   la nullité du courant total en un noeud du circuit, et

\*   la nullité de la somme des différences de potentiels le long d'une maille.

35. Dispositif selon l'une des revendications 26 à 34, caractérisé en ce que l'une des grandeurs physiques sur laquelle est susceptible de s'effectuer le rapprochement des deux fourchettes appartient au groupe comportant les courants d'émetteur, de base et de collecteur d'un transistor et les différences de potentiel entre deux de ses trois bornes.

36. Dispositif selon l'une des revendications 26 à 34, caractérisé en ce que l'une des grandeurs physiques sur laquelle est susceptible de s'effectuer le rapprochement des deux fourchettes est le courant traversant une jonction semi-conductrice, en particulier une diode.

37. Dispositif selon l'une des revendications 26 à 34, caractérisé en ce que l'une des grandeurs physiques sur laquelle est susceptible de s'effectuer le rapprochement des deux fourchettes est la différence de potentiel aux bornes d'un composant passif, en particulier une résistance.

38. Dispositif selon l'une des revendications 1 à 5 prise en combinaison avec la revendication 26, caractérisé en ce que la sonde (A0, A1) est propre à capter une différence de potentiel entre deux bornes choisies du circuit, les moyens d'identification (CL) identifiant au moins un composant branché entre lesdites bornes,

en ce que la mémoire de valeurs (MM1) est propre à stocker plusieurs différences de potentiel correspondant au même intervalle de temps, prises entre une première borne commune et différentes bornes voisines de celle-ci,

et en ce que les moyens de traitement (MT) sont capables:

-   pour chaque différence de potentiel, d'effectuer l'estimation d'une expression de courant tirée du modèle fonctionnel du composant concerné, sur ledit intervalle de temps, et
-   de tester, sur l'ensemble des expressions de courant, en chaque instant dudit intervalle de temps, une condition prenant en compte la nullité présumée du courant total en ladite première borne commune,

ce test donnant une première indication, à au moins deux états, sur le fonctionnement des composants branchés à ladite première borne commune.

39. Dispositif selon la revendication 38, caractérisé en ce que certaines au moins des expressions de courant sont des valeurs de courant,

et en ce que les moyens de traitement (MT) effectuent le test de l'ensemble des expressions de courant sous la forme du calcul de la somme algébrique de ces valeurs de courant.

40. Dispositif selon l'une des revendications 38 et 39, caractérisé en ce que les moyens de traitement (MT) sont aptes à délivrer ladite première indication dudit test en un premier état, ce premier état représentant les faits qu'au moins un composant branché à ladite première borne commune possède un fonctionnement incorrect, et que l'ensemble de ces composants possède globalement un fonctionnement incorrect.

41. Dispositif selon l'une des revendications 38 et 39, caractérisé en ce que les moyens de traitement (MT) sont aptes à délivrer ladite première indication dudit test en un second état, ce second état représentant les faits que plusieurs des composants branchés à ladite première borne commune ont un fonctionnement individuel respectif incorrect, et que l'ensemble des composants branchés à cette borne commune possède globalement un fonctionnement correct.

**42.** Dispositif selon l'une des revendications 38 à 41, caractérisé en ce que la mémoire auxiliaire (MM2) contient des modèles fonctionnels représentatifs d'un fonctionnement correct pour certains au moins des composants branchés à ladite première borne commune.

**43.** Dispositif selon l'une des revendications 38 à 42, caractérisé en ce que la mémoire auxiliaire (MM2) contient en outre des modèles fonctionnels représentatifs d'un fonctionnement incorrect pour certains au moins des composants branchés à ladite première borne commune.

**44.** Dispositif selon les revendications 41 et 42 prises en combinaison, caractérisé en ce que chaque expression de courant, relative à chaque composant branché à la première borne commune, est tirée d'un modèle fonctionnel représentatif d'un fonctionnement correct,

et en ce que les moyens de traitement (MT) ne délivrent le second état de la première indication que si la condition prenant en compte la nullité présumée du courant total en ladite première borne commune est satisfaite.

**45.** Dispositif selon les revendications 40, 42 et 43 prises en combinaison, caractérisé en ce qu'une seule expression de courant est tirée d'un modèle fonctionnel représentatif d'un fonctionnement incorrect du composant correspondant branché à ladite borne commune, tandis que les autres expressions de courant relatives aux autres composants sont tirées respectivement de modèles fonctionnels représentatifs de fonctionnements corrects,

et en ce que les moyens de traitement (MT) ne délivrent le premier état de la première indication que si la nullité présumée du courant total en ladite première borne commune est satisfaite.

**46.** Dispositif selon les revendications 40 et 42 prises en combinaison, caractérisé en ce que chaque expression de courant relative à chaque composant branché à ladite première borne commune est tirée d'un modèle fonctionnel représentatif de fonctionnements corrects,

et en ce que les moyens de traitement (MT) délivrent le premier état de la première indication si la condition prenant en compte la nullité présumée du courant total n'est pas satisfaite.

**47.** Dispositif selon la revendication 46, caractérisé en ce que les moyens de traitement (MT) sont aptes à tester une deuxième condition prenant en compte la nullité présumée du courant total en une deuxième borne commune choisie parmi les bornes voisines de la première borne commune, ce test donnant une deuxième indication sur le fonctionnement des composants branchés à ladite deuxième borne commune,

et en ce que la combinaison des première et deuxième indications est susceptible de donner une troisième indication sur le fonctionnement d'un composant branché entre les première et deuxième bornes communes.

**48.** Dispositif selon l'une des revendications 38 à 47, caractérisé en ce que la mémoire auxiliaire (MM2) contient des expressions-composants de complexités différentes (MODQ1, MODQ2).

**49.** Dispositif selon l'une des revendications 38 à 48, caractérisé en ce que, pour le test de ladite condition prenant en compte la nullité présumée du courant total en ladite borne commune, les moyens de traitement (MT) effectuent une comparaison d'une valeur algébrique à une valeur de référence.

**50.** Dispositif selon l'une des revendications 38 à 49, caractérisé en ce que la sonde comprend deux sondes distinctes (A0,A1) aptes à être placées respectivement aux deux bornes du circuit.

**51.** Dispositif selon l'une des revendications 38 à 50, caractérisé en ce que les moyens de traitement (MT) sont aptes à mémoriser les caractéristiques de la borne commune utilisée pour ladite capture ainsi que les caractéristiques des composants branchés en celle-ci, ce qui permet de construire de façon incrémentale une représentation du circuit.

**52.** Dispositif selon l'une des revendications précédentes, caractérisé en ce que les moyens d'interface (MIN) comprennent des moyens de dialogue (CL,MAF) avec un utilisateur potentiel.

**53.** Dispositif selon la revendication 52, caractérisé en ce que les moyens de traitement (MT) sont aptes à élaborer des directives d'utilisation et à les communiquer aux moyens de dialogue.

54. Dispositif selon l'une des revendications 52 et 53, caractérisé en ce que la mémoire auxiliaire (MM2) est apte à recevoir des modèles fonctionnels particuliers susceptibles d'être communiqués aux moyens de traitement par les moyens de dialogue.

55. Dispositif selon l'une des revendications précédentes, caractérisé en ce qu'il comprend un organe de capture distinct (OSC) incorporant la sonde, et susceptible d'être relié aux moyens de traitement par une liaison numérique (LI).

**Patentansprüche**

1. Elektronische Analysevorrichtung für ein Netzwerk aus Bauelementen von dem Typ, der folgendes aufweist:

   - Schnittstellenmittel (MIN) mit Mitteln (CL) zur Identifizierung wenigstens eines Bauelements des Netzwerks, eine Sonde (A0, A1) zum Erfassen einer physikalischen Größe bezüglich des Funktionszustands dieses Bauelements sowie Mittel, die mit der Sonde zusammenwirken, um numerische Abtastwerte dieser erfaßten physikalischen Größe abzugeben,

   - einen Speicher (MM) mit einer Zone, die einen Wertespeicher (MM1) bildet, der zum Speichern der Abtastwerte von erfaßten physikalischen Größen bezüglich verschiedener Bauelemente des Netzwerks geeignet ist, sowie einer Zone, die einen Hilfsspeicher (MM2) bildet, der zum Speichern einer Darstellung der normalen Funktion des zu testenden Netzwerks aus Bauelementen in Form von Funktionsmodellen (MOD) bezüglich wenigstens einer speziellen Art von Bauelementen geeignet ist, sowie

   - Verarbeitungsmittel (MT), die mit diesem Speicher und den Schnittstellenmitteln (MIN) verbunden und dazu geeignet sind, eine Verarbeitung durchzuführen, die die Anwendung der Funktionsmodelle (MOD) auf die Abtastwerte erfaßter physikalischer Größen umfaßt,
   dadurch gekennzeichnet, daß:

   - die Schnittstellenmittel (MIN) Mittel (IT) zur Definition von Abtastintervallen in einem gewählten Zeitintervall sowie zur Abgabe einer Reihe von Abtastwerten der physikalischen Größe innerhalb dieses gewählten Zeitintervalls aufweisen,

   - der Wertespeicher (MM1) derart angeordnet ist, daß er die Reihen von Abtastwerten als Daten von erfaßten physikalischen Größen speichert, und zwar in Entsprechung zu dem gewählten Zeitintervall sowie in Entsprechung zu einer Spezifikation der betreffenden Knoten und Bauelemente des Netzwerks, und

   - der Hilfsspeicher (MM2) Bauelementausdrücke, die physikalische Größen bezüglich eines Bauelements betreffen, sowie Gesetzesausdrücke aufweist, die allgemeine Beziehungen zwischen physikalischen Größen darstellen,

   - die Verarbeitungsmittel (MT) folgendes aufweisen:

   · Mittel, die ausgehend von Daten von erfaßten physikalischen Größen, die in dem Wertespeicher in Entsprechung zu einem gewählten Zeitintervall gespeichert sind, dazu geeignet sind,

      Schätzungen von physikalischen Größen bezüglich eines aus den spezifizierten Bauelementen des betreffenden Netzwerks gewählten Bauelements zu berechnen, indem auf die Daten ein in dem Hilfsspeicher gespeicherter Bauelementausdruck angewendet wird, wobei dieser Bauelementausdruck dem gewählten Bauelement entspricht, und
      diese Schätzungen von physikalischen Größen in dem Wertespeicher derart zu speichern, daß der Wertespeicher (MM1) sowohl Daten von erfaßten physikalischen Größen als auch geschätzte physikalische Größen enthält,

   · Mittel zur Entscheidungshilfe, die einen Benutzer bei der Auswahl eines Bauelements eines Netzwerks sowie beim Erfassen von physikalischen Größen bezüglich dieses Bauelements in Entsprechung zu einer Spezifikation des Netzwerks unterstützt, die wenigstens das Bauelement betrifft, womit es möglich wird, die zur Eingrenzung eines fehlerhaften Bauelements in dem betreffenden Netzwerk erforderliche Zeit zu verringern.

2. Vorrichtung nach Anspruch 1, dadurch gekennzeichnet, daß wenigstens bestimmte erfaßte Abtastwerte mit Genauigkeitsbereichen im Speicher gespeichert sind,

daß die Funktionsmodelle (MODR10, MODC10, MODQ10) wenigstens teilweise durch Unbestimmtheitsbereiche beeinflußt sind,

daß jede Schätzung mit ihrem geschätzten Unbestimmtheitsbereich gespeichert wird, der sich wenigstens aus bestimmten Unbestimmtheitsbereichen und Genauigkeitsbereichen ergibt,

daß die Verarbeitungsmittel (MT) in Reaktion auf die Situation, daß der Speicher wenigstens für bestimmte Abtastintervalle einen ersten und einen zweiten Bereich unterschiedlicher Herkunft für ein und dieselbe physikalische Größe enthält, die ausgehend von dem Beitrag einer Primärmenge von Bauelementen (EPRi) erstellt wurden, eine Annäherung dieser beiden Bereiche durchführen, um daraus eine erste Information über die Funktion der Bauelemente dieser Primärmenge abzuleiten.

3. Vorrichtung nach Anspruch 2, dadurch gekennzeichnet, daß sowohl der erste als auch der zweite Bereich zur Gruppe von Bereichen gehören, die die Genauigkeitsbereiche und die geschätzten Unbestimmtheitsbereiche umfaßt.

4. Vorrichtung nach Anspruch 3, dadurch gekennzeichnet, daß wenigstens bestimmte Modelle von Bauelementen (MODQ10) wenigstens einen Bezugsbereich aufweisen, der spezielle physikalische Größen bezüglich dieser Bauelemente betrifft,

und daß die Gruppe von Bereichen ferner den(die) Bezugsbereich(e) umfaßt.

5. Vorrichtung nach einem der vorhergehenden Ansprüche, dadurch gekennzeichnet, daß die Mittel zur Definition der Abtastintervalle durch die Verarbeitungsmittel (MT) steuerbar sind.

6. Vorrichtung nach einem der vorhergehenden Ansprüche, dadurch gekennzeichnet, daß die in dem Hilfsspeicher (MM2) enthaltenen Bauelementausdrücke die korrekte Funktion der Bauelemente betreffen.

7. Vorrichtung nach einem der Ansprüche 2 bis 6, dadurch gekennzeichnet, daß die Verarbeitungsmittel (MT) in Reaktion auf die Situation, daß der erste und der zweite Bereich (FDi) wenigstens über einen signifikanten Bruchteil des Zeitintervalls getrennt sind, die erste Information als Darstellung einer inkorrekten Funktion wenigstens eines Bauelements aus der Primärmenge von Bauelementen erstellen.

8. Vorrichtung nach Anspruch 7, dadurch gekennzeichnet, daß die Verarbeitungsmittel (MT) in Reaktion auf die Situation, daß eine Primärmenge von Bauelementen zum Erhalt zweier getrennter Bereiche geführt hat, die einer vorbestimmten Bedingung genügen, eine selektive Erfassung (14) von physikalischen Größen bezüglich bestimmter Bauelemente dieser Primärmenge steuern.

9. Vorrichtung nach einem der Ansprüche 7 und 8, dadurch gekennzeichnet, daß die Verarbeitungsmittel (MT) in Reaktion auf die Situation, daß zwei verschiedene Primärmengen zum Erhalt zweier getrennter Bereiche geführt haben, in dazu geeignet sind, das Bauelement, das zur Schnittmenge der beiden Primärmengen gehört, einer inkorrekten Funktion (CD) zu verdächtigen.

10. Vorrichtung nach Anspruch 9, dadurch gekennzeichnet, daß die Verarbeitungsmittel (MT) die Verarbeitung wenigstens so lange wiederholen, bis zwei Primärmengen erhalten sind, deren Schnittmenge ein einziges Bauelement (CD) enthält.

11. Vorrichtung nach einem der Ansprüche 7 bis 10, dadurch gekennzeichnet, daß der signifikante Bruchteil des Zeitintervalls eine vorbestimmte Anzahl von aufeinanderfolgenden Abtastintervallen aufweist.

12. Vorrichtung nach Anspruch 11, dadurch gekennzeichnet, daß die vorbestimmte Anzahl größer oder gleich zwei ist.

13. Vorrichtung nach einem der Ansprüche 2 bis 6, dadurch gekennzeichnet, daß die Verarbeitungsmittel (MT) in Reaktion auf die Situation, daß der erste Bereich und der zweite Bereich einen nicht leeren Schnittbereich bilden, diesen nicht leeren Schnittbereich prioritär der physikalischen Größe zuordnen.

14. Vorrichtung nach einem der vorhergehenden Ansprüche, dadurch gekennzeichnet, daß die Verarbeitungsmittel (MT) dazu geeignet sind, wenigstens für bestimmte Bauelemente ausgehend von wenigstens einem Datenwort des Wertespeichers (MM1) eine physikalische Größe zu schätzen, die zu der Gruppe gehört, die folgendes aufweist:

   * physikalische Größen eines unterschiedlichen Typs zu denjenigen, die für diese Bauelemente jeweils bereits erfaßt wurden,

   * physikalische Größen, die für diese Bauelemente jeweils bereits erfaßt wurden.

15. Vorrichtung nach einem der vorhergehenden Ansprüche, dadurch gekennzeichnet, daß die Verarbeitungsmittel (MT) zum Schätzen einer physikalischen Größe ausgehend von einer Formulierung, in die mehrere verschiedene physikalische Größen eingehen, eine Formulierung erstellen, in der jede der verschiedenen physikalischen Größen nur ein einziges Mal erscheint.

16. Vorrichtung nach einem der vorhergehenden Ansprüche, dadurch gekennzeichnet, daß sie ferner einen Speicher aufweist, der zum Speichern der Konfiguration des Netzwerks geeignet ist.

17. Vorrichtung nach Anspruch 16, dadurch gekennzeichnet, daß die Verarbeitungsmittel (MT) einen Entscheidungsautomaten (1) aufweisen, der mit der Struktur des Netzwerks verbunden ist und einen ersten Mechanismus (11), der die Bestimmung der Wahl und der Ordnung der Bauelemente betrifft, bezüglich derer die Erfassungen der verschiedenen physikalischen Größen durchgeführt werden, sowie einen zweiten Mechanismus (13) aufweist, der die Schätzungen von physikalischen Größen betrifft.

18. Vorrichtung nach Anspruch 17, dadurch gekennzeichnet, daß der zweite Mechanismus (13) der Verarbeitungsmittel (MT) für eine betrachtete Masche des Netzwerks aus Bauelementen sowie für ein betrachtetes, zu dieser Masche gehörendes oder direkt mit einem Bauelement der Masche verbundenes Bauelement folgendes bewirkt:

   * wenn das betrachtete Bauelement die Erfassung von physikalischen Größen eines gewählten Typs veranlaßt hat, die Durchführung einer Schätzung wenigstens einer physikalischen Größe eines von dem gewählten Typ verschiedenen Typs, die aus einem Funktionsmodell des Bauelements und den Abtastwerten der erfaßten physikalischen Größe gezogen ist,

   * wenn das betrachtete Bauelement nicht die Erfassung von physikalischen Größen eines gewählten Typs veranlaßt hat, die Durchführung einer Schätzung wenigstens einer physikalischen Größe eines gleichen wie des gewählten Typs oder eines verschiedenen Typs, die ausgehend von Werten erhalten ist, die bereits in dem Wertespeicher gespeichert sind und wenigstens einem anderen Bauelement der Masche zugeordnet sind.

19. Vorrichtung nach Anspruch 12 in Kombination mit einem der Ansprüche 17 und 18, dadurch gekennzeichnet, daß der zweite Mechanismus (13) den Schnittbereich für weitere Schätzungen von physikalischen Größen verwenden kann.

20. Vorrichtung nach einem der Ansprüche 17 bis 19, dadurch gekennzeichnet, daß der erste Mechanimus (11) ein erstes Entscheidungskriterium aufweist, das die Auswahl einer Masche des Netzwerks aus Bauelementen (MSE) betrifft, in deren Mitte wenigstens eine Erfassung von physikalischen Größen durchgeführt wird.

21. Vorrichtung nach Anspruch 20, dadurch gekennzeichnet, daß der erste Mechanismus (11) ein erstes Subkriterium (110) des ersten Kriteriums, das die Anzahl von physikalischen Größen betrifft, die in der Mitte jeder Masche bereits bekannt sind.

22. Vorrichtung nach Anspruch 21, dadurch gekennzeichnet, daß der erste Mechanismus in Reaktion auf eine Ambiguitätssituation bei der Auswahl der Maschen (112) nach dem ersten Subkriterium (110) ein zweites Subkriterium (113) des ersten Kriteriums aufweist, das die Anzahl von Bauelementen dieser Maschen (112) betrifft.

23. Vorrichtung nach Anspruch 22, dadurch gekennzeichnet, daß das zweite Subkriterium (113) eine Priorität der Auswahl der Maschen in Abhängigkeit von der Anzahl ihrer Bauelemente in folgender Ordnung aufweist: 3, 4, 2.

**24.** Vorrichtung nach einem der Ansprüche 22 und 23, dadurch gekennzeichnet, daß der erste Mechanismus in Reaktion auf eine Ambiguitätsituation bei der Auswahl der Maschen (115) nach dem zweiten Subkriterium ein drittes Subkriterium (116) des ersten Kriteriums aufweist, das die Beschaffenheit der Bauelemente dieser Maschen (115) betrifft.

**25.** Vorrichtung nach einem der Ansprüche 20 bis 24, dadurch ge kennzeichnet, daß der erste Mechanismus (11) ein zweites Entscheidungskriterium (119-2) aufweist, das die gespeicherte Beschaffenheit der Bauelemente dieser Masche (MSE) betrifft, die durch das erste Kriterium ausgewählt ist.

**26.** Vorrichtung nach einem der vorhergehenden Ansprüche, dadurch gekennzeichnet, daß die Bauelementausdrücke Funktionsgesetze von elektronischen Bauelementen (CI) sind.

**27.** Vorrichtung nach Anspruch 26, dadurch gekennzeichnet, daß die erfaßten physikalischen Größen zur Gruppe gehören, die Stromausdrücke und Potentialdifferenzen aufweist.

**28.** Vorrichtung nach Anspruch 27, dadurch gekennzeichnet, daß die geschätzten physikalischen Größen zur Gruppe gehören, die Stromausdrücke und Potentialdifferenzen umfaßt.

**29.** Vorrichtung nach Anspruch 24 in Kombination mit einem der Ansprüche 26 und 27, dadurch gekennzeichnet, daß die nach dem dritten Subkriterium (116) ausgewählte Masche diejenige ist, die mit der größten Anzahl von passiven Bauelementen gespeichert ist.

**30.** Vorrichtung nach Anspruch 25 in Kombination mit einem der Ansprüche 26 und 27, dadurch gekennzeichnet, daß der erste Mechanismus (11) in Reaktion auf das zweite Kriterium (199-2) eine Erfassung (142) einer Potentialdifferenz bevorzugt an den Anschlüssen eines passiven Bauelements erarbeitet.

**31.** Vorrichtung nach Anspruch 30, dadurch gekennzeichnet, daß der erste Mechanismus (11) bei Vorliegen einer Ambiguität an den passiven Bauelementen eine Erfassung (142) einer Potentialdifferenz bevorzugt an den Anschlüssen eines passiven Dipols erarbeitet.

**32.** Vorrichtung nach Anspruch 7 in Kombination mit einem der Ansprüche 26 und 27, dadurch gekennzeichnet, daß die Verarbeitungsmittel (MT) die Erfassung (142) einer Potentialdifferenz erarbeiten, wobei auf die Anschlüsse der Bauelemente der Primärmenge abgezielt wird, für die diese Erfassung noch nicht durchgeführt worden ist, außer wenn diese Primärmenge (14) nur Bauelemente aufweist, die mit dem gleichen gemeinsamen Anschluß verbunden sind.

**33.** Vorrichtung nach einem der Ansprüche 26 bis 32, dadurch gekennzeichnet, daß die Verarbeitungsmittel (MT) eine Unterstützung nach einem Automaten durchführen, der in der Lage ist:

* wenigstens für bestimmte Bauelemente des Netzwerks auf die Erfassung einer Potentialdifferenz zwischen einem ersten und einem zweiten Anschluß eines dieser Bauelemente zu antworten, indem die Potentialdifferenz zwischen dem zweiten und dem ersten Anschluß sowie die Ströme an jedem dieser beiden Anschlüsse geschätzt wird,

* auf die Tatsache zu antworten, daß ein Bauelement einen mit einem Knoten des Netzwerks verbundenen Anschluß besitzt, mit dem auch die jeweiligen Anschlüsse anderer Bauelemente verbunden sind, für die die jeweiligen Ströme an diesen Anschlüssen bekannt sind, indem der Strom an dem Anschluß des Bauelements geschätzt wird,

* auf die Tatsache zu antworten, daß ein Bauelement zu einer Masche gehört, in der die Potentialdifferenzen an den Anschlüssen der anderen Bauelemente dieser Masche bekannt sind, indem die Potentialdifferenz an den Anschlüssen dieses Bauelements geschätzt wird.

**34.** Vorrichtung nach einem der Ansprüche 26 bis 33, dadurch gekennzeichnet, daß die Gesetzesausdrücke wenigstens eine aus folgendem genommene Regel berücksichtigen:

* Nullbetrag des Gesamtstroms an einem Knoten der Schaltung, sowie

* Nullbetrag der Summe der Potentialdifferenzen entlang einer Schleife.

35. Vorrichtung nach einem der Ansprüche 26 bis 34, dadurch gekennzeichnet, daß eine der physikalischen Größen, an der die Annäherung der beiden Bereiche durchgeführt werden kann, zu der Gruppe gehört, die die Emitter-, Basis- und Kollektorströme eines Transistors sowie die Potentialdifferenzen zwischen zwei seiner drei Anschlüsse aufweist.

36. Vorrichtung nach einem der Ansprüche 26 bis 34, dadurch gekennzeichnet, daß eine der physikalischen Größen, an der die Annäherung der beiden Bereiche durchgeführt werden kann, der Strom ist, der einen Halbleiterübergang, insbesondere eine Diode durchquert.

37. Vorrichtung nach einem der Ansprüche 26 bis 34, dadurch gekennzeichnet, daß eine der physikalischen Größen, an der die Annäherung der beiden Bereiche durchgeführt werden kann, die Potentialdifferenz an den Anschlüssen eines passiven Bauelements, insbesondere eines Widerstands ist.

38. Vorrichtung nach einem der Ansprüche 1 bis 5 in Kombination mit Anspruch 26, dadurch gekennzeichnet, daß die Sonde (A0, A1) dazu geeignet ist, eine Potentialdifferenz zwischen zwei gewählten Anschlüssen der Schaltung zu erfassen, wobei die Identifizierungsmittel (CL) wenigstens ein zwischen den Anschlüssen angeschlossenes Bauelement identifizieren,

daß der Wertespeicher (MM1) dazu geeignet ist, in Entsprechung zum gleichen Zeitintervall mehrere Potentialdifferenzen zu speichern, die zwischen einem ersten gemeinsamen Anschluß und verschiedenen, diesem benachbarten Anschlüssen abgenommen sind,

und daß die Verarbeitungsmittel (MT) in der Lage sind:

- für jede Potentialdifferenz die Schätzung eines Stromausdrucks, der aus dem Funktionsmodell des betreffenden Bauelements gezogen ist, an dem Zeitintervall durchzuführen, und
- an der Menge von Stromausdrücken zu jedem Zeitpunkt des Zeitintervalls eine Bedingung zu testen, die den angenommenen Nullbetrag des Gesamtstroms an dem ersten gemeinsamen Anschluß berücksichtigt,

wobei dieser Test in wenigstens zwei Zuständen eine erste Angabe zur Funktion der Bauelemente gibt, die an den ersten gemeinsamen Anschluß angeschlossen sind.

39. Vorrichtung nach Anspruch 38, dadurch gekennzeichnet, daß wenigstens bestimmte Stromausdrücke Stromwerte sind, und daß die Verarbeitungsmittel (MT) den Test der Menge der Stromausdrücke in Form der Berechnung der algebraischen Summe dieser Stromwerte durchführen.

40. Vorrichtung nach einem der Ansprüche 38 und 39, dadurch gekennzeichnet, daß die Verarbeitungsmittel (MT) dazu geeignet sind, die erste Angabe des Tests in einem ersten Zustand abzugeben, wobei dieser erste Zustand dafür steht, daß wenigstens ein an den ersten Anschluß angeschlossenes Bauelement eine inkorrekte Funktion besitzt und die Menge dieser Bauelemente insgesamt eine inkorrekte Funktion besitzt.

41. Vorrichtung nach einem der Ansprüche 38 und 39, dadurch gekennzeichnet, daß die Verarbeitungsmittel (MT) dazu geeignet sind, die erste Angabe des Tests in einem zweiten Zustand abzugeben, wobei dieser zweite Zustand dafür steht, daß mehrere an den ersten Anschluß angeschlossene Bauelemente jeweils individuell eine inkorrekte Funktion besitzen und die Menge der an diesen Anschluß angeschlossenen Bauelemente insgesamt eine inkorrekte Funktion besitzt.

42. Vorrichtung nach einem der Ansprüche 38 bis 41, dadurch gekennzeichnet, daß der Hilfsspeicher (MM2) Funktionsmodelle enthält, die für eine korrekte Funktion wenigstens bestimmter Bauelemente stehen, die an den ersten gemeinsamen Anschluß angeschlossen sind.

43. Vorrichtung nach einem der Ansprüche 38 bis 42, dadurch gekennzeichnet, daß der Hilfsspeicher (MM2) ferner Funktionsmodelle enthält, die für eine inkorrekte Funktion wenigstens bestimmter Bauelemente stehen, die an den ersten gemeinsamen Anschluß angeschlossen sind.

44. Vorrichtung nach den Ansprüchen 41 und 42 in Kombination, dadurch gekennzeichnet, daß jeder Stromausdruck bezüglich jedes an den ersten Anschluß angeschlossenen Bauelements aus einem Funktionsmodell gezogen ist, das für eine korrekte Funktion steht,

und daß die Verarbeitungsmittel (MT) den zweiten Zustand der ersten Angabe nur dann abgeben, wenn die Bedingung erfüllt ist, die den vermuteten Nullbetrag des Gesamtstroms an dem ersten gemeinsamen Anschluß berücksichtigt.

45. Vorrichtung nach den Ansprüchen 40, 42 und 43 in Kombination, dadurch gekennzeichnet, daß nur ein einziger Stromausdruck aus einem Funktionsmodell gezogen ist, das für eine inkorrekte Funktion des entsprechenden, an den gemeinsamen Anschluß angeschlossenen Bauelements steht, während die anderen Stromausdrücke bezüglich der anderen Bauelemente jeweils aus Funktionsmodellen gezogen sind, die für korrekte Funktionen stehen,

und daß die Verarbeitungsmittel (MT) den ersten Zustand der ersten Angabe nur dann abgeben, wenn der vermutete Nullbetrag des Gesamtstroms an dem ersten gemeinsamen Anschluß erfüllt ist.

46. Vorrichtung nach den Ansprüchen 40 und 42 in Kombination, dadurch gekennzeichnet, daß jeder Stromausdrück bezüglich jedes an den ersten gemeinsamen Anschluß angeschlossenen Bauelements aus einem Funktionsmodell gezogen ist, das für korrekte Funktionen steht,

und daß die Verarbeitungsmittel (MT) den ersten Zustand der ersten Angabe abgeben, wenn die Bedingung nicht erfüllt ist, die den vermuteten Nullbetrag des Gesamtstroms berücksichtigt.

47. Vorrichtung nach Anspruch 46, dadurch gekennzeichnet, daß die Verarbeitungsmittel (MT) dazu geeignet sind, eine zweite Bedingung zu testen, die den vermuteten Nullbetrag des Gesamtstroms an einem zweiten gemeinsamen Anschluß berücksichtigt, der aus den benachbarten Anschlüssen des ersten gemeinsamen Anschlusses gewählt ist, wobei dieser Test eine zweite Angabe zur Funktion der an den zweiten gemeinsamen Anschluß angeschlossenen Bauelemente gibt,

und daß die Kombination der ersten und der zweiten Angabe eine dritte Angabe zu der Funktion eines Bauelements geben kann, die zwischen den ersten und den zweiten gemeinsamen Anschluß angeschlossen ist.

48. Vorrichtung nach einem der Ansprüche 38 bis 47, dadurch gekennzeichnet, daß der Hilfsspeicher (MM2) Bauelementausdrücke unterschiedlicher Komplexität (MODQ1, MODQ2) enthält.

49. Vorrichtung nach einem der Ansprüche 38 bis 48, dadurch gekennzeichnet, daß die Verarbeitungsmittel (MT) für den Test der Bedingung, die den angenommenen Nullbetrag des Gesamtstroms an dem gemeinsamen Anschluß berücksichtigt, einen Vergleich eines algebraischen Werts mit einem Bezugswert durchführen.

50. Vorrichtung nach einem der Ansprüche 38 bis 49, dadurch gekennzeichnet, daß die Sonde zwei verschiedene Sonden (A0, A1) aufweist, die an die beiden Anschlüsse der Schaltung gesetzt werden können.

51. Vorrichtung nach einem der Ansprüche 38 bis 50, dadurch gekennzeichnet, daß die Vearbeitungsmittel (MT) dazu geeignet sind, die Merkmale des gemeinsamen, für die Erfassung verwendeten Anschlusses sowie die Merkmale der an diesen angeschlossenen Bauelemente zu speichern, womit inkremental der Aufbau einer Darstellung der Schaltung möglich wird.

52. Vorrichtung nach einem der vorhergehenden Ansprüche, dadurch gekennzeichnet, daß die Schnittstellenmittel (MIN) Mittel (CL, MAF) zum Dialog mit einem potentiellen Benutzer aufweisen.

53. Vorrichtung nach Anspruch 52, dadurch gekennzeichnet, daß die Verarbeitungsmittel (MT) dazu geeignet sind, Verwendungsrichtlinien zu erarbeiten und sie den Dialogmitteln mitzuteilen.

54. Vorrichtung nach einem der Ansprüche 52 und 53, dadurch gekennzeichnet, daß der Hilfsspeicher (MM2) dazu geeignet ist, spezielle Funktionsmodelle aufzunehmen, die durch die Dialogmittel den Verarbeitungsmitteln mitgeteilt werden können.

55. Vorrichtung nach einem der vorhergehenden Ansprüche, dadurch gekennzeichnet, daß sie ein getrenntes Erfassungsorgan (OSC) aufweist, das die Sonde umfaßt, und mit den Verarbeitungsmitteln durch eine digitale Verbindung (LI) verbunden werden kann.

**Claims**

1. An electronic device for the analysis of a network of components of the type comprising:

   - interface means (MIN), including means (CL) for identifying at least one component of the network, a probe (A0, A1) for detecting a physical value relating to the functional state of this component, and means cooperating with the probe for delivering digital samples of this detected physical value,

   - a memory (MM) comprising a zone forming a values memory (MM1), capable of storing the samples of the detected physical values relating to various components of the network, and a zone forming an auxiliary memory (MM2) capable of storing a representation of the normal functioning of the network of components to be tested, in the form of functional models (MOD) relating to at least one particular kind of components, and

   - processing means (MT), connected to this memory and to the interface means (MIN) and capable of undertaking a processing, including the application of the said functional models (MOD) to the samples of the detected physical values,
   characterized in that

   - the interface means (MIN) comprise means (IT) for defining sampling intervals within a chosen time interval, and for delivering a series of samples of the said physical value within this chosen time interval,

   - the values memory (MM1) is arranged for storing the said series of samples as data of the detected physical values in accordance with the said chosen time interval, and in accordance with a specification of the nodes and components of the network concerned, and

   - the auxiliary memory (MM2) comprises component expressions concerning the physical values relating to a component, and law expressions representing general relationships between physical values,

   - the processing means (MT) comprise:

      . means capable, starting with the data of the detected physical values stored in the values memory in accordance with a chosen time interval,

         of calculating estimates of the physical values relating to one component chosen from the said specified components of the network concerned, by applying to the said data a component expression stored in the auxiliary memory, this component expression corresponding to the said chosen component, and of storing these estimates of the physical values in the values memory, so that the values memory (MM1) contains the data of the detected physical values and of the estimated physical values at the same time,

      . decision-assisting means capable of assisting a user in the selection of a component and in the detection of the physical values relating to this component in accordance with a specification of the network relating at least to the said component, which makes it possible to reduce the time necessary for locating a defective component in the said network concerned.

2. A device according to claim 1, characterized in that at least some of the picked-up samples are stored in the memory with accuracy brackets.

   in that the functional models (MODR10, MODC10, MODQ10) are at least in part allocated uncertainty brackets,

   in that each estimate is stored in the memory with its estimated uncertainty bracket, deriving from at least some of the said uncertainty brackets and the said accuracy brackets,

   in that in response to the situation that the memory contains, for at least some of the sampling intervals, a first and a second bracket of different origins for the same physical value established from the contribution of a primary set of components (EPRi), the processing means (MT) effect a comparison of these two brackets to deduce therefrom a first information regarding the functioning of the components of this primary set.

3. A device according to claim 2, characterized in that each of the first and second brackets belongs to a group of brackets comprising the accuracy brackets, and the estimated uncertainty brackets.

4. A device according to claim 3, characterized in that at least some of the component models (MODQ10) comprise at least one reference bracket concerning the particular physical values relating to these components,

   and in that the said group of brackets comprises, moreover, the reference bracket or brackets.

5. A device according to one of the preceding claims, characterized in that the means for defining the sampling intervals are controllable by the processing means (MT).

6. A device according to one of the preceding claims, characterized in that the component expressions contained in the auxiliary memory (MM2) relate to a correct functioning of the components.

7. A device according to one of claims 2 to 6, characterized in that, in response to the situation that the said first and second brackets (FDi) are disjoint over at least a significant fraction of the time interval, the processing means (MT) establish the said first information as representing an incorrect functioning of at least one component of the said primary set of components.

8. A device according to claim 7, characterized in that, in response to the situation that a primary set of components has led to obtaining two disjoint brackets, and meeting a predetermined condition, the processing means (MT) order a selective detection (14) of physical values relating to certain components of this primary set.

9. A device according to one of claims 7 and 8, characterized in that, in response to the situation that two different primary sets have led to obtaining two disjoint brackets, the processing means (MT) are capable of suspecting the component (CD) belonging to the intersection of the two primary sets of incorrect operation.

10. A device according to claim 9, characterized in that the processing means (MT) repeat the processing at least until two primary sets are obtained whose intersection comprises a single component (CD).

11. A device according to one of claims 7 to 10, characterized in that the said significant fraction of the time interval comprises a predetermined number of successive sampling intervals.

12. A device according to claim 11, characterized in that the said predetermined number is greater than, or equal to two.

13. A device according to one of claims 2 to 6, characterized in that in response to the situation that the said first and second brackets have an intersection bracket that is not empty, the processing means (MT) allocate this intersection bracket that is not empty to the said physical value on a priority basis.

14. A device according to one of the preceding claims, characterized in that the processing means (MT) are capable of estimating from at least one data item of the values memory (MM1) for at least some of the components, at least one physical value belonging to the group comprising:

   * the physical values of a type different from those already respectively detected for these components,

   * the physical values already respectively detected for these components.

15. A device according to one of the preceding claims, characterized in that for estimating a physical value from a formulation that causes several different physical values to intervene, the processing means (MT) establish a formulation where each one of the said different physical values appears only once.

16. A device according to one of the preceding claims, characterized in that it comprises, moreover, a memory capable of memorizing the configuration of the network.

17. A device according to claim 16, characterized in that the processing means (MT) comprise an automatic deciding device (1) connected to the structure of the network, and comprising a first mechanism (11) relating to the determination of the choice and of the order of the components, in respect of which the detections of different physical values will be undertaken, as well as a second mechanism (13) relating to the estimations of physical values.

18. A device according to claim 17, characterized in that for a considered mesh of the network of components, and a considered component belonging to this mesh or directly connected to a component of the said mesh, the second mechanism (13) of the processing means (MT) undertakes:

* if the component under consideration has given rise to a detection of physical values of a given type, the process of estimating at least one physical value of a type that is different from the type chosen drawn from a functional model of the said component and from samples of the said detected physical value,

* if the component in question has not given rise to a detection of a physical value of a chosen type, the process of estimating at least one physical value of the same type as the type chosen, or of a different type obtained from values already stored in the values memory and associated with at least one other component of the said mesh.

19. A device according to claim 12 taken in conjunction with one of claims 17 and 18, characterized in that the second mechanism (13) is capable of using the said intersection bracket for other estimations of physical values.

20. A device according to one of claims 17 to 19, characterized in that the first mechanism (11) comprises a first decision criterion relating to the selection of a mesh of the network of components (MSE) within which at least one detection of physical values will be undertaken.

21. A device according to claim 20, characterized in that the first mechanism (11) comprises a first subcriterion (110) of the first criterion, which first subcriterion relates to the number of physical values already known within each mesh.

22. A device according to claim 21, characterized in that, in response to a situation of ambiguity in the selection of meshes (112) according to the first subcriterion (110), the first mechanism comprises a second subcriterion (113) of the first criterion, which second subcriterion relates to the number of components of these meshes (112).

23. A device according to claim 22, characterized in that the second subcriterion (113) comprises a priority for the selection of meshes according to their number of components taken in the order of : 3, 4, 2.

24. A device according to one of claims 22 and 23, characterized in that, in response to a situation of ambiguity in the selection of meshes (115) according to the second subcriterion, the first mechanism comprises a third subcriterion (116) of the first criterion, which third subcriterion relates to the nature of the components of these meshes (115).

25. A device according to one of claims 20 to 24, characterized in that the first mechanism (11) comprises a second decision criterion (119-2) relating to the nature, such as memorized, of the components of this mesh (MSE) selected by the first criterion.

26. A device according to one of the preceding claims, characterized in that the component expressions are operating laws of the electronic components (CI).

27. A device according to claim 26, characterized in that the detected physical values belong to the group comprising expressions of currents and differences of potential.

28. A device according to claim 27, characterized in that the estimated physical values belong to the group comprising expressions of currents and of differences of potential.

29. A device according to claim 24, taken in conjunction with one of claims 26 and 27, characterized in that the mesh selected according to the third subcriterion (116) is that memorised as having the greatest number of passive components.

30. A device according to claim 25 taken in conjunction with one of claims 26 and 27, characterized in that in response to the second criterion (119-2), the first mechanism (11) undertakes a detection (142) of a difference of potential, preferentially at the terminals of a passive component.

31. A device according to claim 30, characterized in that the first mechanism (11) undertakes in the presence of an ambiguity regarding the passive components, a detection (142) of a difference of potential, preferentially at the terminals of a passive dipole.

**32.** A device according to claim 7, taken in conjunction with one of claims 26 and 27, characterized in that the processing means (MT) undertake the detection (142) of a difference of potential, focusing on the terminals of the components of the primary set in respect of which the detection has not yet been effected, unless this primary set (140) only comprises components connected to the same common terminal.

**33.** A device according to one of claims 26 to 32, characterized in that the processing means (MT) operate an assistance according to an automatic device capable of :

* responding, for at least some of the components of the network, to the detection of a difference of potential between a first and a second terminal of one of these components, by estimating the difference of potential between the second and first terminals, as well as the currents at each one of these two terminals,

* responding to the fact that a component has a terminal connected to a node of the network to which the respective terminals of other components are also connected for which the respective currents at these terminals are known, by estimating the current at the terminal of the said component,

* responding to the fact that a component belongs to a mesh wherein the differences of potential at the terminals of other components of this mesh are known, by estimating the difference of potential at the terminals of this component.

**34.** A device according to one of claims 26 to 33, characterized in that the law expressions take into account at least one rule taken from:

* the zero value of the total current in a node of the circuit, and

* the zero value of the sum of the differences of potential along one mesh.

**35.** A device according to one of claims 26 to 34, characterized in that one of the physical values in respect of which the comparison of two brackets can be effected belongs to the group comprising the currents of the emitter, of the base and of the collector of a transistor and the differences of potential between two of its three terminals.

**36.** A device according to one of claims 26 to 34, characterized in that one of the physical values in respect of which the comparison of two brackets can be effected, is the current passing through a semiconductor junction, in particular a diode.

**37.** A device according to one of claims 26 to 34, characterized in that one of the physical values in respect of which the comparison of the brackets can be effected, is the difference of potential at the terminal of a passive component, in particular a resistor.

**38.** A device according to one of claims 1 to 5, taken in conjunction with claim 26, characterized in that the probe (A0, A1) is capable of detecting a difference of potential between two chosen terminals of the circuit, the identification means (CL) identifying at least one component disposed between the said terminals,

in that the values memory (MM1) is capable of storing several differences of potential, corresponding to the same time interval, taken between a first common terminal and different terminals adjacent thereto,

and in that the processing means (MT) are capable:

- of undertaking, for each difference of potential, the estimation of a current expression drawn from the functional models of the component concerned over the said time interval, and

- of testing over the set of current expressions at each instant of the said time interval, a condition that takes into account the presumed zero value of the total current at the said first common terminal,

this test giving a first indication in at least two states regarding the functioning of the components connected to the said first common terminal.

**39.** A device according to claim 38, characterized in that at least some of the current expressions are current values,

and in that the processing means (MT) effect the test of the set of the current expressions in the form of a calculation of the algebraic sum of these current values.

40. A device according to one of claims 38 and 39, characterized in that the processing means (MT) are capable of delivering the said first indication of the said test in a first state, this first state representing the facts that at least one component connected to the said first common terminal is functioning incorrectly, and that the set of these components functions incorrectly as a whole.

41. A device according to one of claims 38 and 39, characterized in that the processing means (MT) are capable of delivering the said first indication of the said test in a second state, this second state representing the facts that several of the components connected to the said first common terminal respectively function individually incorrectly, and that the set of the components connected to this common terminal function correctly as a whole.

42. A device according to one of claims 38 to 41, characterized in that the auxiliary memory (MM2) contains functional models representing a correct functioning for at least some of the components connected to the said first common terminal.

43. A device according to one of claims 38 to 42, characterized in that the auxiliary memory (MM2) contains moreover functional models representing an incorrect functioning for at least some of the components connected to the said first common terminal.

44. A device according to claims 41 and 42 taken together, characterized in that each current expression relating to each component connected to the first common terminal is drawn from a functional model representing a correct functioning,

and in that the processing means (MT) only deliver the second state of the first indication if the condition that takes into account the presumed zero value of the total current in the said first common terminal has been met.

45. A device according to claims 40, 42 and 43 taken together, characterized in that a single current expression is drawn from a functional model representing an incorrect functioning of the corresponding component connected to the said common terminal, while the other current expressions relating to the other components are respectively drawn from functional models representing correct functioning,

and in that the processing means (MT) only deliver the first state of the first indication if the presumed zero value of the total current in the said first common terminal has been met.

46. A device according to claims 40 and 42 taken together, characterized in that each current expression relating to each component connected to the said first common terminal is drawn from a functional model representing correct functioning,

and in that the processing means (MT) deliver the first state of the first indication if the condition that takes into account the presumed zero value of the total current has not been met.

47. A device according to claim 46, characterized in that the processing means (MT) are capable of testing a second condition, that takes into account the presumed zero value of the total current in a second common terminal chosen from the terminals adjacent to the first common terminal, this test giving a second indication regarding the functioning of the components connected to the said second common terminal,

and in that the combination of the first and second indications is capable of giving a third indication regarding the functioning of a component disposed between the first and second common terminals.

48. A device according to one of claims 38 to 47, characterized in that the auxiliary memory (MM2) contains component expressions of different complexities (MODQ1, MODQ2).

49. A device according to one of claims 38 to 48, characterized in that for the test of the said condition that takes into account the presumed zero value of the total current in the said common terminal, the processing means (MT) effect a comparison of an algebraic value with a reference value.

50. A device according to one of claims 38 to 49, characterized in that the detector comprises two separate probes (A0, A1) capable of being placed respectively onto the two terminals of the circuit.

51. A device according to one of claims 38 to 50, characterized in that the processing means (MT) are capable of memorizing the characteristics of the common terminal used for the said detection, as well as the characteristics of the components connected thereto, which makes it possible to construct a representation of the circuit in an incremental manner.

52. A device according to one of the preceding claims, characterized in that the interface means (MIN) comprise means (CL, MAF) for dialogue with a potential user.

53. A device according to claim 52, characterized in that the processing means (MT) are capable of elaborating instructions for use and of communicating them to the dialogue means.

54. A device according to one of claims 52 and 53, characterized in that the auxiliary memory (MM2) is capable of receiving particular functional models that can be communicated to the processing means by the dialogue means.

55. A device according to one of the preceding claims, characterized in that it comprises a separate detector element (OSC) incorporating the probe, and capable of being connected to the processing means via a digital line (LI).

FIG.1

FIG.2

<u>FIG.3</u>

$$Rm \leqslant R \leqslant RM$$

$$V(R,a,b) = R . I(R,a)$$

$$I(R,a) \quad = V(R,a,b)/R$$

MODR 10

<u>FIG.4</u>

$$Cm \leqslant C \leqslant CM$$

$$I(C,a) = C . \frac{d}{dt}(V(C,a,b))$$

MODC 10

<u>FIG.6</u>

$$si \ V(D,a,k) \geqslant 0,6 \ Volt \quad alors \ I(D,a) \in [-10^{-4}A, +\infty[$$

MODD10

1) modèle de rang 1:

$$I(T,c) \in [-10^{-4}A, +\infty[$$

$$I(T,e) \in ]-\infty, +10^{-4}A]$$

MODQ 10

2) modèle de rang 2:

si $V(T,b,e) \geqslant 0,6$ Volt et $V(T,c,e) \geqslant 0,3$ Volt

alors $I(T,c) = BETA.I(T,b)$

$$BETA\,m \leqslant BETA \leqslant BETA\,M$$

MODQ 20

FIG.5

$$I(CP1,a) = -I(CP2,a) - I(CP3,a)$$
$$I(CP2,a) = -I(CP1,a) - I(CP3,a)$$
$$I(CP3,a) = -I(CP1,a) - I(CP2,a)$$

$$V(CP4,a,b) = -V(CP4,b,a)$$

$$V(CP5,a,b) = -V(CP6,a,b) - V(CP7,a,b)$$
$$V(CP6,a,b) = -V(CP5,a,b) - V(CP7,a,b)$$
$$V(CP7,a,b) = -V(CP5,a,b) - V(CP6,a,b)$$

FIG.7

**FIG.8**

**FIG.9**

FIG.10

11

| analyse du nombre de grandeurs connues au sein des mailles |— 110

sélection possible d'une maille? — 111 → oui

non

( plusieurs mailles sélectionnables )— 112

| analyse de ces mailles selon leur taille |— 113

sélection possible d'une maille? — 114 → oui

non

( plusieurs mailles sélectionnables )— 115

| analyse de ces mailles selon la nature de leurs composants. |— 116

sélection possible d'une maille? — 117 → oui

non

( plusieurs mailles sélectionnables )— 118

| sélection arbitraire d'une de ces mailles. |— 119-1

( maille sélectionnée )— MSE

| sélection du composant dans la maille |— 119-2

( composant sélectionné )— CPS

( fin )

# FIG.11

FIG.12

FIG.13

EP 0 408 425 B1

FIG.14

choix de la maille : M 1 —MSE

choix du composant : R2 —CPS

capture : V(R2, a, b) —12

estimations:
V(R2, b, a) , I(R2, a), I(R2, b) —13

choix de la maille: M 1 —MSE

choix du composant: C1 —CPS

capture : V(C1, b, a) —12

estimations:
V(C1, a, b) , I(C1, a), I(C1, b )
I(Q1, b) , V(R3, a, b), I(R3, a),
I(R3, b) , I(Q2, c). —13

obtention de deux fourchettes
disjointes pour I(Q2, c)
sur 4 instants d'échantillonnage —FD1

ensemble primaire
de composants:
Q2, R3, R2, C1 —EPR1

## FIG.15

estimation : V(R3, b, a) —13

analyse ensemble pri-
-maire EPR1 —14

A

$$\boxed{A}$$

| choix du composant:R3 | 141 |

| capture:V(R3,b,a) | 142 |

| estimations:<br>V(R3,a,b),I(R3,a),I(R3,b),<br>I(Q2,c) | 13 |

| obtention de deux fourchettes<br>disjointes pour I(Q2,c) sur 2<br>instants d'échantillonnage. | FO2 |

ensemble primaire
de composants:
Q2, C1, R3 — EPR2

| analyse ensemble primaire<br>EPR2 | 14 |

| choix de la maille: M2 | MSE |

| choix du composant: R1 | CPS |

| capture:V(R1,b,a) | 12 |

## FIG.16

| estimations:<br>V(R1,a,b),I(R1,a),I(R1,b)<br>I(Alim+),I(Alim-),V(Q1,b,c),<br>V(Q1,c,b) | 13 |

$$\boxed{B}$$

**FIG.17**

Flowchart:

B

→ choix de la maille : M3 — MSE

→ choix du composant R4 — CPS

→ capture : V(R4, a, b) — 12

→ estimations:
V(R4,b,a), I(R4,a), I(R4,b)
I(Q1,c), I(Q1,e) — 13

→ obtention de deux fourchettes disjointes pour I(Q1,e) sur 2 instants d'échantillonnage. — FD3

→ ensemble primaire de composants:
C1,R2,Q1,R1,R4 — EPR3

→ comparaison de tous les en-sembles primaires — 2

→ composant défectueux C1 — CD

→ FIN: hypothèse panne unique

Début

Choix d'une borne commune BC — 30

Sonde A0 en BC — 31

Sonde A1 en BCVi — 32

réglage capture
Définition IT — 33

Identification
composant — 34

Déclenchement Capture et
Validité Capture — 35

Stockage Exp. Courant — 36

37 modèles

BCVi+1? — 38 — oui

non

Diagnostic — 39

Demande
Affichage
Diagnostic
? — 40 — non

oui

Résultat
satisfaisant? — 41 — non

oui

FIN

42 autre
borne
commune

## FIG.18

```
┌─────────────────────────────┐
│  Stockage      Expressions  │ ⌐36
│     de  courant             │
└─────────────────────────────┘
              │
              ▼
┌─────────────────────────────┐
│  Test      Condition        │
│  Nullité    présumée        │ ⌐391
│  du  courant  total.        │
└─────────────────────────────┘
              │
              ▼
┌─────────────────────────────┐
│  gestion  des               │
│  conflits    et             │ ⌐392
│    des  alibis              │
└─────────────────────────────┘
              │
              ▼
┌─────────────────────────────┐
│  Détermination              │ ⌐393
│    des  candidats           │
└─────────────────────────────┘
```

## FIG.19

FIG.20

EP 0 408 425 B1

FIG.21

MODQ1

1) modèle  de  rang 1 : $Ib \geqslant 0$ ; $Ic > 0$

MODQ2

2) modele  de  rang 2 :

- si         0,6 Volt $\leqslant$ Vbe $< 1,5$ Volt   et  Vce $\leqslant 0,1$ Volt

        alors   Q saturé  et $0 < \beta < 30$

- si         0,6 Volt  $\leqslant$ Vbc  $< 1,5$ Volt   et  Vce $> 0,1$ Volt

        alors   Q conduit  et $30 < \beta < 300$

- si         Vbc $< 0,6$ Volt   et  Vce $> 0,1$ Volt

        alors  Q bloqué  et $Ib = 0$

## FIG.22

$$\text{modèle de rang 1:}$$
$$\text{si } V_{Ank} \geq 0,6 \text{ Volt} \quad \text{alors } ID > 0$$
$$\text{si } V_{Ank} < 0,6 \text{ Volt} \quad \text{alors } ID = 0$$

— MODD1

## FIG.23

$$I = C \frac{dV}{dt}$$

— MODC1

## FIG.24

$$I = \frac{U}{R}$$

— MODR1

## FIG.25

Utilisateur | Dispositif

```
┌─────────────────────┐                      ┌───────────────────┐
│ Sonde A0  en  N1    │─61                   │  Capture DP12     │─62
│ Sonde A1  en  N2    │─────────────────────▶│                   │
│ Identification  Q2  │                      └───────────────────┘
└─────────────────────┘                               │
                                                       ▼
                                              ┌───────────────────┐
                                              │ Directive Utilisateur: │─63
              ┌──────────────────────────────│ DP Collecteur-Emetteur │
              │                               │      de  Q2?      │
              ▼                               └───────────────────┘
┌─────────────────────┐
│ Sonde A1  en  N3    │─64
│                     │──────────────────────┐
└─────────────────────┘                      ▼
                                     ┌───────────────────┐
                                     │  Capture DP13     │─65
                                     └───────────────────┘
                                              │
                                              ▼
                                     ┌───────────────┐        ╭──────────╮
                                     │ Determination │─66     │ modèle   │ MODQ1
              ┌──────────────────────│ expression de │◀───────│   Q2     │
              │                      │ courant  Q2   │        ╰──────────╯
              ▼                      └───────────────┘
┌─────────────────────┐
│ Sonde A1   en N4    │─67
│ Identification  Q1  │──────────────────────┐
└─────────────────────┘                      ▼
                                     ┌───────────────────┐
                                     │  Capture DP14     │─68
                                     └───────────────────┘
                                              │
                                              ▼
                                     ┌───────────────────┐
                                     │ Directive Utilisateur: │─69
                                     │ DP Collecteur-Emetteur │
                                     │      de   Q1?     │
                                     └───────────────────┘
                                              │
                                              ▼
                                             ( 1 )
```

## FIG.26A

Utilisateur | Dispositif

( 1 )

70 ⌐
┌─────────────────────┐
│ Sonde A1 en N5      │
└─────────────────────┘

71 ⌐
┌─────────────────────┐
│ Capture DP15        │
└─────────────────────┘

72 ⌐
┌─────────────────────┐
│ Determination       │        ┌─────────────┐
│ expression de       │  ◄──── │ Modèle Q1   │
│ courant  Q1         │        └─────────────┘
└─────────────────────┘              ⌐MODQ1

73 ⌐
┌─────────────────────┐
│ Sonde   A0 en N4    │
│ Sonde   A1 en N6    │
│                     │
│ Identification R2   │
└─────────────────────┘

74 ⌐
┌─────────────────────┐
│ Capture DP 46       │
└─────────────────────┘

75 ⌐
┌─────────────────────┐
│ Determination       │        ┌─────────────┐
│ expression de       │  ◄──── │ modèle R2   │
│ courant  R2         │        └─────────────┘
└─────────────────────┘              ⌐MODR 1

76 ⌐
┌─────────────────────┐
│ Sonde  A1 en N3     │
│ Identification C1   │
└─────────────────────┘

77 ⌐
┌─────────────────────┐
│ Capture DP43        │
└─────────────────────┘

78 ⌐
┌─────────────────────┐
│ Directive Utilisateur: │
│ Dilater autour de 10µs │
└─────────────────────┘

( 2 )

## FIG.26B

Utilisateur | Dispositif

(2)

79

Sonde A1 en N3

80

Capture DP 43

81

Determination
courant
C1

MODC1

Modèle C1

82

Demande   de
Diagnostic

83

Diagnostic

Conflit
Q1,R2,C1

84

85

Sonde A0 en N3
Sonde A1 en N6
Identification R3

86

Capture DP 36

(3)

## FIG26C

EP 0 408 425 B1

| Utilisateur | Dispositif |
|---|---|

**3**

87 — Determination courant R3

MODR1 — Modèle R3

88 — Sonde A1 en N7 Identification D2

89 — Capture DP 37

90 — Determination expression courant D2

MODD1 — Modèle D2

91 — Sonde A1 en N4 Identification C1

92 — Capture DP 34

93 — Directive Utilisateur: Dilater autour de 10μs

**4**

## FIG.26D

60

Utilisateur          Dispositif

④

94
Sonde A1 en N3

95
Capture DP34

96
Determination
courant
C 1

MODC1
Modèle C 1

97
Demande de
Diagnostic

98
Diagnostic

99
Conflit
Q2,R3,C1,D2

de 84

100
Candidat: C1

FIG.26E

FIG.27

FIG.28

FIG.29

FIG.30

FIG.31

FIG.32

FIG.33

FIG.34

IC1(Ampères)

FIG.35

IC1(Ampères)

FIG.36

66

FIG.37

FIG.38

FIG.39

FIG.40

FIG.41

FIG.42

FIG.43